(19) Europäisches Patentamt
European Patent Office
Office européen des brevets

(11) EP 3 439 061 B1

(12) **EUROPEAN PATENT SPECIFICATION**

(45) Date of publication and mention of the grant of the patent:
**21.07.2021 Bulletin 2021/29**

(21) Application number: **17774850.6**

(22) Date of filing: **27.03.2017**

(51) Int Cl.:
***H01L 51/54*** *(2006.01)* ***C08G 61/10*** *(2006.01)*
***C08G 61/12*** *(2006.01)* ***C09K 11/06*** *(2006.01)*
*H01L 51/50* *(2006.01)*

(86) International application number:
**PCT/JP2017/012225**

(87) International publication number:
**WO 2017/170313 (05.10.2017 Gazette 2017/40)**

(54) **LIGHT-EMITTING ELEMENT**

LICHTEMITTIERENDES ELEMENT

ÉLÉMENT ÉLECTROLUMINESCENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.03.2016 JP 2016065572**

(43) Date of publication of application:
**06.02.2019 Bulletin 2019/06**

(73) Proprietor: **Sumitomo Chemical Company, Limited**
**Tokyo 104-8260 (JP)**

(72) Inventors:
- **SASADA Toshiaki**
  **Tsukuba-shi**
  **Ibaraki 300-3294 (JP)**
- **YOKOYA Seiichirou**
  **Tokyo 104-8260 (JP)**

(74) Representative: **J A Kemp LLP**
**14 South Square**
**Gray's Inn**
**London WC1R 5JJ (GB)**

(56) References cited:
**WO-A1-2015/145871** **WO-A1-2015/194448**
**JP-A- 2010 183 010** **JP-A- 2010 185 008**
**JP-A- 2011 108 792** **US-A1- 2011 042 661**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 439 061 B1

## Description

### Technical Field

The present invention relates to a light-emitting device.

### Background Art

Light-emitting devices such as organic electroluminescence devices can be suitably used for display and illumination purposes, and research and development are underway.

For example, in Patent Literature 1, a light-emitting device having an organic layer containing a polymer compound (P0-1) represented by the following formula, and a light-emitting layer containing a fluorescent compound (EM0-1) represented by the following formula is described:

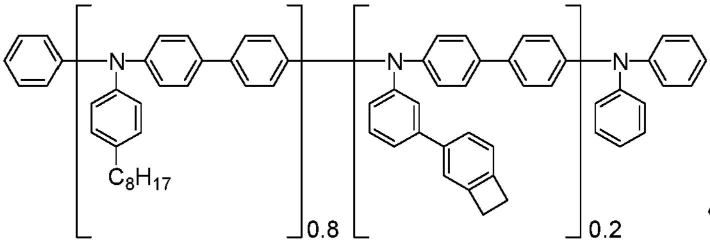

Polymer compound (P0-1)

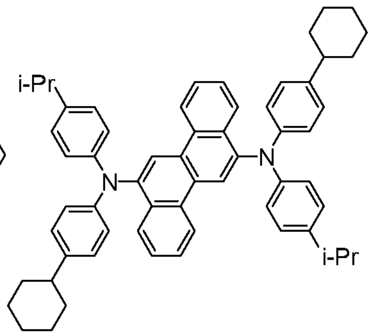

Fluorescent compound (EM0-1)

For example, in Patent Literature 2, a light-emitting device having an organic layer containing a polymer compound (P0-2) comprising a constitutional unit (M0) represented by the following formula, and a light-emitting layer containing a fluorescent compound (EM0-2) represented by the following formula is described:

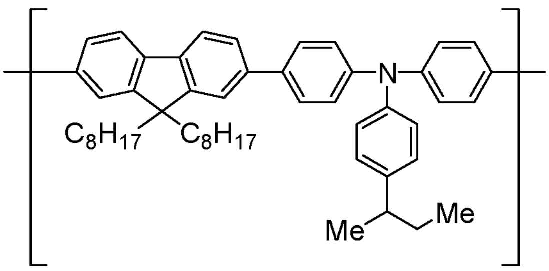

Constitutional unit (M0)

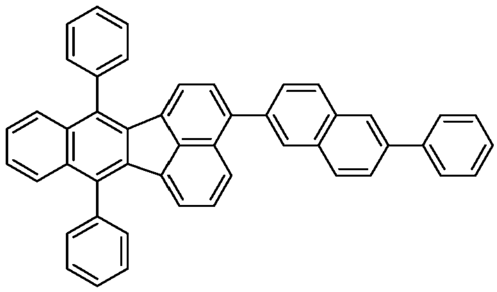

Fluorescent compound (EM0-2)

Patent literature 3 discloses a conjugated polymer which contains an insolubilizing group as a substituent, the weight average molecular weight (Mw) is 20,000 or more and the dispersity (Mw/Mn) is 2.40 or less. The document also discloses an organic electroluminescence element.

Patent literature 4 discloses a polymer compound comprising a constitutional unit having a group represented by the formula (1):

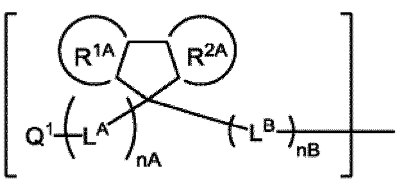

(1)

wherein Ring $R^{1A}$ and Ring $R^{2A}$ represent an aromatic hydrocarbon ring or a heterocyclic ring and these rings each optionally have a substituent, nA represents an integer of 0 to 5, nB represents an integer of 1 to 5, $L^A$ and $L^B$ represent an alkylene group, a cycloalkylene group, an arylene group, a divalent heterocyclic ring group, a group represented by -NR'-, an oxygen atom or a sulfur atom, and R' represents a hydrogen atom, an alkyl group or the like, and $Q^1$ represents a crosslinkable group.

## Citation List

### Patent Literature

Patent Literature 1: International Publication No. WO 2009/102027
Patent Literature 2: International Publication No. WO 2007/100010
Patent Literature 3: US Publication No. US 2011/042661
Patent Literature 4: International Publication No. WO 2015/145871

## Summary of Invention

### Technical Problem

One having an excellent external quantum efficiency has been demanded as a light-emitting device. Accordingly, an object of the present invention is to provide a light-emitting device excellent in external quantum efficiency.

### Solution to Problem

The present invention provides the following [1] to [15]:

[1] A light-emitting device comprising: an anode; a cathode; a first organic layer disposed between the anode and the cathode; and a second organic layer disposed, adjacently to the first organic layer, between the anode and the cathode, wherein:

the first organic layer is a layer containing a fluorescent low-molecular compound that does not have a molecular weight distribution and has a molecular weight of $1 \times 10^4$ or smaller;
a maximum peak wavelength of an emission spectrum of the fluorescent low-molecular compound is 380 nm or larger and 750 nm or smaller;
the second organic layer is a layer containing a cross-linked form of a polymer compound comprising a cross-linking constitutional unit having a cross-linking group;
as for each constitutional unit constituting the polymer compound, when value x obtained by multiplying molar ratio C of the constitutional unit to total mol of all constitutional units by molecular weight M of the constitutional unit, and value y obtained by multiplying the molar ratio C by number n of the cross-linking group carried by the constitutional unit are determined, a value of $(Y_1 \times 1000) / X_1$ calculated from summation $X_1$ of the x and summation $Y_1$ of the y is 0.60 or more;
the fluorescent low-molecular compound is a compound represented by the formula (B):

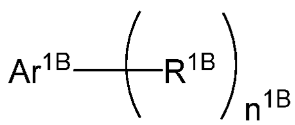

(B)

wherein

$n^{1B}$ represents an integer of 1 to 8;
$Ar^{1B}$ represents an aromatic hydrocarbon group or an aromatic heterocyclic group, and these groups optionally have a substituent; in the case where a plurality of the substituent are present, they are the same or different and are optionally bonded to each other to form a ring together with the atoms to which they are attached;
$R^{1B}$ represents an alkyl group, a cycloalkyl group, an alkoxy group, a cycloalkoxy group, an aryl group, a monovalent heterocyclic group, a substituted amino group, an alkenyl group, a cycloalkenyl group, an alkynyl

group or a cycloalkynyl group, and these groups optionally have a substituent; and in the case where a plurality of $R^{1B}$ are present, they are the same or different and are optionally bonded to each other to form a ring together with the carbon atoms to which they are attached; and
the maximum peak wavelength of an emission spectrum of the fluorescent low-molecular compound is evaluated by measuring a photoluminescence spectrum.

[2] The light-emitting device according to [1], wherein $n^{1B}$ is an integer of 1 to 4.
[3] The light-emitting device according to [1] or [2], wherein the $Ar^{1B}$ is an aromatic hydrocarbon group optionally having a substituent.
[4] The light-emitting device according to [3], wherein the $Ar^{1B}$ is a group formed by removing one or more hydrogen atoms directly bonded to an annular carbon atom from a benzene ring, a biphenyl ring, a naphthalene ring, an anthracene ring, a phenanthrene ring, a dihydrophenanthrene ring, a triphenylene ring, a naphthacene ring, a fluorene ring, a spirobifluorene ring, a pyrene ring, a perylene ring, a chrysene ring, an indene ring, a fluoranthene ring, a benzofluoranthene ring or an acenaphthofluoranthene ring, optionally wherein the group has a substituent.
[5] The light-emitting device according to [4], wherein the $Ar^{1B}$ is a group formed by removing one or more hydrogen atoms directly bonded to an annular carbon atom from a biphenyl ring, a pyrene ring, a chrysene ring, a fluoranthene ring or a benzofluoranthene, optionally wherein the group has a substituent.
[6] The light-emitting device according to [5], wherein the $Ar^{1B}$ is a group formed by removing one or more hydrogen atoms directly bonded to an annular carbon atom from a fluoranthene ring or a benzofluoranthene ring, optionally wherein the group has a substituent.
[7] The light-emitting device according to any one of [1] to [6], wherein the $R^{1B}$ is an alkyl group, a cycloalkyl group, an aryl group, a monovalent heterocyclic group, a substituted amino group, an alkenyl group or a cycloalkenyl group, optionally wherein these groups have a substituent.
[8] The light-emitting device according to [7], wherein the $R^{1B}$ is an aryl group, a substituted amino group or an alkenyl group optionally wherein these groups have a substituent.
[9] The light-emitting device according to any one of [1] to [8], wherein the maximum peak wavelength of an emission spectrum of the fluorescent low-molecular compound is 380 nm or larger and 570 nm or smaller.
[10] The light-emitting device according to any one of [1] to [9], wherein the polymer compound is a polymer compound comprising a cross-linking constitutional unit having at least one cross-linking group selected from the Group A of cross-linking group:

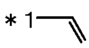
(XL-1)
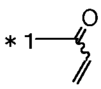
(XL-2)
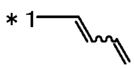
(XL-3)
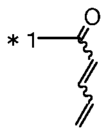
(XL-4)
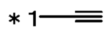
(XL-5)
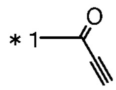
(XL-6)

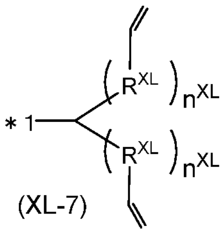
(XL-7)
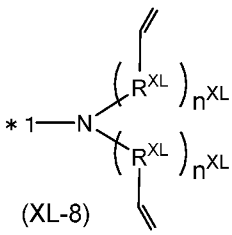
(XL-8)
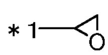
(XL-9)
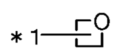
(XL-10)

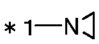
(XL-11)
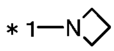
(XL-12)
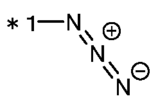
(XL-13)
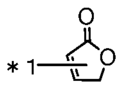
(XL-14)
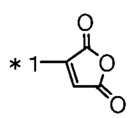
(XL-15)

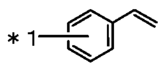
(XL-16)

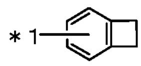
(XL-17)

wherein $R^{XL}$ represents a methylene group, an oxygen atom or a sulfur atom; $n^{XL}$ represents an integer of 0 to 5; in the case where a plurality of $R^{XL}$ are present, they are the same or different; in the case where a plurality of $n^{XL}$ are present, they are the same or different; *1 represents a position of a bond; and these cross-linking groups optionally have a substituent.

[11] The light-emitting device according to [10], wherein the cross-linking constitutional unit is a constitutional unit represented by the formula (2) or a constitutional unit represented by the formula (2'):

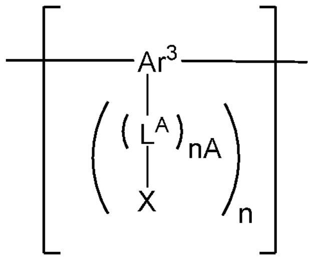
(2)

wherein

nA represents an integer of 0 to 5; n represents 1 or 2; in the case where a plurality of nA are present, they are the same or different;

$Ar^3$ represents an aromatic hydrocarbon group or a heterocyclic group, and these groups optionally have a substituent;

$L^A$ represents an alkylene group, a cycloalkylene group, an arylene group, a divalent heterocyclic group, a group represented by -NR'-, an oxygen atom or a sulfur atom, and these groups optionally have a substituent; R' represents a hydrogen atom, an alkyl group, a cycloalkyl group, an aryl group or a monovalent heterocyclic group, and these groups optionally have a substituent; in the case where a plurality of $L^A$ are present, they are the same or different;

X represents a cross-linking group selected from the Group A of cross-linking group; and in the case where a plurality of X are present, they are the same or different, and

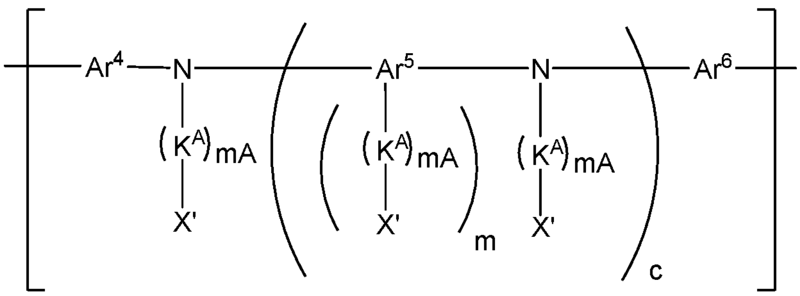
(2')

wherein

mA represents an integer of 0 to 5; m represents an integer of 1 to 4; c represents an integer of 0 or 1; in the case where a plurality of mA are present, they are the same or different;

$Ar^5$ represents an aromatic hydrocarbon group, a heterocyclic group, or a group in which at least one aromatic hydrocarbon ring and at least one heterocyclic ring are directly bonded, and these groups optionally have a substituent;

$Ar^4$ and $Ar^6$ each independently represent an arylene group or a divalent heterocyclic group, and these groups optionally have a substituent;

each of $Ar^4$, $Ar^5$ and $Ar^6$ optionally forms a ring by bonding directly or via an oxygen atom or a sulfur atom to a group, other than the group concerned, bonded to the nitrogen atom to which the group concerned is bonded;

$K^A$ represents an alkylene group, a cycloalkylene group, an arylene group, a divalent heterocyclic group, a group represented by -NR'-, an oxygen atom or a sulfur atom, and these groups optionally have a substituent; R' represents a hydrogen atom, an alkyl group, a cycloalkyl group, an aryl group or a monovalent heterocyclic group, and these groups optionally have a substituent; in the case where a plurality of $K^A$ are present, they are the same or different;
X' represents a cross-linking group selected from the group A of cross-linking group, a hydrogen atom, an alkyl group, a cycloalkyl group, an aryl group or a monovalent heterocyclic group, and these groups optionally have a substituent; and in the case where a plurality of X' are present, they are the same or different, provided that at least one X' is a cross-linking group selected from the Group A of cross-linking group.

[12] The light-emitting device according to any of [1] to [11], wherein the value of $(Y_1 \times 1000) / X_1$ is 0.85 or more and 4.0 or less.
[13] The light-emitting device according to any of [1] to [12], wherein: the first organic layer is a layer containing the fluorescent low-molecular compound and a host material; the host material is a compound represented by the formula (FH-1) or a polymer compound comprising a constitutional unit represented by the formula (Y); and the amount of the fluorescent low-molecular compound is 0.1 to 50 parts by mass with respect to 100 parts by mass in total of the fluorescent low-molecular compound and the host material:

$$Ar^{H1}-\left[L^{H1}\right]_{n^{H1}}-Ar^{H2} \qquad \textbf{(FH-1)}$$

wherein

$Ar^{H1}$ and $Ar^{H2}$ each independently represent an aryl group, a monovalent heterocyclic group or a substituted amino group and these groups optionally have a substituent;
$n^{H1}$ represents an integer of 0 to 15;
$L^{H1}$ represents an arylene group, a divalent heterocyclic group, or a group represented by $-[C(R^{H11})_2]n^{H11}-$ and these groups optionally have a substituent; in the case where a plurality of $L^{H1}$ are present, they are the same or different; $n^{H11}$ represents an integer of 1 to 10; $R^{H11}$ represents a hydrogen atom, an alkyl group, a cycloalkyl group, an alkoxy group, a cycloalkoxy group, an aryl group or a monovalent heterocyclic group and these groups optionally have a substituent; and a plurality of $R^{H11}$ present are the same or different and are optionally bonded to each other to form a ring together with the carbon atoms to which they are attached and

$$-[-Ar^{Y1}-]- \qquad (Y)$$

wherein $Ar^{Y1}$ represents an arylene group, a divalent heterocyclic group, or a divalent group in which at least one arylene group and at least one divalent heterocyclic group are directly bonded and these groups optionally have a substituent.

[14] The light-emitting device according to any of [1] to [13], wherein the first organic layer further contains at least one material selected from the group consisting of a hole-transporting material, a hole-injecting material, an electron-transporting material, an electron-injecting material, an antioxidant, and a light-emitting material different from the fluorescent low-molecular compound.
[15] The light-emitting device according to any of [1] to [14], wherein the second organic layer is a layer disposed between the anode and the first organic layer.

## Advantageous Effects of Invention

According to the present invention, a light-emitting device excellent in external quantum efficiency can be provided.

## Description of Embodiments

Hereinafter, preferable embodiments of the present invention will be described in detail.

<Description of common terms>

The terms commonly used in the present specification have the following meanings unless otherwise specified.

Me represents a methyl group, Et represents an ethyl group, Bu represents a butyl group, i-Pr represents an isopropyl group, and t-Bu represents a tert-butyl group.

The hydrogen atom may be a heavy hydrogen atom or may be a light hydrogen atom.

In a formula that represents a metal complex, a solid line that represents a bond to a central metal means a covalent bond or a coordinate bond.

The "polymer compound" means a polymer that has a molecular weight distribution and has a polystyrene-based number-average molecular weight of $1 \times 10^3$ to $1 \times 10^8$.

The "low-molecular compound" means a compound that does not have a molecular weight distribution and has a molecular weight of $1 \times 10^4$ or smaller.

The "constitutional unit" means one or more units present in a polymer compound.

The "alkyl group" may be linear or branched. The number of carbon atoms of the linear alkyl group is usually 1 to 50, preferably 3 to 30, more preferably 4 to 20, which excludes the number of carbon atoms of a substituent. The number of carbon atoms of the branched alkyl group is usually 3 to 50, preferably 3 to 30, more preferably 4 to 20, which excludes the number of carbon atoms of a substituent.

Examples of the alkyl group include a methyl group, an ethyl group, a propyl group, an isopropyl group, a butyl group, a 2-butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group and a dodecyl group. The alkyl group optionally has a substituent and can be, for example, a group in which a portion or the whole of hydrogen atoms in the alkyl group is replaced with a cycloalkyl group, an alkoxy group, a cycloalkoxy group, an aryl group, a fluorine atom or the like. Examples of the alkyl group having a substituent include a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-hexylphenyl)propyl group and a 6-ethyloxyhexyl group.

The number of carbon atoms of the "cycloalkyl group" is usually 3 to 50, preferably 3 to 30, more preferably 4 to 20, which excludes the number of carbon atoms of a substituent.

Examples of the cycloalkyl group include a cyclopentyl group and a cyclohexyl group. The cycloalkyl group optionally has a substituent and can be, for example, a group in which a portion or the whole of hydrogen atoms in the cycloalkyl group is replaced with an alkyl group, a cycloalkyl group, an alkoxy group, a cycloalkoxy group, an aryl group, a fluorine atom or the like. Examples of the cycloalkyl group having a substituent include a cyclohexylmethyl group and a cyclohexylethyl group.

The "aryl group" means a remaining atomic group excluding one hydrogen atom directly bonded to an annular carbon atom from an aromatic hydrocarbon. The number of carbon atoms of the aryl group is usually 6 to 60, preferably 6 to 20, more preferably 6 to 10, which excludes the number of carbon atoms of a substituent.

Examples of the aryl group include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group and a 4-phenylphenyl group. The aryl group optionally has a substituent and can be, for example, a group in which a portion or the whole of hydrogen atoms in the aryl group is replaced with an alkyl group, a cycloalkyl group, an alkoxy group, a cycloalkoxy group, an aryl group, a fluorine atom or the like.

The "alkoxy group" may be linear or branched. The number of carbon atoms of the linear alkoxy group is usually 1 to 40, preferably 4 to 10, which excludes the number of carbon atoms of a substituent. The number of carbon atoms of the branched alkoxy group is usually 3 to 40, preferably 4 to 10, which excludes the number of carbon atoms of a substituent.

Examples of the alkoxy group include a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group and a lauryloxy group. The alkoxy group optionally has a substituent and can be, for example, a group in which a portion or the whole of hydrogen atoms in the alkoxy group is replaced with a cycloalkyl group, an alkoxy group, a cycloalkoxy group, an aryl group, a fluorine atom or the like.

The number of carbon atoms of the "cycloalkoxy group" is usually 3 to 40, preferably 4 to 10, which excludes the number of carbon atoms of a substituent.

Examples of the cycloalkoxy group include a cyclopentyloxy group and a cyclohexyloxy group. The cycloalkoxy group optionally has a substituent and can be, for example, a group in which a portion or the whole of hydrogen atoms in the cycloalkoxy group is replaced with an alkyl group, a cycloalkyl group, an alkoxy group, a cycloalkoxy group, an aryl group, a fluorine atom or the like.

The "aryloxy group" means an atomic group in which one aryl group is bonded to an oxygen atom. The number of carbon atoms of the aryloxy group is usually 6 to 60, preferably 6 to 48, which excludes the number of carbon atoms of a substituent.

Examples of the aryloxy group include a phenoxy group, a 1-naphthyloxy group, a 2-naphthyloxy group, a 1-anthracenyloxy group, a 9-anthracenyloxy group and a 1-pyrenyloxy group. The aryloxy group optionally has a substituent and can be, for example, a group in which a portion or the whole of hydrogen atoms in the aryloxy group is replaced with an alkyl group, a cycloalkyl group, an alkoxy group, a cycloalkoxy group, a fluorine atom or the like.

The "p-valent heterocyclic group" (p represents an integer of 1 or larger) means a remaining atomic group excluding p hydrogen atom(s) among hydrogen atoms directly bonded to annular carbon atoms or heteroatoms from a heterocyclic compound. Among the p-valent heterocyclic groups, a "p-valent aromatic heterocyclic group" is preferable which is a remaining atomic group excluding p hydrogen atom(s) among hydrogen atoms directly bonded to annular carbon atoms or heteroatoms from an aromatic heterocyclic compound.

The "aromatic heterocyclic compound" means a compound in which a heterocyclic ring itself exhibits aromaticity, such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, or dibenzophosphole, and a compound in which an aromatic ring is condensed with a heterocyclic ring even though the heterocyclic ring itself does not aromaticity, such as phenoxazine, phenothiazine, dibenzoborole, dibenzosilole, or benzopyran.

The number of carbon atoms of the monovalent heterocyclic group is usually 2 to 60, preferably 4 to 20, which excludes the number of carbon atoms of a substituent.

Examples of the monovalent heterocyclic group include a thienyl group, a pyrrolyl group, a furyl group, a pyridyl group, a piperidinyl group, a quinolinyl group, an isoquinolinyl group, a pyrimidinyl group and a triazinyl group. The monovalent heterocyclic group optionally has a substituent and can be, for example, a group in which a portion or the whole of hydrogen atoms in the monovalent heterocyclic group is replaced with an alkyl group, a cycloalkyl group, an alkoxy group, a cycloalkoxy group or the like.

The "halogen atom" refers to a fluorine atom, a chlorine atom, a bromine atom or an iodine atom.

The "amino group" optionally has a substituent and a substituted amino group is preferable. An alkyl group, a cycloalkyl group, an aryl group or a monovalent heterocyclic group is preferable as the substituent carried by the amino group.

Examples of the substituted amino group include a dialkylamino group, a dicycloalkylamino group and a diarylamino group. Specific examples of the substituted amino group include a dimethylamino group, a diethylamino group, a diphenylamino group, a bis(4-methylphenyl)amino group, a bis(4-tert-butylphenyl)amino group and a bis(3,5-di-tert-butylphenyl)amino group.

The "alkenyl group" may be linear or branched. The number of carbon atoms of the linear alkenyl group is usually 2 to 30, preferably 3 to 20, which excludes the number of carbon atoms of a substituent. The number of carbon atoms of the branched alkenyl group is usually 3 to 30, preferably 4 to 20, which excludes the number of carbon atoms of a substituent.

The number of carbon atoms of the "cycloalkenyl group" is usually 3 to 30, preferably 4 to 20, which excludes the number of carbon atoms of a substituent.

Examples of the alkenyl group and the cycloalkenyl group include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group and a 7-octenyl group. The alkenyl group optionally has a substituent and can be, for example, a group in which a portion or the whole of hydrogen atoms in the alkenyl group is replaced with a cycloalkyl group, an alkoxy group, a cycloalkoxy group, an aryl group, a fluorine atom or the like. Also, the cycloalkenyl group optionally has a substituent and can be, for example, a group in which a portion or the whole of hydrogen atoms in the cycloalkenyl group is replaced with an alkyl group, a cycloalkyl group, an alkoxy group, a cycloalkoxy group, an aryl group, a fluorine atom or the like.

The "alkynyl group" may be linear or branched. The number of carbon atoms of the alkynyl group is usually 2 to 20, preferably 3 to 20, which excludes the carbon atoms of a substituent. The number of carbon atoms of the branched alkynyl group is usually 4 to 30, preferably 4 to 20, which excludes the carbon atoms of a substituent.

The number of carbon atoms of the "cycloalkynyl group" is usually 4 to 30, preferably 4 to 20, which excludes the carbon atoms of a substituent.

Examples of the alkynyl group and the cycloalkynyl group include an ethynyl group, a 1-propynyl group, a 2-propynyl group, a 2-butynyl group, a 3-butynyl group, a 3-pentynyl group, a 4-pentynyl group, a 1-hexynyl group and a 5-hexynyl group. The alkynyl group optionally has a substituent and can be, for example, a group in which a portion or the whole of hydrogen atoms in the alkynyl group is replaced with a cycloalkyl group, an alkoxy group, a cycloalkoxy group, an aryl group, a fluorine atom or the like. Also, the cycloalkynyl group optionally has a substituent and can be, for example, a group in which a portion or the whole of hydrogen atoms in the cycloalkynyl group is replaced with an alkyl group, a cycloalkyl group, an alkoxy group, a cycloalkoxy group, an aryl group, a fluorine atom or the like.

The "arylene group" means a remaining atomic group excluding two hydrogen atoms directly bonded to annular carbon atoms from an aromatic hydrocarbon. The number of carbon atoms of the arylene group is usually 6 to 60, preferably 6 to 30, more preferably 6 to 18, which excludes the number of carbon atoms of a substituent.

Examples of the arylene group include a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group and a chrysenediyl group. The arylene group optionally has a substituent and can be, for example, a group in which a portion or the whole of hydrogen atoms in the arylene group is replaced with an alkyl group, a cycloalkyl group, an alkoxy group, a cycloalkoxy group, an aryl group, a fluorine atom or the like.

The arylene group is preferably groups represented by the formula (A-1) to the formula (A-20). The arylene group includes groups in which a plurality of these groups are bonded.

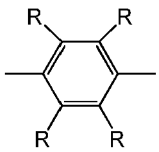
(A-1)
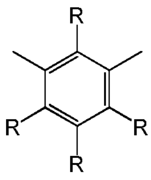
(A-2)
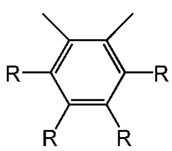
(A-3)
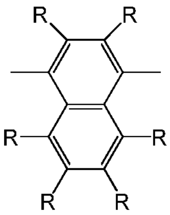
(A-4)
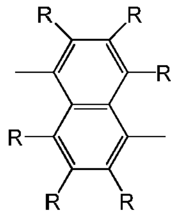
(A-5)
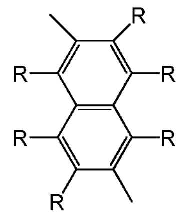
(A-6)

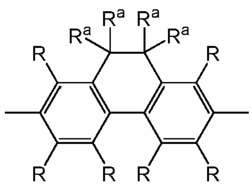
(A-7)
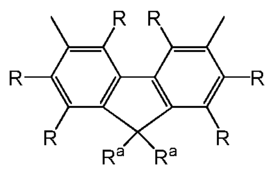
(A-8)
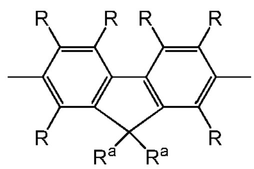
(A-9)
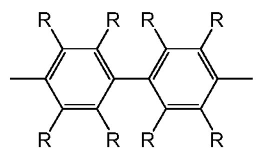
(A-10)

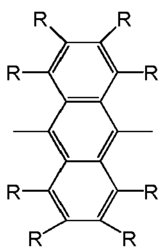
(A-11)
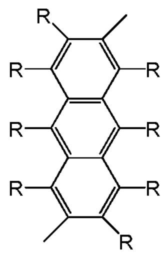
(A-12)
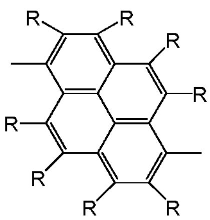
(A-13)
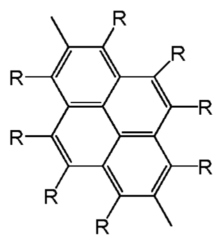
(A-14)
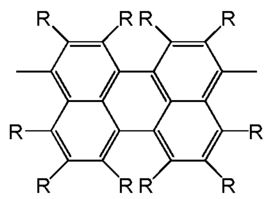
(A-15)

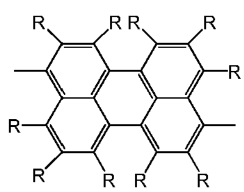
(A-16)
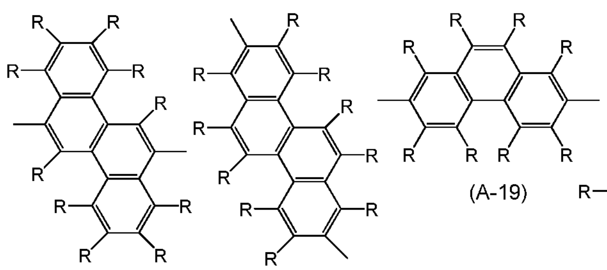
(A-17) (A-18) (A-19)
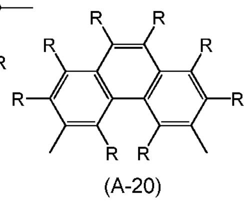
(A-20)

In the formulas, R and $R^a$ each independently represent a hydrogen atom, an alkyl group, a cycloalkyl group, an aryl group or a monovalent heterocyclic group. Pluralities of R and $R^a$ present are respectively the same or different, and a plurality of $R^a$ are optionally bonded to each other to form a ring together with the atoms to which they are attached.

The number of carbon atoms of the divalent heterocyclic group is usually 2 to 60, preferably 3 to 20, more preferably 4 to 15, which excludes the number of carbon atoms of a substituent.

Examples of the divalent heterocyclic group include divalent groups excluding two hydrogen atoms among

hydrogen atoms directly bonded to annular carbon atoms or heteroatoms from heterocyclic compounds such as pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole, and triazole. The divalent heterocyclic group optionally has a substituent and can be, for example, a group in which a portion or the whole of hydrogen atoms in the divalent heterocyclic group is replaced with an alkyl group, a cycloalkyl group, an alkoxy group, a cycloalkoxy group, an aryl group, a fluorine atom or the like.

The divalent heterocyclic group is preferably groups represented by the formula (AA-1) to the formula (AA-34). The divalent heterocyclic group includes groups in which a plurality of these groups are bonded.

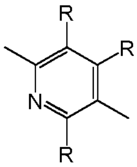
(AA-1)

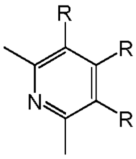
(AA-2)

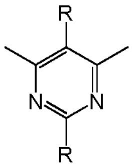
(AA-3)

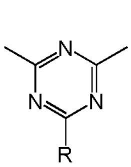
(AA-4)

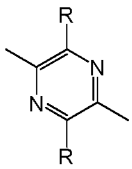
(AA-5)

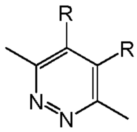
(AA-6)

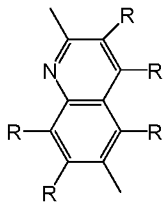
(AA-7)

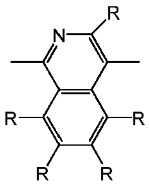
(AA-8)

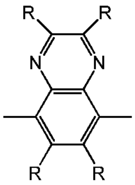
(AA-9)

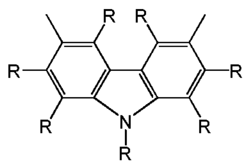
(AA-10)

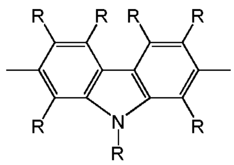
(AA-11)

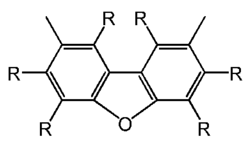
(AA-12)

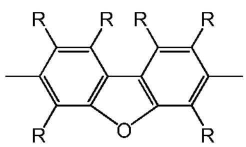
(AA-13)

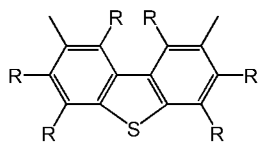
(AA-14)

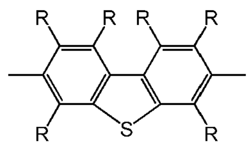
(AA-15)

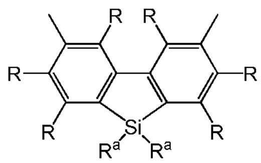
(AA-16)

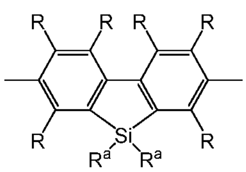
(AA-17)

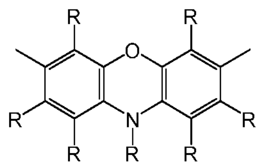
(AA-18)

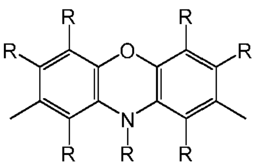
(AA-19)

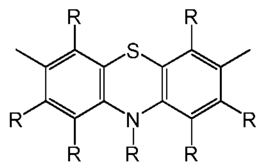
(AA-20)

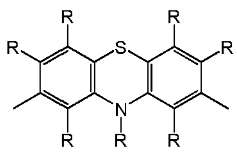
(AA-21)

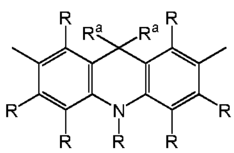
(AA-22)

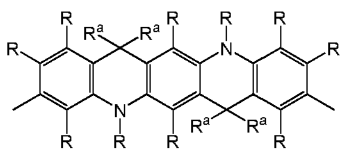
(AA-23)

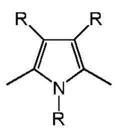
(AA-24)

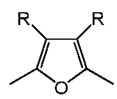
(AA-25)

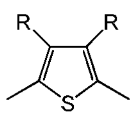
(AA-26)

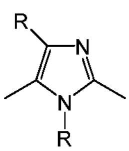
(AA-27)

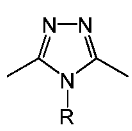
(AA-28)

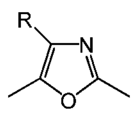
(AA-29)

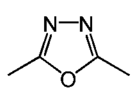
(AA-30)

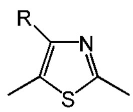
(AA-31)

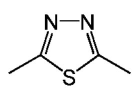
(AA-32)

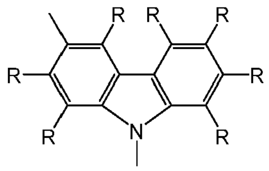

(AA-33)

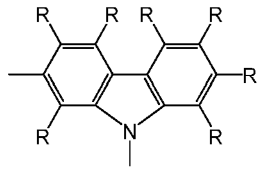

(AA-34)

In the formulas, R and $R^a$ represent the same meanings as above.

The "cross-linking group" is a group capable of being subjected to a heating treatment, an ultraviolet irradiation, a near-ultraviolet irradiation, a visible light irradiation, an infrared irradiation, a radical reaction or the like and thereby forming a new bond and is preferably groups represented by the formula (XL-1) to the formula (XL-17) of the above -described Group A of cross-linking group.

Examples of the "substituent" include a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group and a cycloalkynyl group. The substituent may be a cross-linking group.

<Light-emitting device>

Next, the light-emitting device according to one embodiment of the present invention will be described.

The light-emitting device according to the present embodiment comprises an anode, a cathode, a first organic layer disposed between the anode and the cathode, and a second organic layer disposed, adjacently to the first organic layer, between the anode and the cathode. The first organic layer is a layer containing a fluorescent low-molecular compound, and the second organic layer is a layer containing a cross-linked form of a polymer compound comprising a cross-linking constitutional unit having a cross-linking group.

Examples of methods for forming the first organic layer and the second organic layer include: dry methods such as a vacuum deposition method; and wet methods such as a spin coating method and an inkjet printing method, and a wet method is preferable.

In the case of forming the first organic layer by the wet method, it is preferable to use an ink for the first organic layer (hereinafter, also referred to as a "first ink") mentioned later.

In the case of forming the second organic layer by the wet method, it is preferable to use an ink for the second organic layer (hereinafter, also referred to as a "second ink") mentioned later. After formation of the second organic layer, a polymer compound of the second organic layer mentioned later, contained in the second organic layer can be cross-linked by a heating treatment or a light irradiation, and it is preferable to cross-link the polymer compound of the second organic layer mentioned later, contained in the second organic layer by a heating treatment. In the case where the polymer compound of the second organic layer mentioned later is contained in a cross-linked state (a cross-linked form of the polymer compound of the second organic layer mentioned later) in the second organic layer, the second organic layer is substantially insolubilized in a solvent. Therefore, the second organic layer can be suitably used in the lamination of the light-emitting device.

The temperature of the heating for cross-linking is usually 25 to 300°C, preferably 50 to 250°C, more preferably 150°C to 200°C, further preferably 170°C to 190°C. The time of the heating for cross-linking is usually 0.1 to 1000 minutes, preferably 0.5 to 500 minutes, more preferably 1 to 120 minutes, further preferably 30 to 90 minutes.

The type of the light used in the light irradiation is, for example, ultraviolet light, near-ultraviolet light, or visible light.

Examples of a method for analyzing a component contained in the first organic layer or the second organic layer include: chemical separation analysis methods such as extraction; instrumental analysis methods such as infrared spectroscopy (IR), nuclear magnetic resonance spectroscopy (NMR), and mass spectrometry (MS); and analysis methods combining chemical separation analysis methods and instrumental analysis methods.

It is possible to separate the first organic layer or the second organic layer into a component substantially insoluble in an organic solvent (insoluble component) and a component soluble in an organic solvent (soluble component) by performing solid-liquid extraction using an organic solvent such as toluene, xylene, chloroform, or tetrahydrofuran. The insoluble component can be analyzed by an infrared spectroscopy or a nuclear magnetic resonance spectroscopy, and the soluble component can be analyzed by a nuclear magnetic resonance spectroscopy or a mass spectrometry.

<First organic layer>

The first organic layer is a layer containing a fluorescent low-molecular compound. In the first organic layer, one fluorescent low-molecular compound may be used alone, or two or more may be contained.

[Fluorescent low-molecular compound]

The "fluorescent low-molecular compound" usually means a low-molecular compound that exhibits fluorescence at room temperature (25°C) and is preferably a low-molecular compound that exhibits light emission from a singlet excited state at room temperature.
The maximum peak wavelength of an emission spectrum of the fluorescent low-molecular compound is 380 nm or larger and 750 nm or smaller, preferably 380 nm or larger and 570 nm or smaller, more preferably 390 nm or larger and 540 nm or smaller, further preferably 400 nm or larger and 495 nm or smaller, particularly preferably 420 nm or larger and 480 nm or smaller.
In the present specification, the maximum peak wavelength of an emission spectrum of a compound can be evaluated by dissolving the compound in an organic solvent such as xylene, toluene, chloroform, or tetrahydrofuran to prepare a dilute solution (on the order of $1 \times 10^{-6}$ to $1 \times 10^{-3}$% by mass) and measuring the PL spectrum of the dilute solution at room temperature. Toluene is preferable as the organic solvent dissolving the compound.
The fluorescent low-molecular compound is a compound represented by the formula (B).

[Compound represented by formula (B)]

$n^{1B}$ represents an integer of 1 to 8, preferably an integer of 1 to 6, further preferably an integer of 1 to 4, particularly preferably an integer of 2 to 4.
$Ar^{1B}$ represents an aromatic hydrocarbon group or an aromatic heterocyclic group and these groups optionally have a substituent. In $Ar^{1B}$, the number of carbon atoms of the aromatic hydrocarbon group is usually 6 to 60, preferably 6 to 40, more preferably 6 to 30, further preferably 6 to 20 which excludes the number of carbon atoms of a substituent.
Examples of the aromatic hydrocarbon group in $Ar^{1B}$ include a group formed by removing one or more hydrogen atoms directly bonded to an annular carbon atom from a benzene ring, a biphenyl ring, a naphthalene ring, an anthracene ring, a phenanthrene ring, a dihydrophenanthrene ring, a triphenylene ring, a naphthacene ring, a fluorene ring, a spirobifluorene ring, a pyrene ring, a perylene ring, a chrysene ring, an indene ring, a fluoranthene ring, a benzofluoranthene ring or an acenaphthofluoranthene ring. The aromatic hydrocarbon group is preferably a group formed by removing one or more hydrogen atoms directly bonded to an annular carbon atom from a benzene ring, a biphenyl ring, a naphthalene ring, an anthracene ring, a phenanthrene ring, a dihydrophenanthrene ring, a triphenylene ring, a naphthacene ring, a fluorene ring, a spirobifluorene ring, a pyrene ring, a perylene ring, a chrysene ring, a fluoranthene ring, a benzofluoranthene ring or an acenaphthofluoranthene ring, more preferably a group formed by removing one or more hydrogen atoms directly bonded to an annular carbon atom from a benzene ring, a biphenyl ring, a naphthalene ring, an anthracene ring, a phenanthrene ring, a dihydrophenanthrene ring, a fluorene ring, a spirobifluorene ring, a pyrene ring, a perylene ring, a chrysene ring, a fluoranthene ring, a benzofluoranthene ring or an acenaphthofluoranthene ring, further preferably a group formed by removing one or more hydrogen atoms directly bonded to an annular carbon atom from a benzene ring, a biphenyl ring, a naphthalene ring, a fluorene ring, a spirobifluorene ring, a pyrene ring, a perylene ring, a chrysene ring, a fluoranthene ring, a benzofluoranthene ring or an acenaphthofluoranthene ring, particularly preferably a group formed by removing one or more hydrogen atoms directly bonded to an annular carbon atom from a biphenyl ring, a naphthalene ring, a fluorene ring, a pyrene ring, a perylene ring, a chrysene ring, a fluoranthene ring, a benzofluoranthene ring or an acenaphthofluoranthene ring, especially preferably a group formed by removing one or more hydrogen atoms directly bonded to an annular carbon atom from a biphenyl ring, a naphthalene ring, a pyrene ring, a chrysene ring, a fluoranthene ring or a benzofluoranthene ring, especially more preferably a group formed by removing one or more hydrogen atoms directly bonded to an annular carbon atom from a biphenyl ring, a pyrene ring, a chrysene ring, a fluoranthene ring or a benzofluoranthene ring, especially further preferably a group formed by removing one or more hydrogen atoms directly bonded to an annular carbon atom from a pyrene ring, a chrysene ring, a fluoranthene ring or a benzofluoranthene ring. These groups optionally have a substituent.
In $Ar^{1B}$, the number of carbon atoms of the aromatic heterocyclic group is usually 2 to 60, preferably 3 to 30, more preferably 3 to 20, which excludes the number of carbon atoms of a substituent.
Examples of the aromatic heterocyclic group in $Ar^{1B}$ include a group formed by removing one hydrogen atom directly bonded to an annular carbon atom or heteroatom from a pyrrole ring, a diazole ring, a triazole ring, a pyridine ring, a diazabenzene ring, a triazine ring, an azanaphthalene ring, a diazanaphthalene ring, a triazanaphthalene ring, an indole ring, a benzodiazole ring, a benzotriazole ring, a carbazole ring, an azacarbazole ring, a diazacarbazole ring, a dibenzofuran ring, a dibenzothiophene ring, a phenoxazine ring, a phenothiazine ring, an acridine ring, a 9,10-dihydroacridine ring, an acridone ring, a phenazine ring or a 5,10-dihydrophenazine ring. The aromatic heterocyclic group is preferably a group formed by removing one hydrogen atom directly bonded to an annular carbon atom or heteroatom from a diazole ring, a triazole ring, a pyridine ring, a diazabenzene ring, a triazine ring, an indole ring, a benzodiazole ring, a benzotriazole ring, a carbazole ring, a dibenzofuran ring, a dibenzothiophene ring, a phenoxazine ring, a phenothiazine ring, a 9,10-dihydroacridine ring or a 5,10-dihydrophenazine ring, more preferably a group formed by removing

one hydrogen atom directly bonded to an annular carbon atom or heteroatom from a diazole ring, a triazole ring, a pyridine ring, a diazabenzene ring, a triazine ring, a benzodiazole ring, a benzotriazole ring, a carbazole ring, a dibenzofuran ring or dibenzothiophene ring. These groups optionally have a substituent.

The substituent optionally carried by $Ar^{1B}$ is preferably a halogen atom, a cyano group, an aryloxy group or an amino group, more preferably a fluorine atom or a cyano group. These groups optionally further have a substituent.

Examples and a preferable range of the substituent optionally further carried by the substituent optionally carried by $Ar^{1B}$ are the same as examples and a preferable range of a substituent optionally carried by $R^{1B}$ mentioned later.

$Ar^{1B}$ is preferably an aromatic hydrocarbon group optionally having a substituent.

$R^{1B}$ represents an alkyl group, a cycloalkyl group, an alkoxy group, a cycloalkoxy group, an aryl group, a monovalent heterocyclic group, a substituted amino group, an alkenyl group, a cycloalkenyl group, an alkynyl group or a cycloalkynyl group, and these groups optionally have a substituent. $R^{1B}$ is preferably an alkyl group, a cycloalkyl group, an alkoxy group, a cycloalkoxy group, an aryl group, a monovalent heterocyclic group, a substituted amino group, an alkenyl group or a cycloalkenyl group, more preferably an alkyl group, a cycloalkyl group, an aryl group, a monovalent heterocyclic group, a substituted amino group, an alkenyl group or a cycloalkenyl group, further preferably an alkyl group, a cycloalkyl group, an aryl group, a substituted amino group, an alkenyl group or a cycloalkenyl group, particularly preferably an aryl group, a substituted amino group or an alkenyl group, especially preferably an aryl group or a substituted amino group. These groups optionally have a substituent.

In the case where $R^{1B}$ is an aryl group, the number of carbon atoms of the aryl group is usually 6 to 60, preferably 6 to 40, more preferably 6 to 30, further preferably 6 to 14, which excludes the number of carbon atoms of a substituent.

In the case where $R^{1B}$ is an aryl group, examples of the aryl group include a group formed by removing one hydrogen atom directly bonded to an annular carbon atom from a benzene ring, a naphthalene ring, an anthracene ring, a phenanthrene ring, a triphenylene ring, a dihydrophenanthrene ring, a naphthacene ring, a fluorene ring, a spirobifluorene ring, a pyrene ring, a perylene ring, a chrysene ring, an indene ring, a fluoranthene ring or a benzofluoranthene ring. The aryl group is preferably a group formed by removing one hydrogen atom directly bonded to an annular carbon atom from a benzene ring, a naphthalene ring, an anthracene ring, a phenanthrene ring, a dihydrophenanthrene ring, a fluorene ring, a spirobifluorene ring, a pyrene ring, a fluoranthene ring or a benzofluoranthene ring, more preferably a group formed by removing one hydrogen atom directly bonded to an annular carbon atom from a benzene ring, a naphthalene ring, an anthracene ring, a fluorene ring, a spirobifluorene ring, a fluoranthene ring or a benzofluoranthene ring, further preferably a group formed by removing one hydrogen atom directly bonded to an annular carbon atom from a benzene ring, a naphthalene ring, a fluorene ring or a spirobifluorene ring, particularly preferably a phenyl group or a naphthyl group. These groups optionally further have a substituent.

In the case where $R^{1B}$ is a monovalent heterocyclic group, the number of carbon atoms of the monovalent heterocyclic group is usually 2 to 60, preferably 3 to 30, and more preferably 3 to 20 which excludes the number of carbon atoms of a substituent.

In the case where $R^{1B}$ is a monovalent heterocyclic group, examples of the monovalent heterocyclic group include a group formed by removing one hydrogen atom directly bonded to an annular carbon atom or heteroatom from a pyrrole ring, a diazole ring, a triazole ring, a pyridine ring, a diazabenzene ring, a triazine ring, an azanaphthalene ring, a diazanaphthalene ring, a triazanaphthalene ring, an indole ring, a carbazole ring, an azacarbazole ring, a diazacarbazole ring, a dibenzofuran ring, a dibenzothiophene ring, a phenoxazine ring, a phenothiazine ring, an acridine ring, a 9,10-dihydroacridine ring, an acridone ring, a phenazine ring or a 5,10-dihydrophenazine ring. The monovalent heterocyclic group is preferably a group formed by removing one hydrogen atom directly bonded to an annular carbon atom or heteroatom from a pyridine ring, a diazabenzene ring, a triazine ring, an azanaphthalene ring, a diazanaphthalene ring, a carbazole ring, an azacarbazole ring, a diazacarbazole ring, a dibenzofuran ring, a dibenzothiophene ring, a phenoxazine ring, a phenothiazine ring, a 9,10-dihydroacridine ring or a 5,10-dihydrophenazine ring, more preferably a group formed by removing one hydrogen atom directly bonded to an annular carbon atom or heteroatom from a pyridine ring, a diazabenzene ring, a triazine ring, an azanaphthalene ring, a diazanaphthalene ring, a carbazole ring, a dibenzofuran ring or a dibenzothiophene ring. These groups optionally further have a substituent.

In the case where $R^{1B}$ is a substituted amino group, an aryl group or a monovalent heterocyclic group is preferable as the substituent carried by the amino group, and an aryl group is more preferable, and these groups optionally further have a substituent. Examples and the preferable range of the aryl group as the substituent carried by the amino group are the same as the examples and the preferable range of the aryl group in $R^{1B}$. Examples and the preferable range of the monovalent heterocyclic group as the substituent carried by the amino group are the same as the examples and the preferable range of the monovalent heterocyclic group in $R^{1B}$.

The substituent optionally carried by $R^{1B}$ is preferably an alkyl group, a cycloalkyl group, an aryl group, a monovalent heterocyclic group, an alkoxy group, a cycloalkoxy group, an aryloxy group, a substituted amino group or a halogen atom; more preferably an alkyl group, a cycloalkyl group, an alkoxy group, a cycloalkoxy group, an aryl group, a monovalent heterocyclic group or a substituted amino group; and further preferably an alkyl group, a cycloalkyl group, an aryl group or a monovalent heterocyclic group; particularly preferably an alkyl group, a cycloalkyl group or an aryl

group; and especially preferably an alkyl group or a cycloalkyl group. These groups optionally further have a substituent.

Examples and the preferable range of the aryl group, the monovalent heterocyclic group and the substituted amino group as the substituent optionally carried by $R^{1B}$ are the same as the examples and the preferable range of the aryl group, the monovalent heterocyclic group and the substituted amino group in $R^{1B}$, respectively.

The substituent optionally further carried by the substituent optionally carried by $R^{1B}$ is preferably an alkyl group, a cycloalkyl group, an aryl group, a monovalent heterocyclic group, an alkoxy group, a cycloalkoxy group, an aryloxy group, a substituted amino group or a halogen atom; more preferably an alkyl group, a cycloalkyl group, an aryl group or a monovalent heterocyclic group; and further preferably an alkyl group or a cycloalkyl group. These groups optionally further have a substituent.

Examples and the preferable range of the aryl group, the monovalent heterocyclic group and the substituted amino group as the substituent optionally further carried by the substituent optionally carried by $R^{1B}$ are the same as the examples and the preferable range of the aryl group, the monovalent heterocyclic group and the substituted amino group in $R^{1B}$, respectively.

In the case where a plurality of $R^{1B}$ are present, it is preferable that they should not be bonded to each other to form a ring together with the atoms to which they are attached because the maximum peak wavelength of an emission spectrum of the compound represented by the formula (B) becomes a short wavelength.

Examples of the fluorescent low-molecular compound include compounds represented by the following formulas:

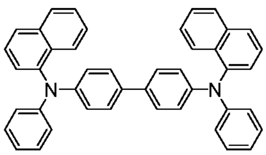

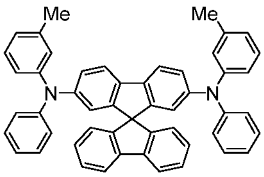

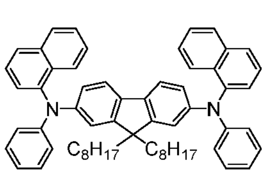

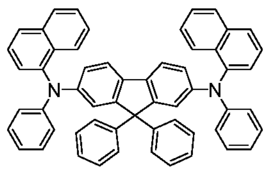

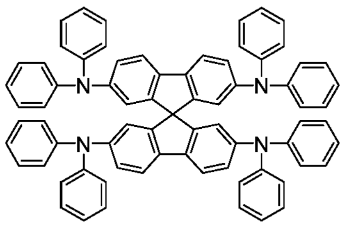

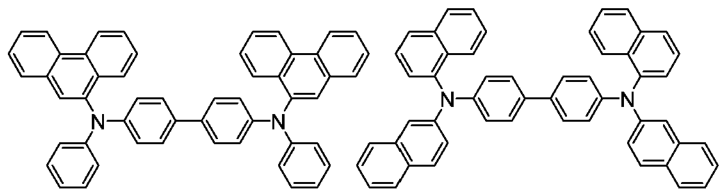

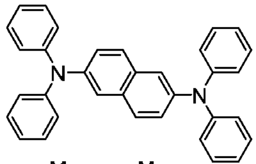

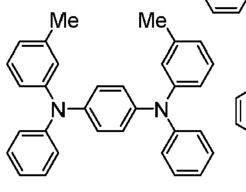

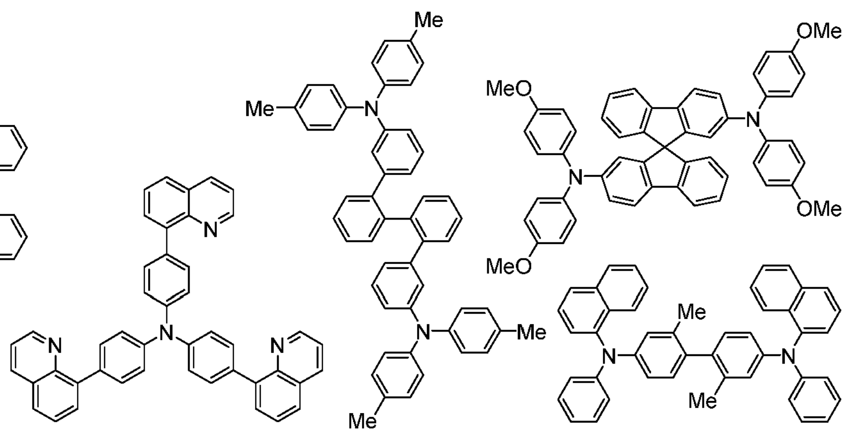

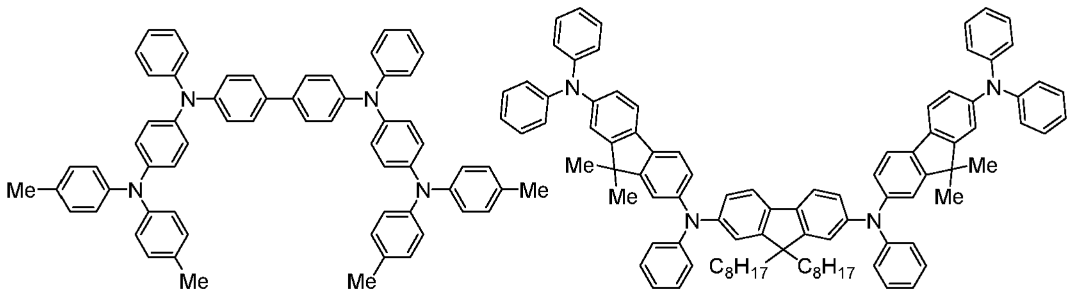

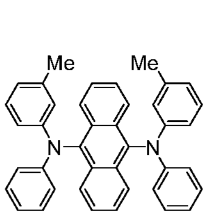
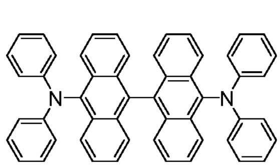
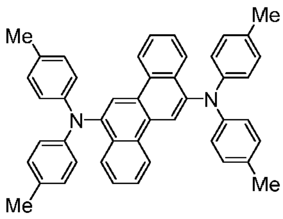
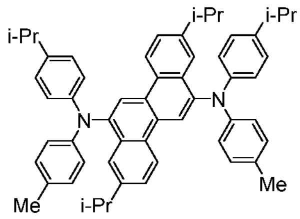

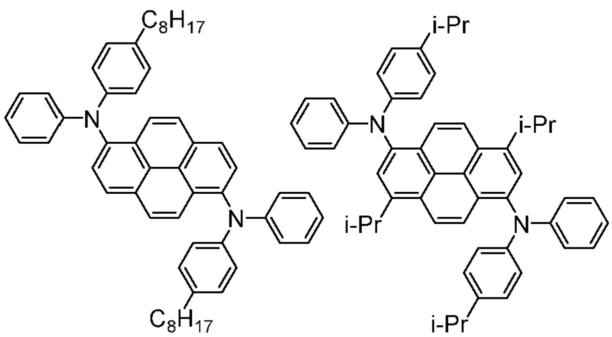
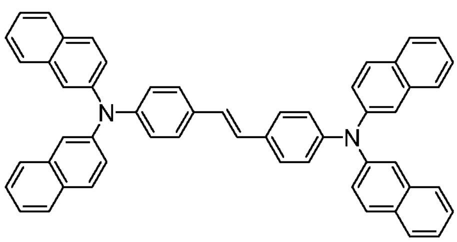

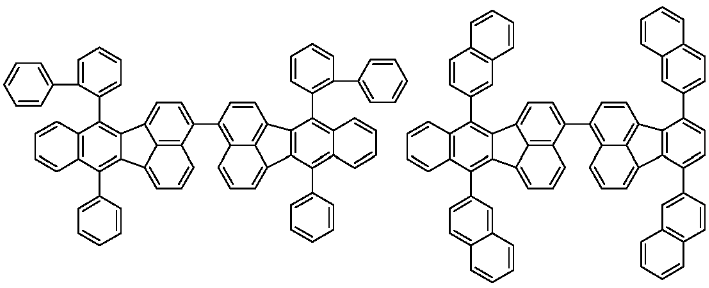
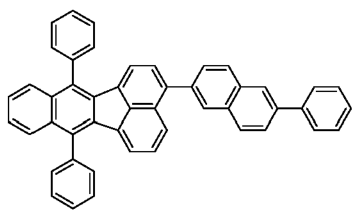

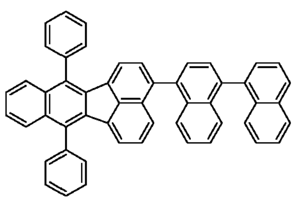
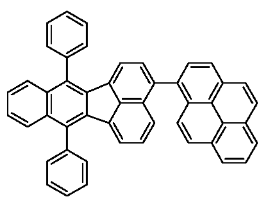
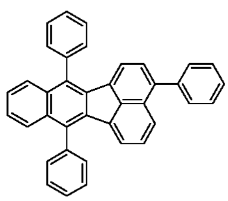
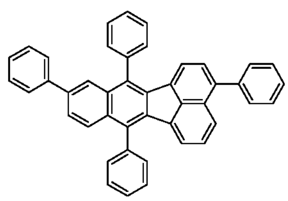

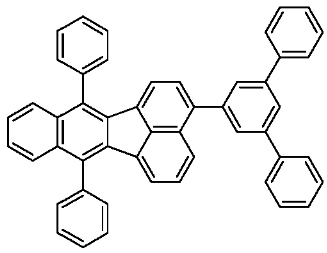
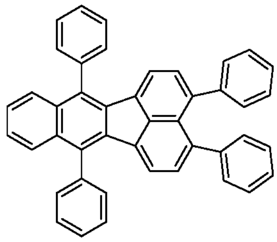
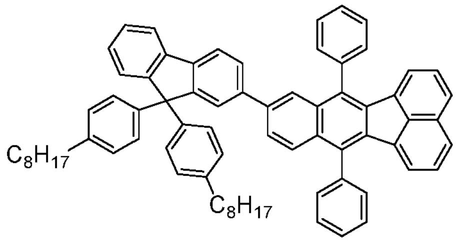

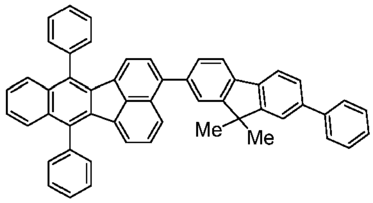
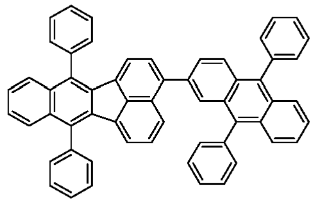
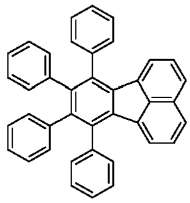
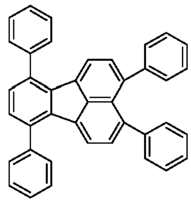

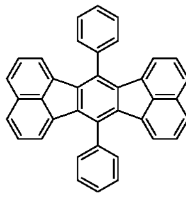
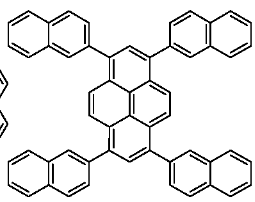
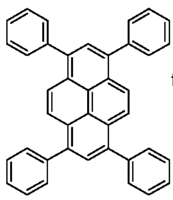
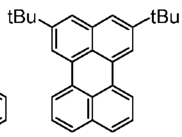
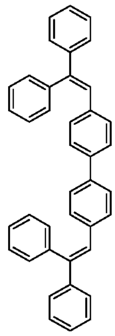
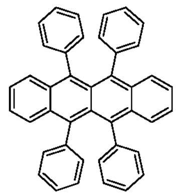

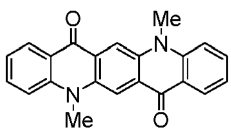
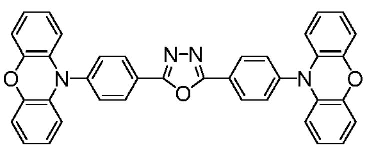
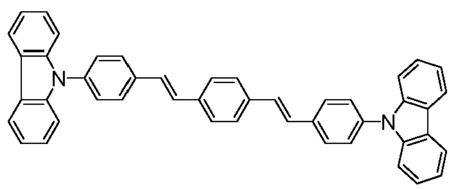

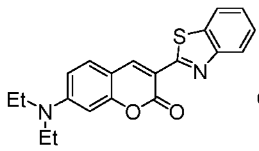
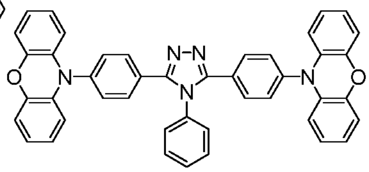
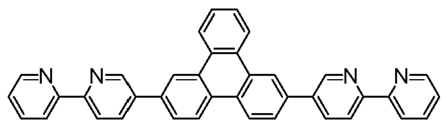

The fluorescent low-molecular compound is available from Sigma-Aldrich Co. LLC, Luminescence Technology Corp., AK Scientific, Inc., etc. Alternatively, it can be synthesized according to a method described in, for example, International Publication No. WO 2007/100010, International Publication No. WO 2008/059713, International Publication No. WO 2011/012212, International Publication No. WO 2012/096263, International Publication No. WO 2006/025273, or International Publication No. WO 2006/030527.

[Host material]

It is preferable that the first organic layer should be a layer containing the fluorescent low-molecular compound and a host material having at least one function selected from the group consisting of a hole-injecting function, a hole-transporting function, an electron-injecting function and an electron-transporting function, because the external quantum efficiency of the light-emitting device according to the present embodiment is better. In the case where the first organic layer is a layer containing the fluorescent low-molecular compound and a host material, one host material may be contained singly, or two or more may be contained.

In the case where the first organic layer is a layer containing the fluorescent low-molecular compound and a host material, the amount of the fluorescent low-molecular compound is usually 0.05 to 80 parts by mass, preferably

0.1 to 50 parts by mass, more preferably 1 to 30 parts by mass and further preferably 5 to 15 parts by mass with respect to 100 parts by mass in total of the fluorescent low-molecular compound and the host material.

In the case where the first organic layer is a layer containing the fluorescent low-molecular compound and a host material, it is preferable that the lowest excited singlet state ($S_1$) possessed by the host material should have an energy level equivalent to or an energy level higher than that of $S_1$ possessed by the fluorescent low-molecular compound because the external quantum efficiency of the light-emitting device according to the present embodiment is excellent. Specifically, it is preferable that the maximum peak wavelength of an emission spectrum of the host material should be a wavelength equivalent to or shorter than the maximum peak wavelength of an emission spectrum of the fluorescent low-molecular compound because the external quantum efficiency of the light-emitting device according to the present embodiment is excellent.

It is preferable for the host material to exhibit solubility in a solvent capable of dissolving the fluorescent low-molecular compound contained in the first organic layer, because the light-emitting device according to the present embodiment can be prepared by a solution coating process.

The host material is classified into a low-molecular compound and a polymer compound. Examples of the host material include hole-transporting materials mentioned later and electron-transporting materials mentioned later.

[Low-molecular host]

The low-molecular compound preferable as the host material (hereinafter, also referred to as a "low-molecular host") will be described.

The low-molecular host is preferably a compound represented by the formula (FH-1).

Each of $Ar^{H1}$ and $Ar^{H2}$ is preferably an aryl group or a monovalent heterocyclic group, more preferably an aryl group. These groups optionally have a substituent.

In the case where each of $Ar^{H1}$ and $Ar^{H2}$ is an aryl group, the number of carbon atoms of the aryl group is usually 6 to 60, preferably 6 to 30, more preferably 6 to 20 and further preferably 6 to 14 which excludes the number of carbon atoms of a substituent.

In the case where each of $Ar^{H1}$ and $Ar^{H2}$ is an aryl group, examples of the aryl group include a group formed by removing one hydrogen atom directly bonded to an annular carbon atom from a benzene ring, a naphthalene ring, an anthracene ring, a phenanthrene ring, a triphenylene ring, a dihydrophenanthrene ring, a naphthacene ring, a fluorene ring, a spirobifluorene ring, a pyrene ring, a perylene ring, a chrysene ring, an indene ring, a fluoranthene ring or a benzofluoranthene ring. The aryl group is preferably a group formed by removing one hydrogen atom directly bonded to an annular carbon atom from a benzene ring, a naphthalene ring, an anthracene ring, a phenanthrene ring, a dihydrophenanthrene ring, a fluorene ring, a spirobifluorene ring, a pyrene ring or a chrysene ring, more preferably a group formed by removing one hydrogen atom directly bonded to an annular carbon atom from a benzene ring, a naphthalene ring, an anthracene ring, a pyrene ring, a fluorene ring or a spirobifluorene ring, further preferably a phenyl group, a naphthyl group or an anthracenyl group, particularly preferably a phenyl group or a naphthyl group. These groups optionally further have a substituent.

In the case where each of $Ar^{H1}$ and $Ar^{H2}$ is a monovalent heterocyclic group, the number of carbon atoms of the monovalent heterocyclic group is usually 2 to 60, preferably 3 to 30 and more preferably 3 to 20 which excludes the number of carbon atoms of a substituent.

In the case where each of $Ar^{H1}$ and $Ar^{H2}$ is a monovalent heterocyclic group, examples of the monovalent heterocyclic group include a group formed by removing one hydrogen atom directly bonded to an annular carbon atom or heteroatom from a pyrrole ring, a diazole ring, a triazole ring, a pyridine ring, a diazabenzene ring, a triazine ring, an azanaphthalene ring, a diazanaphthalene ring, a triazanaphthalene ring, an indole ring, a benzodiazole ring, a benzotriazole ring, a carbazole ring, an azacarbazole ring, a diazacarbazole ring, a dibenzofuran ring, a dibenzothiophene ring, a phenoxazine ring, a phenothiazine ring, an acridine ring, a 9,10-dihydroacridine ring, an acridone ring, a phenazine ring or a 5,10-dihydrophenazine ring. The monovalent heterocyclic group is preferably a group formed by removing one hydrogen atom directly bonded to an annular carbon atom or heteroatom from a diazole ring, a triazole ring, a pyridine ring, a diazabenzene ring, a triazine ring, an indole ring, a benzodiazole ring, a benzotriazole ring, a carbazole ring, a dibenzofuran ring, a dibenzothiophene ring, a phenoxazine ring, a phenothiazine ring, a 9,10-dihydroacridine ring or a 5,10-dihydrophenazine ring, more preferably a group formed by removing one hydrogen atom directly bonded to an annular carbon atom or heteroatom from a diazole ring, a triazole ring, a pyridine ring, a diazabenzene ring, a triazine ring, a benzodiazole ring, a benzotriazole ring, a carbazole ring, a dibenzofuran ring or a dibenzothiophene ring. These groups optionally further have a substituent.

In the case where each of $Ar^{H1}$ and $Ar^{H2}$ is a substituted amino group, an aryl group or a monovalent heterocyclic group is preferable as the substituent carried by the amino group, and an aryl group is more preferable and these groups optionally further have a substituent. Examples and the preferable range of the aryl group as the substituent carried by the amino group are the same as the examples and the preferable range of the aryl group in $Ar^{H1}$ and $Ar^{H2}$. Examples

and the preferable range of the monovalent heterocyclic group as the substituent carried by the amino group are the same as the examples and the preferable range of the monovalent heterocyclic group in $Ar^{H1}$ and $Ar^{H2}$.

The substituent optionally carried by $Ar^{H1}$ and $Ar^{H2}$ is preferably an alkyl group, a cycloalkyl group, an aryl group, a monovalent heterocyclic group, an alkoxy group, a cycloalkoxy group, an aryloxy group, a substituted amino group or a halogen atom; more preferably an alkyl group, a cycloalkyl group, an alkoxy group, a cycloalkoxy group, an aryl group, a monovalent heterocyclic group or a substituted amino group; further preferably an alkyl group, a cycloalkyl group, an aryl group or a monovalent heterocyclic group; and particularly preferably an alkyl group, a cycloalkyl group or an aryl group. These groups optionally further have a substituent.

Examples and the preferable range of the aryl group, the monovalent heterocyclic group and the substituted amino group as the substituent optionally carried by $Ar^{H1}$ and $Ar^{H2}$ are the same as the examples and the preferable range of the aryl group, the monovalent heterocyclic group and the substituted amino group in $Ar^{H1}$ and $Ar^{H2}$, respectively.

The substituent optionally further carried by the substituent optionally carried by $Ar^{H1}$ and $Ar^{H2}$ is preferably an alkyl group, a cycloalkyl group, an aryl group, a monovalent heterocyclic group, an alkoxy group, a cycloalkoxy group, an aryloxy group, a substituted amino group or a halogen atom; more preferably an alkyl group, a cycloalkyl group, an alkoxy group, a cycloalkoxy group, an aryl group, a monovalent heterocyclic group or a substituted amino group; further preferably an alkyl group, a cycloalkyl group, an aryl group or a monovalent heterocyclic group; and particularly preferably an alkyl group or a cycloalkyl group, and these groups optionally further have a substituent.

Examples and the preferable range of the aryl group, the monovalent heterocyclic group and the substituted amino group as the substituent optionally further carried by the substituent optionally carried by $Ar^{H1}$ and $Ar^{H2}$ are the same as the examples and the preferable range of the aryl group, the monovalent heterocyclic group and the substituted amino group in $Ar^{H1}$ and $Ar^{H2}$, respectively.

$n^{H1}$ is preferably an integer of 0 to 10, more preferably an integer of 1 to 5 and further preferably an integer of 1 to 3.

$L^{H1}$ is preferably an arylene group or a divalent heterocyclic group and more preferably an arylene group.

Examples and the preferable range of the substituent optionally carried by $L^{H1}$ are the same as the examples and the preferable range of the substituent optionally carried by $Ar^{H1}$ and $Ar^{H2}$.

The arylene group in $L^{H1}$ is preferably groups represented by the formula (A-1) to the formula (A-14) or the formula (A-17) to the formula (A-20), more preferably groups represented by the formula (A-1) to the formula (A-9), the formula (A-11) to the formula (A-14), the formula (A-19) or the formula (A-20), further preferably groups represented by the formula (A-1) to the formula (A-7), the formula (A-9), the formula (A-11) to the formula (A-14) or the formula (A-19), particularly preferably groups represented by the formula (A-1) to the formula (A-6), the formula (A-11) or the formula (A-12).

The divalent heterocyclic group in $L^{H1}$ is preferably groups represented by the formula (AA-1) to the formula (AA-6), the formula (AA-10) to the formula (AA-22) or the formula (AA-24) to the formula (AA-34), more preferably groups represented by the formula (AA-1) to the formula (AA-4), the formula (AA-10) to the formula (AA-15), the formula (AA-18) to the formula (AA-21) or the formula (AA-27) to the formula (AA-34), further preferably groups represented by the formula (AA-1) to the formula (AA-4), the formula (AA-10) to the formula (AA-15) or the formula (AA-27) to the formula (AA-32).

$n^{H11}$ is preferably an integer of 1 to 5, more preferably an integer of 1 to 3, further preferably 1.

It is preferable that $R^{H11}$ should be a hydrogen atom, an alkyl group, a cycloalkyl group, an aryl group or a monovalent heterocyclic group, it is more preferable to be a hydrogen atom, an alkyl group or a cycloalkyl group, and it is further preferable to be a hydrogen atom or an alkyl group. These groups optionally have a substituent.

Examples and the preferable range of the substituent optionally carried by $R^{H11}$ are the same as the examples and the preferable range of the substituent optionally carried by $Ar^{H1}$ and $Ar^{H2}$.

Examples of the compound represented by the formula (FH-1) include compounds represented by the following formulas:

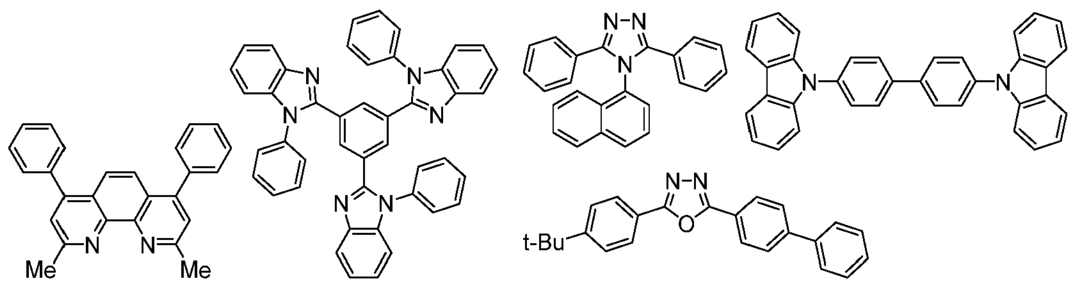

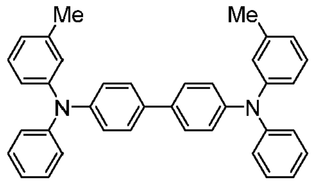
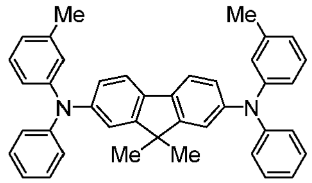
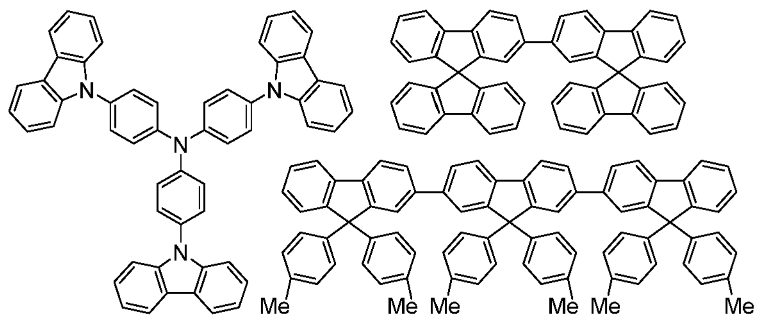
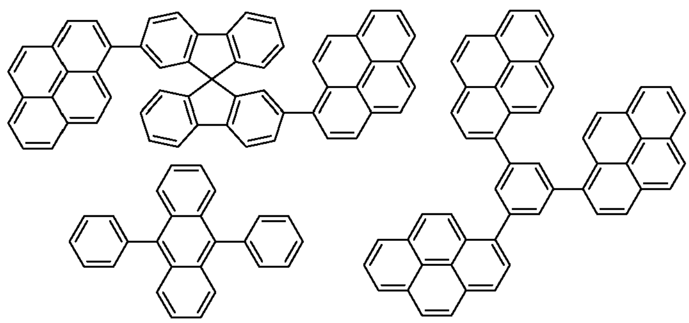
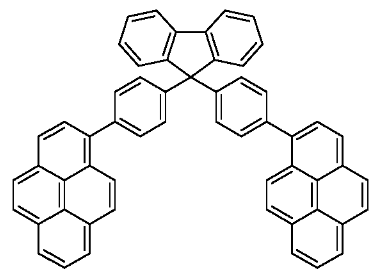
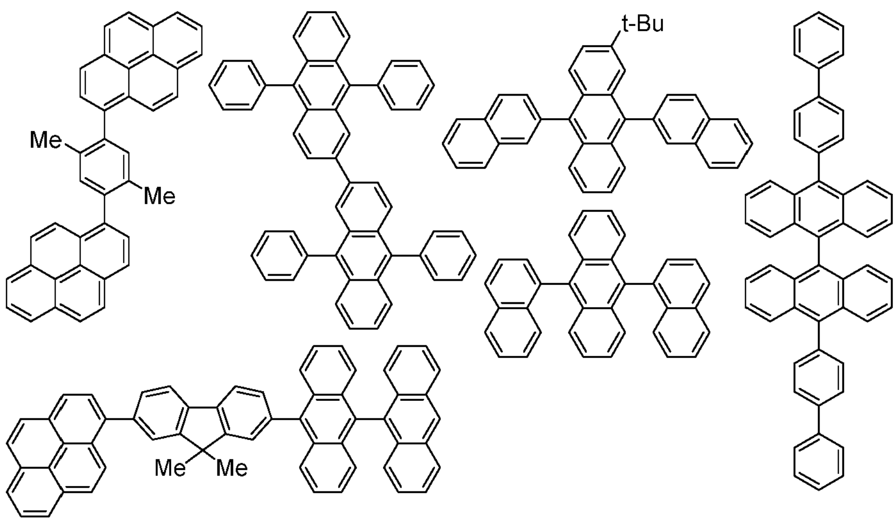
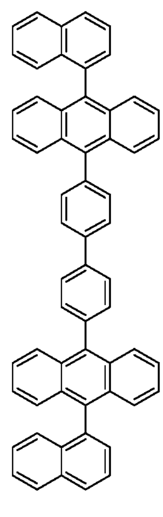
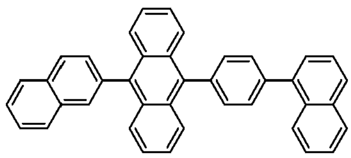
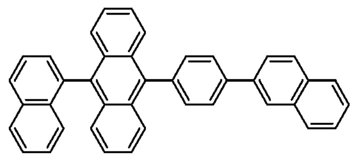
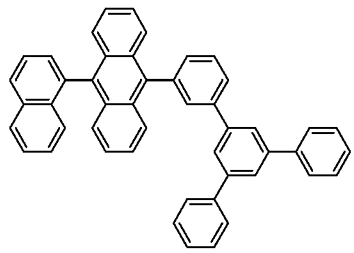

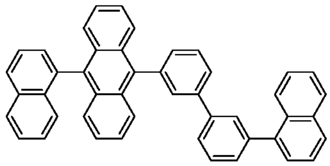
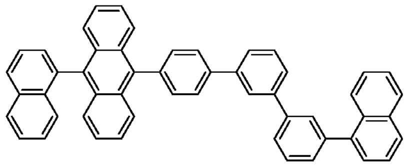
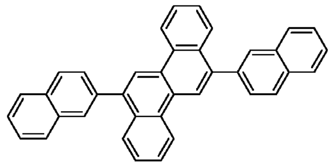

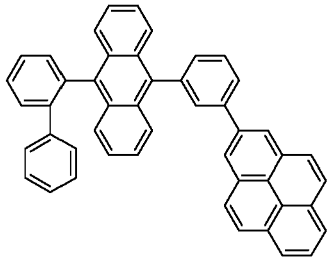
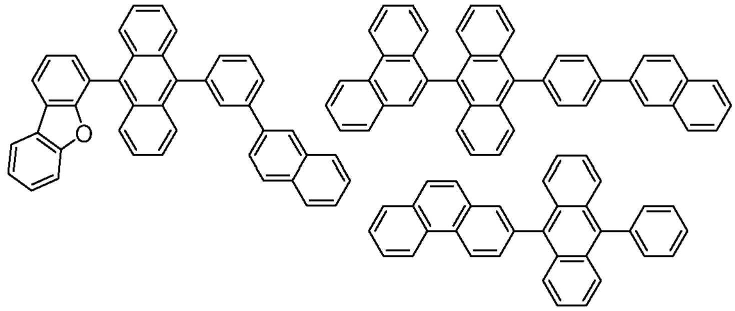

[Polymer host]

The polymer compound preferable as the host material (hereinafter, also referred to as a "polymer host") will be described.

The polymer host is preferably a polymer compound comprising a constitutional unit represented by the formula (Y).

The arylene group represented by $Ar^{Y1}$ is preferably groups represented by the formula (A-1), the formula (A-6), the formula (A-7), the formula (A-9) to the formula (A-11), the formula (A-13) or the formula (A-19), more preferably a group represented by the formula (A-1), the formula (A-7), the formula (A-9), the formula (A-11) or the formula (A-19). These groups optionally have a substituent.

The divalent heterocyclic group represented by $Ar^{Y1}$ is preferably a group represented by the formula (AA-4), the formula (AA-10), the formula (AA-13), the formula (AA-15), the formula (AA-18) or the formula (AA-20), more preferably a group represented by the formula (AA-4), the formula (AA-10), the formula (AA-18) or the formula (AA-20). These groups optionally have a substituent.

Preferable ranges and more preferable ranges of the arylene group and the divalent heterocyclic group in the divalent group in which at least one arylene group and at least one divalent heterocyclic group are directly bonded, represented by $Ar^{Y1}$ are similar to the preferable ranges and the more preferable ranges of the arylene group and the divalent heterocyclic group represented by $Ar^{Y1}$ mentioned above, respectively.

Examples of the divalent group in which at least one arylene group and at least one divalent heterocyclic group are directly bonded, represented by $Ar^{Y1}$ include those similar to the divalent group in which at least one arylene group and at least one divalent heterocyclic group are directly bonded, represented by $Ar^{X2}$ and $Ar^{X4}$ in the formula (X).

The substituent optionally carried by the group represented by $Ar^{Y1}$ is preferably an alkyl group, a cycloalkyl group or an aryl group. These groups optionally further have a substituent.

Examples of the constitutional unit represented by the formula (Y) include constitutional units represented by the formula (Y-1) to the formula (Y-7), preferably a constitutional unit represented by the formula (Y-1) or the formula (Y-2) from the viewpoint of the external quantum efficiency of the light-emitting device according to the present embodiment, preferably a constitutional unit represented by the formula (Y-3) or the formula (Y-4) from the viewpoint of the electron-transporting function of the polymer host, and preferably a constitutional unit represented by the formula (Y-5) to the formula (Y-7) from the viewpoint of the hole-transporting function of the polymer host.

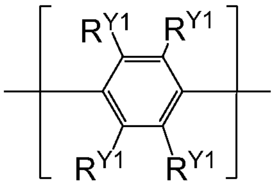 (Y-1)

In the formula, $R^{Y1}$ represents a hydrogen atom, an alkyl group, a cycloalkyl group, an alkoxy group, a cycloalkoxy group, an aryl group or a monovalent heterocyclic group, and these groups optionally have a substituent. A plurality of $R^{Y1}$ present are the same or different and adjacent groups $R^{Y1}$ are optionally bonded to each other to form a ring together

with the carbon atoms to which they are attached.

$R^{Y1}$ is preferably a hydrogen atom, an alkyl group, a cycloalkyl group or an aryl group. These groups optionally have a substituent.

The constitutional unit represented by the formula (Y-1) is preferably a constitutional unit represented by the formula (Y-1').

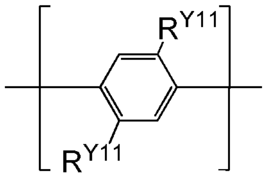

(Y-1')

In the formula, $R^{Y11}$ represents an alkyl group, a cycloalkyl group, an alkoxy group, a cycloalkoxy group, an aryl group or a monovalent heterocyclic group, and these groups optionally have a substituent. A plurality of $R^{Y11}$ present are the same or different.

$R^{Y11}$ is preferably an alkyl group, a cycloalkyl group or an aryl group, more preferably an alkyl group or a cycloalkyl group. These groups optionally have a substituent.

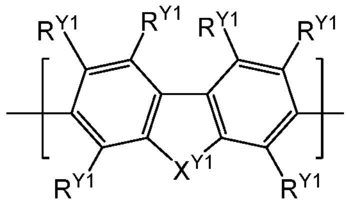

(Y-2)

In the formula, $R^{Y1}$ represents the same meaning as above. $X^{Y1}$ represents a group represented by $-C(R^{Y2})_2-$, $-C(R^{Y2}) = C(R^{Y2})-$ or $-C(R^{Y2})_2-C(R^{Y2})_2-$. $R^{Y2}$ represents a hydrogen atom, an alkyl group, a cycloalkyl group, an alkoxy group, a cycloalkoxy group, an aryl group or a monovalent heterocyclic group, and these groups optionally have a substituent. A plurality of $R^{Y2}$ present are the same or different, and $R^{Y2}$ are optionally bonded to each other to form a ring together with the carbon atoms to which they are attached.

$R^{Y2}$ is preferably an alkyl group, a cycloalkyl group, an aryl group or a monovalent heterocyclic group, more preferably an alkyl group, a cycloalkyl group or an aryl group, and these groups optionally have a substituent.

In $X^{Y1}$, the combination of two $R^{Y2}$ in the group represented by $-C(R^{Y2})_2-$ is preferably alkyl groups or cycloalkyl groups for both, aryl groups for both, monovalent heterocyclic groups for both, or an alkyl group or a cycloalkyl group for one of them and an aryl group or a monovalent heterocyclic group for the other, more preferably an alkyl group or a cycloalkyl group for one of them and an aryl group for the other. These groups optionally have a substituent. Two $R^{Y2}$ present are optionally bonded to each other to form a ring together with the atoms to which they are attached, and in the case where $R^{Y2}$ forms a ring, the group represented by $-C(R^{Y2})_2-$ is preferably a group represented by the formula (Y-A1) to the formula (Y-A5), more preferably a group represented by the formula (Y-A4). These groups optionally have a substituent.

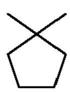
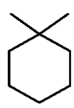
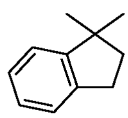
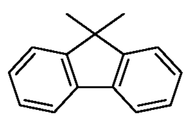
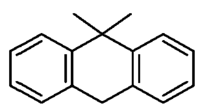

(Y-A1) (Y-A2) (Y-A3) (Y-A4) (Y-A5)

In $X^{Y1}$, the combination of two $R^{Y2}$ in the group represented by $-C(R^{Y2}) = C(R^{Y2})-$ is preferably alkyl groups or cycloalkyl groups for both, or an alkyl group or a cycloalkyl group for one of them and an aryl group for the other, and these groups optionally have a substituent.

In $X^{Y1}$, each of four $R^{Y2}$ in the group represented by $-C(R^{Y2})_2-C(R^{Y2})_2-$ is preferably an alkyl group optionally having a substituent or a cycloalkyl group optionally having a substituent. A plurality of $R^{Y2}$ are optionally bonded to each other to form a ring together with the atoms to which they are attached, and in the case where the groups $R^{Y2}$ forms a ring, the group represented by $-C(R^{Y2})_2-C(R^{Y2})_2-$ is preferably groups represented by the formula (Y-B1) to the formula (Y-B5), more preferably a group represented by the formula (Y-B3). These groups optionally have a substituent.

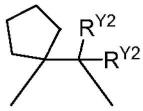
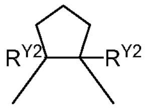
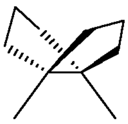
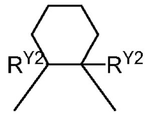
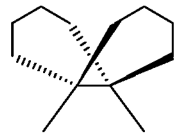

(Y-B1) (Y-B2) (Y-B3) (Y-B4) (Y-B5)

In the formulas, $R^{Y2}$ represents the same meaning as above.

It is preferable that the constitutional unit represented by the formula (Y-2) should be a constitutional unit represented by the formula (Y-2').

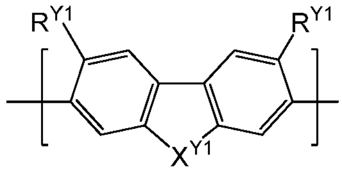
(Y-2')

In the formula, $R^{Y1}$ and $X^{Y1}$ represent the same meanings as above.

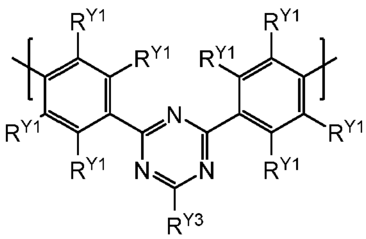
(Y-3)

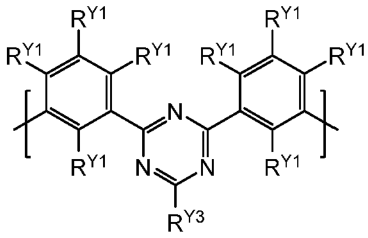
(Y-4)

In the formulas, $R^{Y1}$ represents the same meaning as above. $R^{Y3}$ represents a hydrogen atom, an alkyl group, a cycloalkyl group, an alkoxy group, a cycloalkoxy group, an aryl group or a monovalent heterocyclic group, and these groups optionally have a substituent.

$R^{Y3}$ is preferably an alkyl group, a cycloalkyl group, an alkoxy group, a cycloalkoxy group, an aryl group or a monovalent heterocyclic group, more preferably an aryl group. These groups optionally have a substituent.

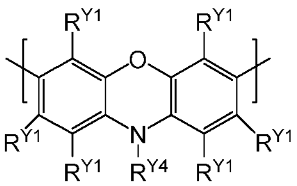
(Y-5)

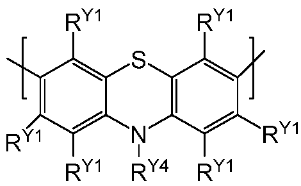
(Y-6)

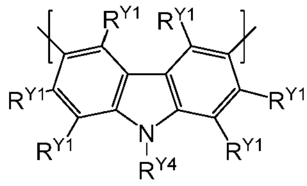
(Y-7)

In the formulas, $R^{Y1}$ represents the same meaning as above. $R^{Y4}$ represents a hydrogen atom, an alkyl group, a cycloalkyl group, an alkoxy group, a cycloalkoxy group, an aryl group or a monovalent heterocyclic group, and these groups optionally have a substituent.

$R^{Y4}$ is preferably an alkyl group, a cycloalkyl group, an alkoxy group, a cycloalkoxy group, an aryl group or a monovalent heterocyclic group, more preferably an aryl group. These groups optionally have a substituent.

Examples of the constitutional unit represented by the formula (Y) include constitutional units represented by the formula (Y-11) to the formula (Y-56), preferably constitutional units represented by the formula (Y-11) to the formula (Y-55).

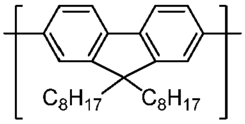
(Y-11)

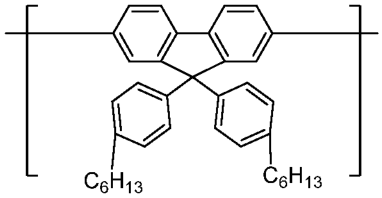
(Y-12)

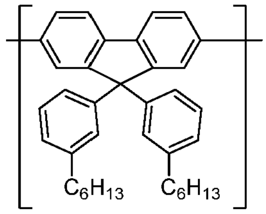
(Y-13)

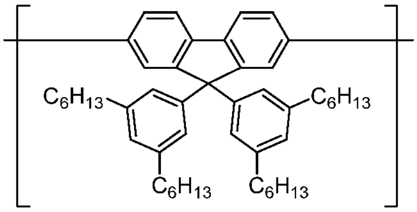
(Y-14)

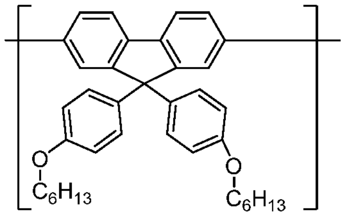
(Y-15)

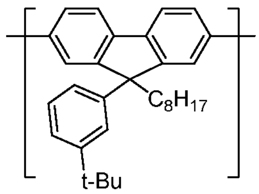
(Y-16)

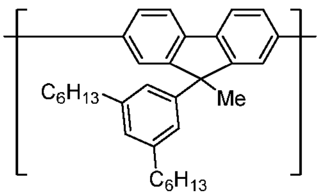
(Y-17)

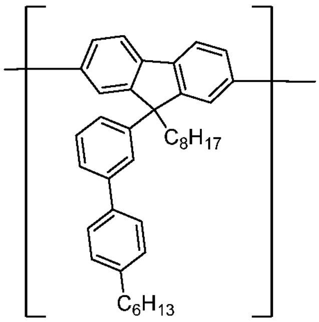
(Y-18)

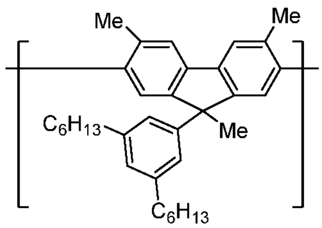
(Y-19)

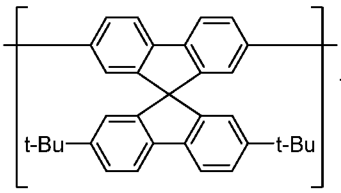
(Y-20)

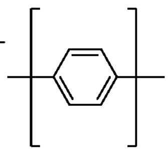
(Y-21)

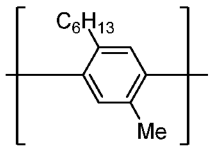
(Y-22)

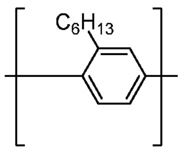
(Y-23)

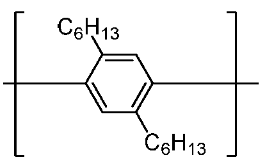
(Y-24)

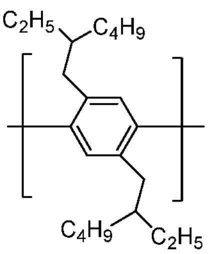
(Y-25)

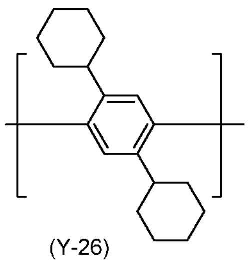
(Y-26)

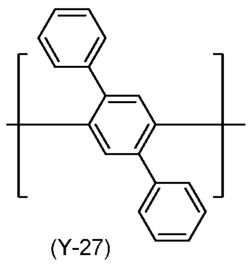
(Y-27)

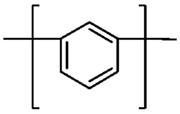
(Y-28)

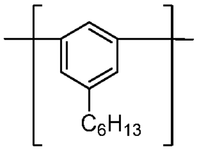
(Y-29)

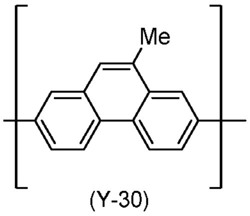
(Y-30)

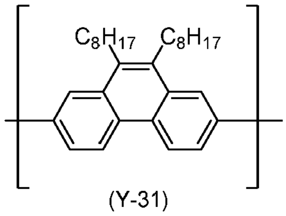
(Y-31)

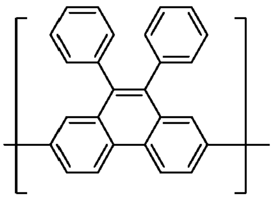
(Y-32)

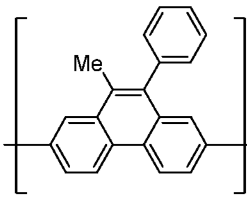
(Y-33)

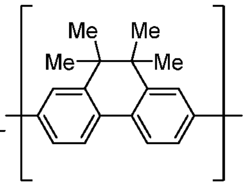
(Y-34)

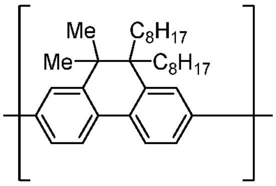
(Y-35)

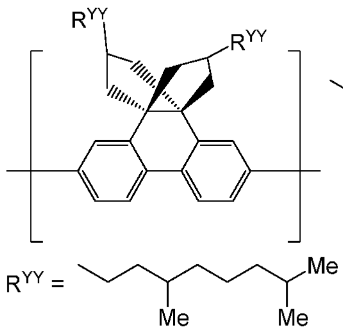
(Y-36)

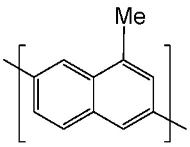
(Y-37)

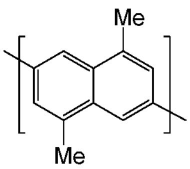
(Y-38)

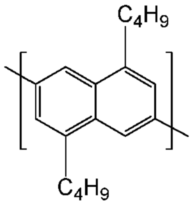
(Y-39)

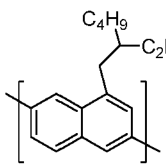
(Y-40)

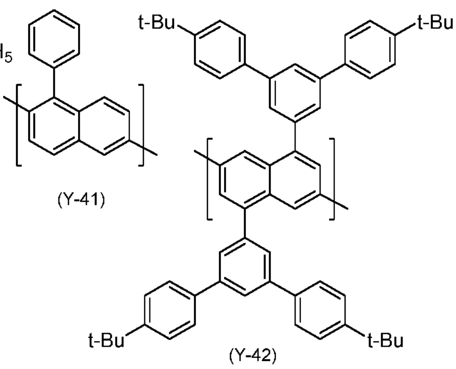
(Y-41)

(Y-42)

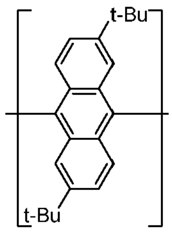
(Y-43)

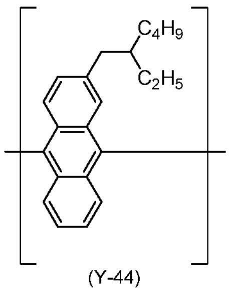
(Y-44)

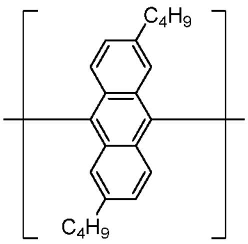
(Y-45)

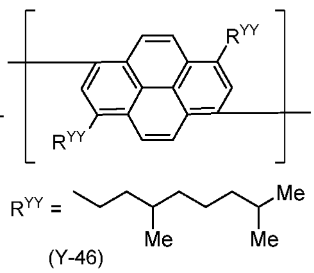
(Y-46)

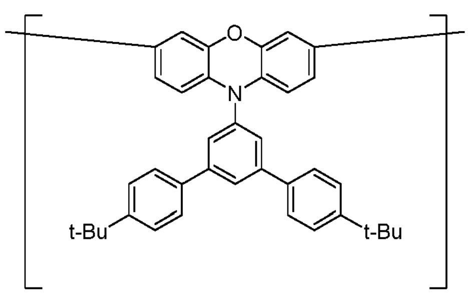
(Y-47)

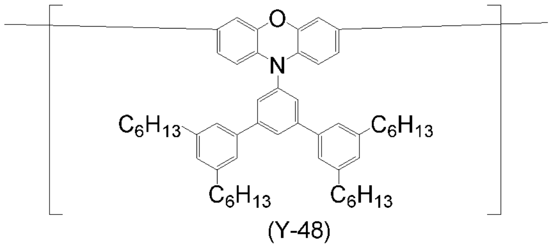

(Y-48)

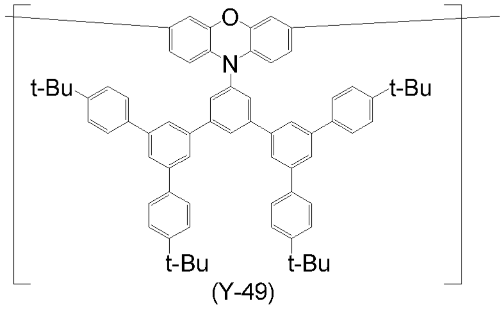

(Y-49)

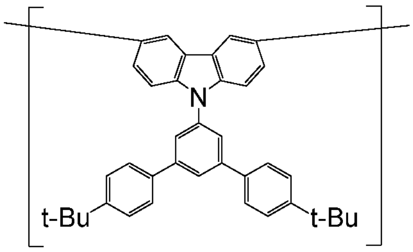

(Y-50)

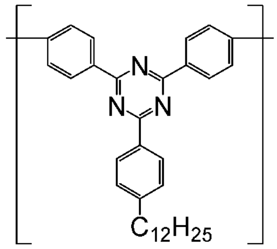

(Y-51)

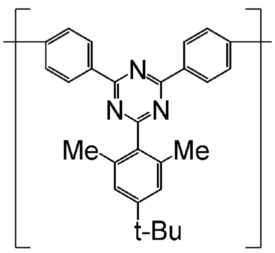

(Y-52)

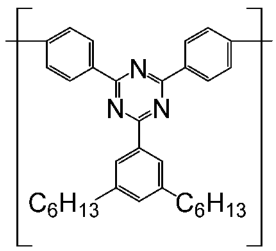

(Y-53)

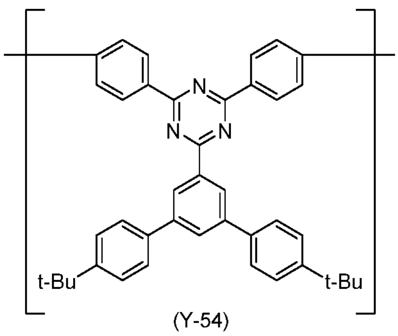

(Y-54)

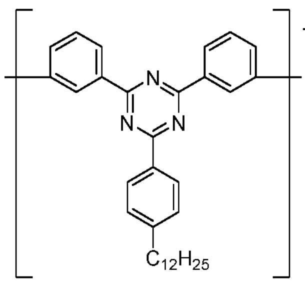

(Y-55)

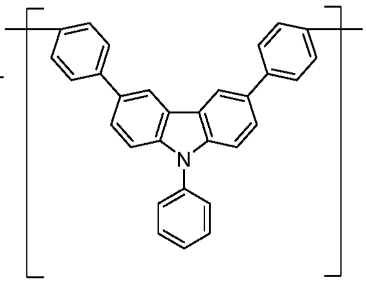

(Y-56)

The constitutional unit which is a constitutional unit represented by the formula (Y) wherein $Ar^{Y1}$ is an arylene group is preferably 10 to 100% by mol, more preferably 50 to 100% by mol with respect to the total content of constitutional units contained in the polymer host, because the external quantum efficiency of the light-emitting device according to the present embodiment is better.

The constitutional unit which is a constitutional unit represented by the formula (Y) wherein $Ar^{Y1}$ is a divalent heterocyclic group, or a divalent group in which at least one arylene group and at least one divalent heterocyclic group are directly bonded is preferably 0.5 to 40% by mol, more preferably 3 to 30% by mol with respect to the total content of constitutional units contained in the polymer host because the charge-transporting function of the polymer host is excellent.

Only one constitutional unit represented by the formula (Y) may be contained in the polymer host or two or more may be contained.

It is preferable that the polymer host should further comprise a constitutional unit represented by the formula (X) because the hole-transporting function is excellent.

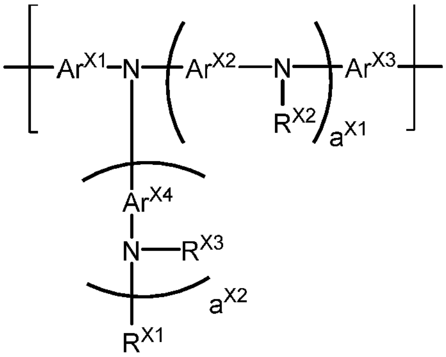

(X)

In the formula,

$a^{X1}$ and $a^{X2}$ each independently represent an integer of 0 or larger.
$Ar^{X1}$ and $Ar^{X3}$ each independently represent an arylene group or a divalent heterocyclic group and these groups optionally have a substituent.
$Ar^{X2}$ and $Ar^{X4}$ each independently represent an arylene group, a divalent heterocyclic group or a divalent group in which at least one arylene group and at least one divalent heterocyclic group are directly bonded and these groups optionally have a substituent. In the case where a plurality of $Ar^{X2}$ and $Ar^{X4}$ are present, they are the same or different.
$R^{X1}$, $R^{X2}$ and $R^{X3}$ each independently represent a hydrogen atom, an alkyl group, a cycloalkyl group, an aryl group or a monovalent heterocyclic group, and these groups optionally have a substituent.

In the case where pluralities of $R^{X2}$ and $R^{X3}$ are present, they are the same or different.
$a^{X1}$ is preferably an integer of 2 or smaller, more preferably 1, because the external quantum efficiency of the light-emitting device according to the present embodiment is better.
$a^{X2}$ is preferably an integer of 2 or smaller, more preferably 0, because the external quantum efficiency of the light-emitting device according to the present embodiment is better.

Each of $R^{X1}$, $R^{X2}$ and $R^{X3}$ is preferably an alkyl group, a cycloalkyl group, an aryl group or a monovalent heterocyclic group, more preferably an aryl group. These groups optionally have a substituent.

The arylene group represented by $Ar^{X1}$ and $Ar^{X3}$ is preferably a group represented by the formula (A-1) or the formula (A-9), more preferably a group represented by the formula (A-1). These groups optionally have a substituent.

The divalent heterocyclic group represented by $Ar^{X1}$ and $Ar^{X3}$ is preferably groups represented by the formula (AA-1), the formula (AA-2) or the formula (AA-7) to the formula (AA-26). These groups optionally have a substituent.

Each of $Ar^{X1}$ and $Ar^{X3}$ is preferably an arylene group optionally having a substituent.

The arylene group represented by $Ar^{X2}$ and $Ar^{X4}$ is preferably groups represented by the formula (A-1), the formula (A-6), the formula (A-7), the formula (A-9) to the formula (A-11) or the formula (A-19). These groups optionally have a substituent.

The preferable range of the divalent heterocyclic group represented by $Ar^{X2}$ and $Ar^{X4}$ is the same as the preferable range of the divalent heterocyclic group represented by $Ar^{X1}$ and $Ar^{X3}$.

The preferable range and more preferable range of the arylene group and the divalent heterocyclic group in the divalent group in which at least one arylene group and at least one divalent heterocyclic group are directly bonded to each other, represented by $Ar^{X2}$ and $Ar^{X4}$ are the same as the preferable range and the more preferable range of the arylene group and the divalent heterocyclic group represented by $Ar^{X1}$ and $Ar^{X3}$, respectively.

Examples of the divalent group in which at least one arylene group and at least one divalent heterocyclic group are directly bonded to each other, represented by $Ar^{X2}$ and $Ar^{X4}$ include groups represented by the following formulas, and these groups optionally have a substituent:

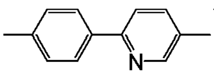
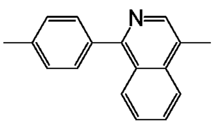
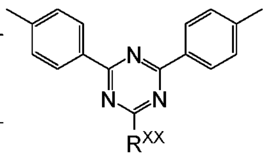
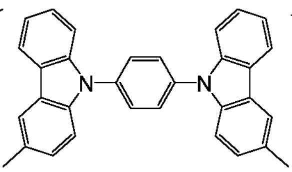
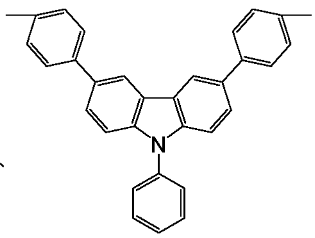

In the formulas, $R^{XX}$ represents a hydrogen atom, an alkyl group, a cycloalkyl group, an aryl group or a monovalent heterocyclic group, and these groups optionally have a substituent.

Each of $Ar^{X2}$ and $Ar^{X4}$ is preferably an arylene group optionally having a substituent.

The substituent optionally carried by the group represented by $Ar^{X1}$ to $Ar^{X4}$ and $R^{X1}$ to $R^{X3}$ is preferably an alkyl group, a cycloalkyl group or an aryl group. These groups optionally further have a substituent.

The constitutional unit represented by the formula (X) is preferably constitutional units represented by the formula (X-1) to the formula (X-7), more preferably constitutional units represented by the formula (X-3) to the formula (X-7), further preferably constitutional units represented by the formula (X-3) to the formula (X-6).

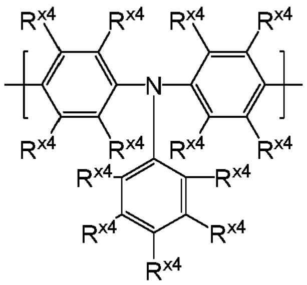

(X-1)

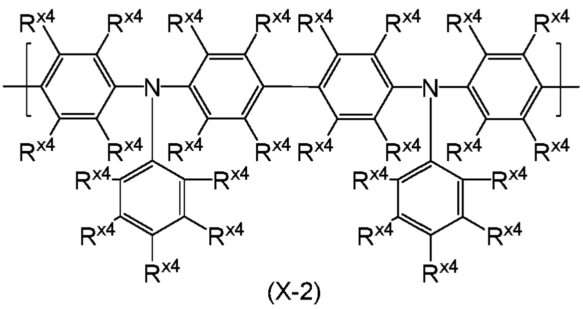

(X-2)

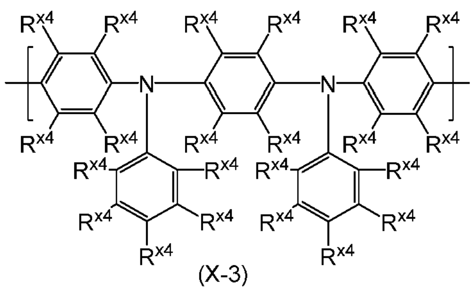

(X-3)

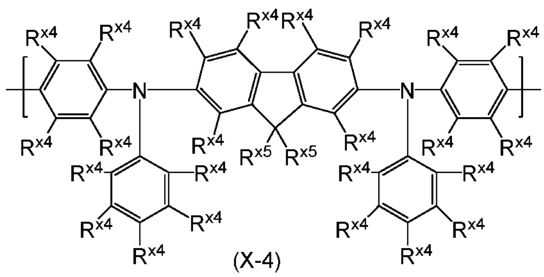

(X-4)

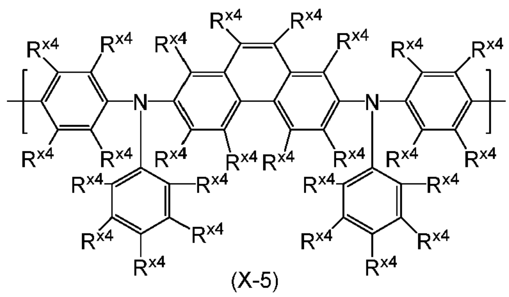

(X-5)

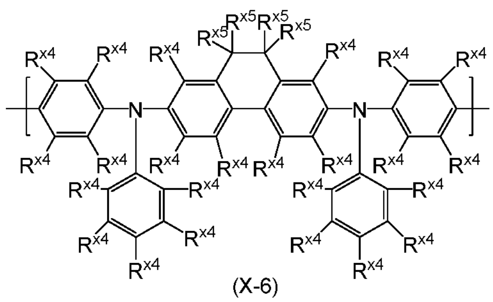

(X-6)

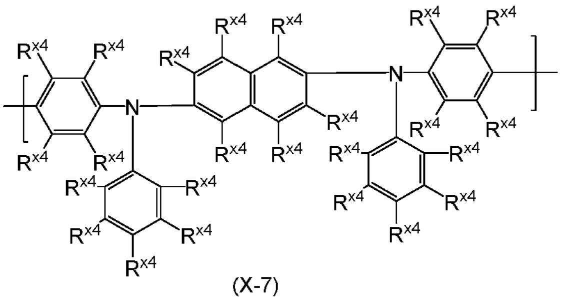

(X-7)

In the formulas, $R^{X4}$ and $R^{X5}$ each independently represent a hydrogen atom, an alkyl group, a cycloalkyl group, an alkoxy group, a cycloalkoxy group, an aryl group, an aryloxy group, a halogen atom, a monovalent heterocyclic group or a cyano group, and these groups optionally have a substituent. A plurality of $R^{X4}$ present are the same or different. A plurality of $R^{X5}$ present are the same or different, and adjacent groups $R^{X5}$ are optionally bonded to each other to form a ring together with the carbon atoms to which they are attached.

The constitutional unit represented by the formula (X) is preferably 0.1 to 50% by mol, more preferably 1 to 40% by mol, further preferably 5 to 30% by mol, with respect to the total content of all constitutional units contained in the polymer host, because the hole-transporting function is excellent.

Examples of the constitutional unit represented by the formula (X) include constitutional units represented by the formula (X1-1) to the formula (X1-19), preferably constitutional units represented by the formula (X1-6) to the formula (X1-14).

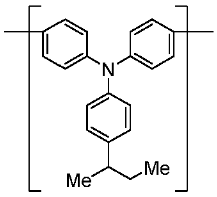
(X1-1)

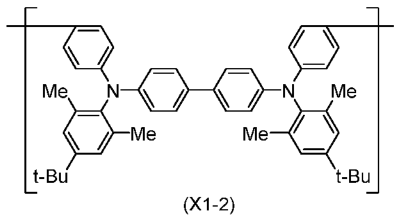
(X1-2)

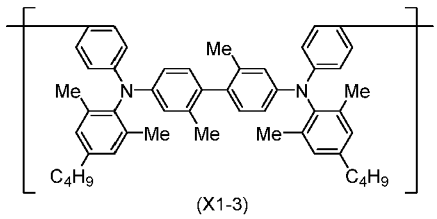
(X1-3)

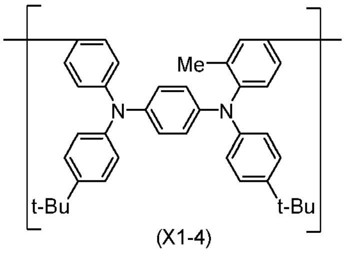
(X1-4)

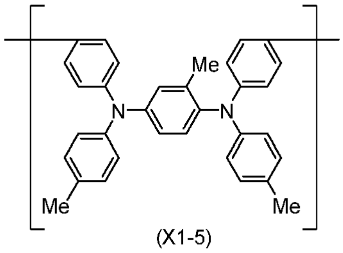
(X1-5)

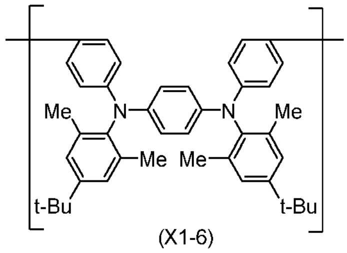
(X1-6)

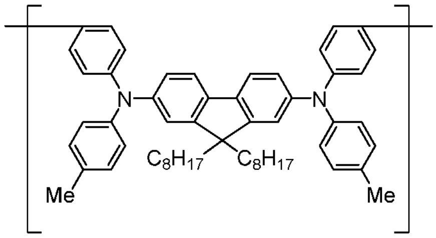
(X1-7)

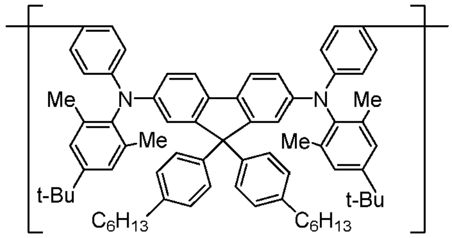
(X1-8)

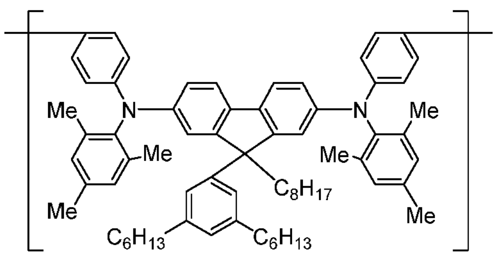
(X1-9)

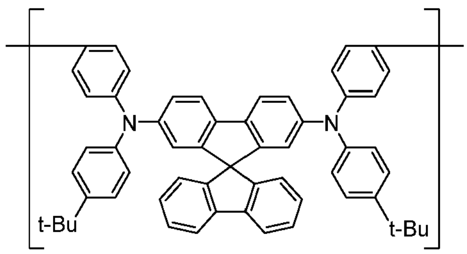
(X1-10)

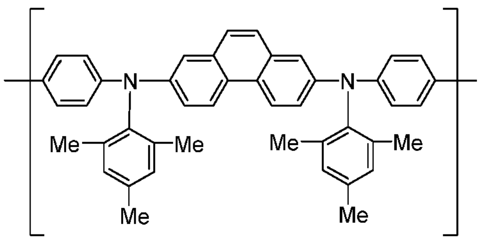
(X1-11)

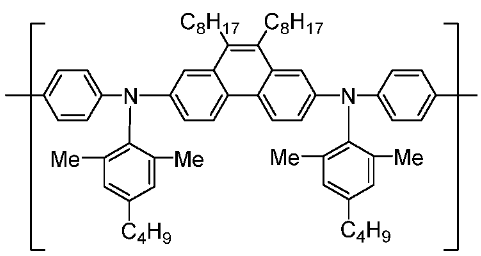
(X1-12)

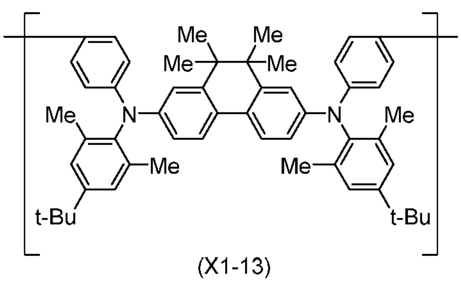

(X1-13)

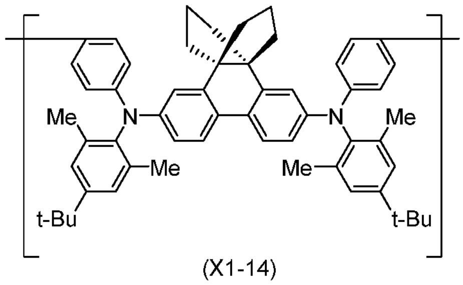

(X1-14)

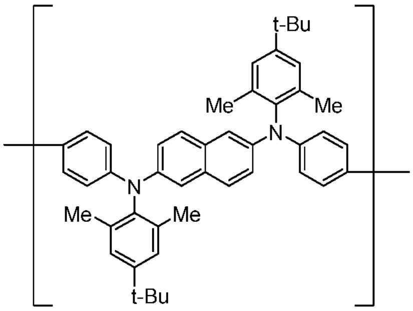

(X1-15)

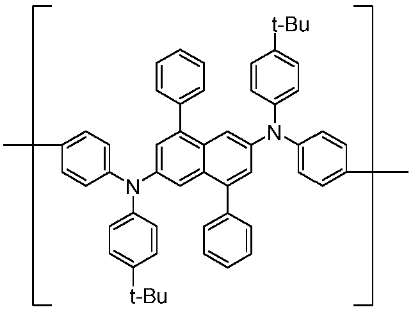

(X1-16)

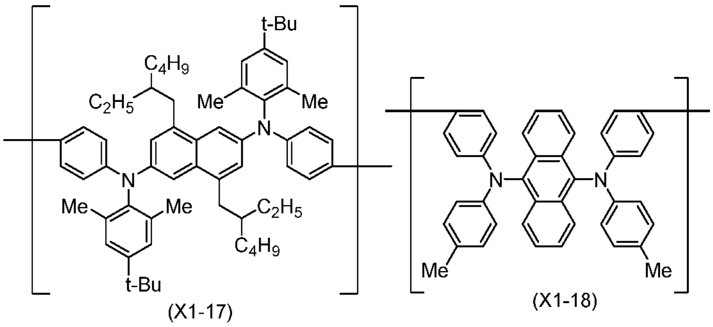

(X1-17) (X1-18)

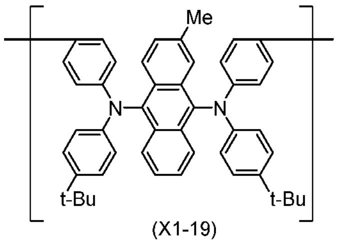

(X1-19)

In the polymer host, only one constitutional unit represented by the formula (X) may be contained, or two or more may be contained.

Examples of the polymer host include polymer compounds (P-1) to (P-6) shown in Table 1. In this context, "Additional constitutional unit" means a constitutional unit other than the constitutional unit represented by the formula (Y) and the constitutional unit represented by the formula (X).

Table 1]

| Polymer compound | Constitutional unit and molar ratio thereof | | | | |
|---|---|---|---|---|---|
| | Formula (Y) | | | Formula (X) | Additional |
| | (Y-1)-(Y-2) | (Y-3)-(Y-4) | (Y-5)-(Y-7) | (X-1)-(X-7) | |
| | p | q | r | s | t |
| (P-1) | 0.1-99.9 | 0.1-99.9 | 0 | 0 | 0-30 |
| (P-2) | 0.1-99.9 | 0 | 0.1-99.9 | 0 | 0-30 |
| (P-3) | 0.1-99.8 | 0.1-99.8 | 0 | 0.1-99.8 | 0-30 |
| (P-4) | 0.1-99.8 | 0.1-99.8 | 0.1-99.8 | 0 | 0-30 |
| (P-5) | 0.1-99.8 | 0 | 0.1-99.8 | 0.1-99.8 | 0-30 |
| (P-6) | 0.1-99.7 | 0.1-99.7 | 0.1-99.7 | 0.1-99.7 | 0-30 |

In Table 1, p, q, r, s and t represent the molar ratio of each constitutional unit. $p + q + r + s + t = 100$, and $100 \geq p + q + r + s \geq 70$.

Examples and the preferable range of the constitutional units represented by the formula (X) and the formula (Y) in the polymer compounds (P-1) to (P-6) are as mentioned above.

The polymer host may be any of a block copolymer, a random copolymer, an alternate copolymer, and a graft copolymer, or may be in other forms, and it is preferable to be a copolymer prepared by copolymerizing a plurality of raw material monomers.

The polystyrene-based number-average molecular weight of the polymer host is preferably $5 \times 10^3$ to $1 \times 10^6$, more preferably $1 \times 10^4$ to $5 \times 10^5$, further preferably $1.5 \times 10^4$ to $2 \times 10^5$.

[Method for producing polymer host]

The polymer host can be produced using a publicly known polymerization method described in Chem. Rev., Vol. 109, p. 897-1091 (2009), etc., and examples include a method of performing polymerization through coupling reaction using a transition metal catalyst, such as Suzuki reaction, Buchwald reaction, Stille reaction, Negishi reaction and Kumada reaction.

In the above polymerization method, examples of a method for adding monomers include a method of adding the whole amount of the monomers in one portion to a reaction system, a method of adding a portion of the monomers, reacting them, and then adding the remaining monomers in one portion, continuously or in divided portions, and a method of adding the monomers continuously or in divided portions.

Examples of the transition metal catalyst include palladium catalysts and nickel catalysts.

The aftertreatment of the polymerization reaction publicly known methods is performed by using singly or in combination, for example, a method of removing water-soluble impurities by solution separation, and a method of adding the reaction solution after the polymerization reaction to a lower alcohol such as methanol, and filtering deposited precipitates, followed by drying. In the case where the purity of the polymer host is low, it can be purified by a usual method, for example, crystallization, reprecipitation, continuous extraction with a Soxhlet extractor, or column chromatography.

[First composition]

The first organic layer may be a layer containing a composition comprising the fluorescent low-molecular compound and at least one material selected from the group consisting of the host material mentioned above, a hole-transporting material, a hole-injecting material, an electron-transporting material, an electron-injecting material, an antioxidant, and a light-emitting material (different from the fluorescent low-molecular compound) (hereinafter, also referred to as a "first composition").

[Hole-transporting material]

The hole-transporting material is classified into a low-molecular compound and a polymer compound and is preferably a polymer compound. The hole-transporting material may have a cross-linking group.

Examples of the polymer compound include: polyvinylcarbazole and derivatives thereof; and polyarylene having an aromatic amine structure in the side chain or the main chain and derivatives thereof. The polymer compound may be a compound attached with an electron-accepting site. Examples of the electron-accepting site include fullerene, tetrafluorotetracyanoquinodimethane, tetracyanoethylene, and trinitrofluorenone, preferably fullerene.

In the first composition, the amount of the hole-transporting material is usually 1 to 400 parts by mass, preferably 5 to 150 parts by mass, with respect to 100 parts by mass of the fluorescent low-molecular compound.

The hole-transporting material may be used singly, or two or more may be used in combination.

[Electron-transporting material]

The electron-transporting material is classified into a low-molecular compound and a polymer compound. The electron-transporting material may have a cross-linking group.

Examples of the low-molecular compound include phosphorescent compounds with 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene and diphenoquinone, and their derivatives.

Examples of the polymer compound include polyphenylene, polyfluorene, and their derivatives. The polymer compound may be doped with a metal.

In the first composition, the amount of the electron-transporting material is usually 1 to 400 parts by mass,

preferably 5 to 150 parts by mass, with respect to 100 parts by mass of the fluorescent low-molecular compound.

The electron-transporting material may be used singly, or two or more may be used in combination.

[Hole-injecting material and electron-injecting material]

The hole-injecting material and the electron-injecting material are each classified into a low-molecular compound and a polymer compound. The hole-injecting material and the electron-injecting material may have a cross-linking group.

Examples of the low-molecular compound include metallic phthalocyanine such as copper phthalocyanine; carbon; oxides of metals such as molybdenum and tungsten; and metal fluorides such as lithium fluoride, sodium fluoride, cesium fluoride, and potassium fluoride.

Examples of the polymer compound include polyaniline, polythiophene, polypyrrole, polyphenylenevinylene, polythienylenevinylene, polyquinoline and polyquinoxaline, and their derivatives; and conductive polymers such as a polymer having an aromatic amine structure in the main chain or the side chain.

In the first composition, each of the amounts of the hole-injecting material and the electron-injecting material is usually 1 to 400 parts by mass, preferably 5 to 150 parts by mass, with respect to 100 parts by mass of the fluorescent low-molecular compound.

One each of the electron-injecting material and the hole-injecting material may be used alone, or two or more each may be used in combination.

[Ion dope]

In the case where the hole-injecting material or the electron-injecting material contains a conductive polymer, the electric conductivity of the conductive polymer is preferably $1 \times 10^{-5}$ S/cm to $1 \times 10^{3}$ S/cm. In order to adjust the electric conductivity of the conductive polymer to such a range, the conductive polymer can be doped with an appropriate amount of an ion.

The kind of the doping ion is an anion for the hole-injecting material and is a cation for the electron-injecting material. Examples of the anion include polystyrene sulfonate ions, alkylbenzene sulfonate ions, and camphorsulfonate ions. Examples of the cation include lithium ions, sodium ions, potassium ions, and tetrabutylammonium ions.

The doping ion may be used singly, or two or more may be used in combination.

[Light-emitting material]

The light-emitting material is classified into a low-molecular compound and a polymer compound. The light-emitting material may have a cross-linking group.

Examples of the low-molecular compound include naphthalene and derivatives thereof, anthracene and derivatives thereof, perylene and derivatives thereof, and triplet light-emitting complexes with iridium, platinum or europium as a central metal.

Examples of the polymer compound include polymer compounds containing a phenylene group, a naphthalenediyl group, a fluorenediyl group, a phenanthrenediyl group, a dihydrophenanthrenediyl group, a constitutional unit represented by the formula (X), a carbazolediyl group, a phenoxazinediyl group, a phenothiazinediyl group, an anthracenediyl group, a pyrenediyl group, or the like.

The light-emitting material preferably contains a triplet light-emitting complex and/or a polymer compound.

Examples of the triplet light-emitting complex include metal complexes shown below.

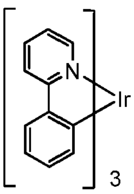
$Ir(ppy)_3$

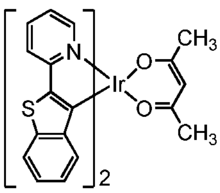
$Btp_2Ir(acac)$

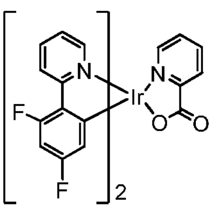
FIrpic

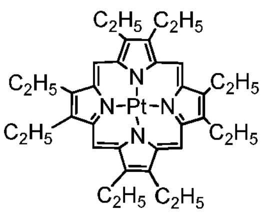
PtOEP

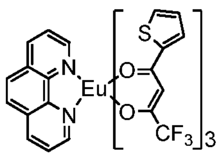
$Eu(TTA)_3phen$

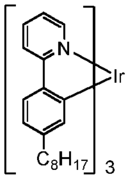

COM-1

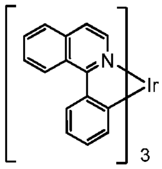

COM-2

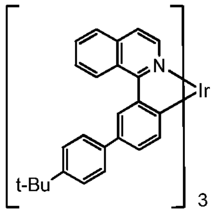

COM-3

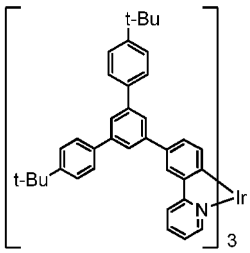

COM-4

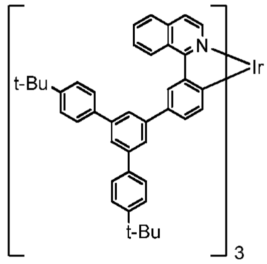

COM-5

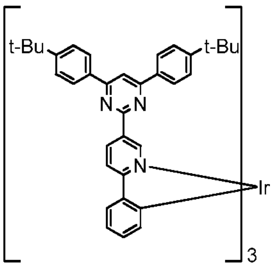

COM-6

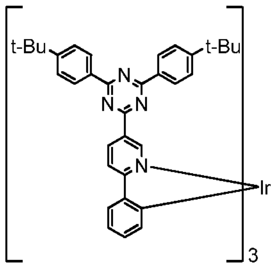

COM-7

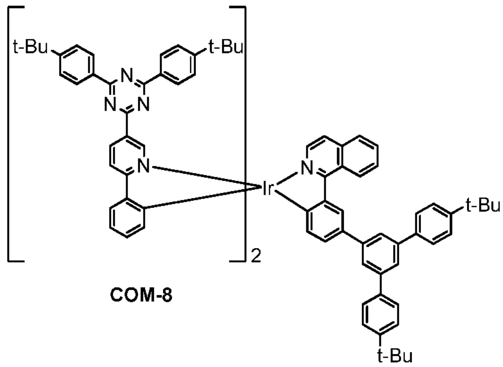

COM-8

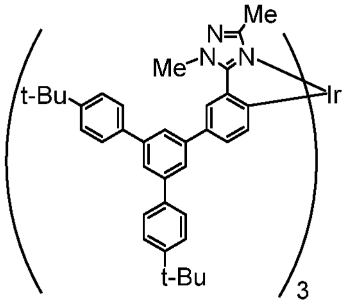

COM-9

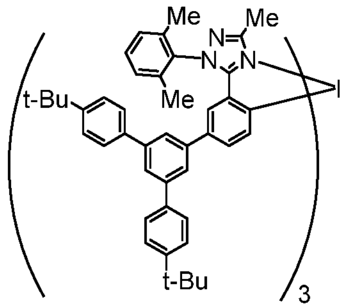

COM-10

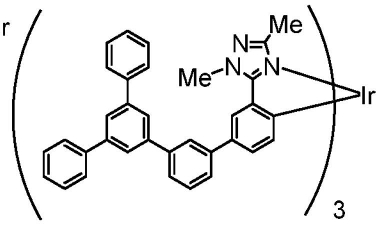

COM-11

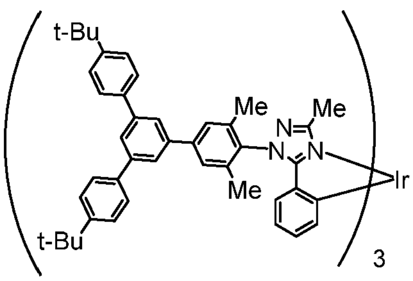

COM-12

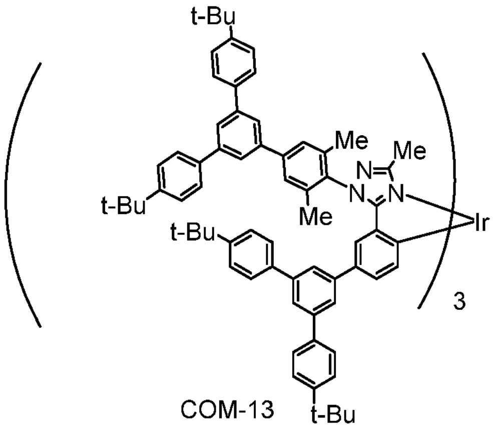

COM-13

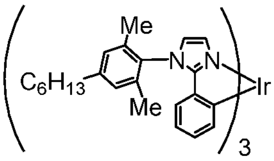

COM-14

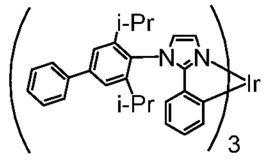

COM-15

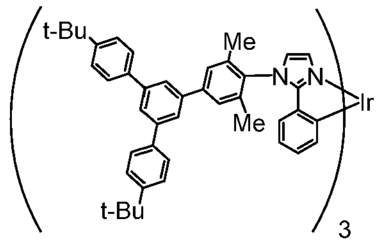

COM-16

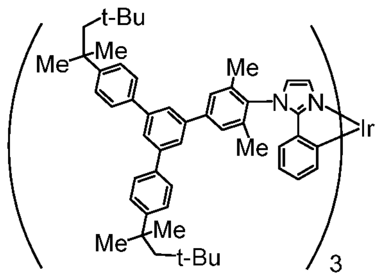

COM-17

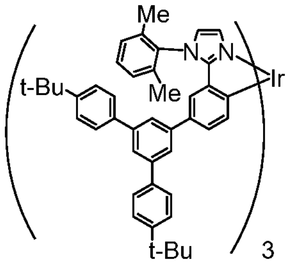

COM-18

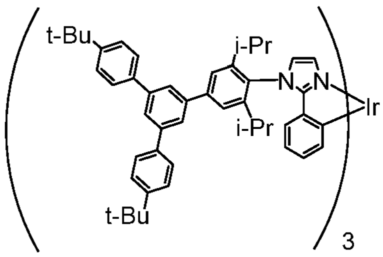

COM-19

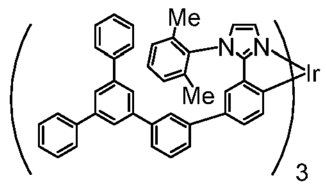

COM-20

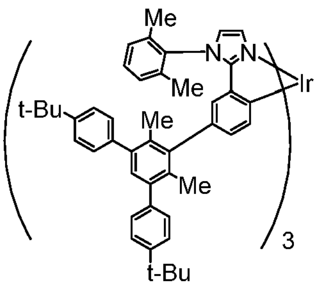

COM-21

In the first composition, the amount of the light-emitting material is usually 1 to 400 parts by mass, preferably 5 to 150 parts by mass with respect to 100 parts by mass of the fluorescent low-molecular compound.

The light-emitting material may be used singly, or two or more may be used in combination.

[Antioxidant]

The antioxidant can be a compound that is soluble in the same solvent as that for a fluorescent low-molecular compound and does not inhibit light emission and charge transport, and examples include phenol-based antioxidants and phosphorus-based antioxidants.

In the first composition, the amount of the antioxidant is usually 0.001 to 10 parts by mass with respect to 100 parts by mass of the fluorescent low-molecular compound.

The antioxidant may be used singly, or two or more may be used in combination.

[First ink]

A composition containing the fluorescent low-molecular compound and a solvent can be used as the first ink for forming the first organic layer. The first ink can be suitably used in a wet method such as a spin coating method, a casting method, a micro-gravure coating method, a gravure coating method, a bar coating method, a roll coating method, a wire bar coating method, a dip coating method, a spray coating method, a screen printing method, a flexographic printing method, an offset printing method, an inkjet printing method, a capillary coating method, or a nozzle coating method.

The viscosity of the first ink can be adjusted according to the kind of the wet method, and in the case of being applied to a printing method in which a solution passes through a discharge apparatus, such as an inkjet printing method, is preferably 1 to 20 mPa·s at 25°C because clogging or curved flight in discharging is less likely to occur.

The solvent contained in the first ink is preferably a solvent that can dissolve or uniformly disperse solid matter

in the ink. Examples of the solvent include: chlorine-based solvents such as 1,2-dichloroethane, 1,1,2-trichloroethane, chlorobenzene, and o-dichlorobenzene; ether-based solvents such as THF, dioxane, anisole, and 4-methylanisole; aromatic hydrocarbon-based solvents such as toluene, xylene, mesitylene, ethylbenzene, n-hexylbenzene, and cyclohexylbenzene; aliphatic hydrocarbon-based solvents such as cyclohexane, methylcyclohexane, n-pentane, n-hexane, n-heptane, n-octane, n-nonane, n-decane, n-dodecane, and bicyclohexyl; ketone-based solvents such as acetone, methyl ethyl ketone, cyclohexanone, and acetophenone; ester-based solvents such as ethyl acetate, butyl acetate, ethylcellosolve acetate, methyl benzoate, and phenyl acetate; polyhydric alcohol-based solvents such as ethylene glycol, glycerin, and 1,2-hexanediol; alcohol-based solvents such as isopropyl alcohol and cyclohexanol; sulfoxide-based solvents such as dimethyl sulfoxide; and amide-based solvents such as N-methyl-2-pyrrolidone and N,N-dimethylformamide. The solvent may be used singly, or two or more may be used in combination.

In the first ink, the amount of the solvent is usually 1000 to 100000 parts by mass, preferably 2000 to 20000 parts by mass, with respect to 100 parts by mass of the fluorescent low-molecular compound.

It is preferable that the first organic layer should be a layer that does not contain the triplet light-emitting complex mentioned above.

<Second organic layer>

The second organic layer is a layer containing a cross-linked form of a polymer compound comprising a cross-linking constitutional unit having a cross-linking group (hereinafter, also referred to as a "polymer compound of the second organic layer").

In the second organic layer, the cross-linked form of the polymer compound of the second organic layer may be contained singly, or two or more may be contained.

The cross-linked form of the polymer compound of the second organic layer is obtained by preparing the polymer compound of the second organic layer into a cross-linked state by the method and the conditions, etc. mentioned above.

In the case where the second organic layer is a layer containing a cross-linked form in which one polymer compound of the second organic layer is cross-linked, as for each constitutional unit constituting the one polymer compound of the second organic layer, when value x obtained by multiplying the molar ratio C of the constitutional unit to total mol of all constitutional units constituting the one polymer compound by molecular weight M of the constitutional unit, and value y obtained by multiplying the molar ratio C by number n of the cross-linking group carried by the constitutional unit are determined, the value of $(Y_1 \times 1000) / X_1$ calculated from the summation $X_1$ of the values x and the summation $Y_1$ of the values y is 0.60 or more.

In the case where the second organic layer is a layer containing a cross-linked form in which two or more polymer compounds of the second organic layer are cross-linked, a weighted average of the value of $(Y_1 \times 1000) / X_1$ determined as to each polymer compound of the second organic layer (average value from the mixing amount ratio of two or more polymer compounds of the second organic layer) is 0.60 or more.

In the case where the second organic layer is a layer containing a cross-linked form in which one or more polymer compounds of the second organic layer are cross-linked, and a polymer compound that does not contain the cross-linking constitutional unit having a cross-linking group, a weighted average of the value of $(Y_1 \times 1000) / X_1$ determined as to each polymer compound of the second organic layer and the value of $(Y_1 \times 1000) / X_1$ determined as to each polymer compound that does not contain the cross-linking constitutional unit having a cross-linking group (average value from the mixing amount ratio of one or more polymer compounds of the second organic layer and one or more polymer compounds that do not contain the cross-linking constitutional unit having a cross-linking group) is 0.60 or more.

In the second organic layer, examples of the polymer compound that does not contain the cross-linking constitutional unit having a cross-linking group include a polymer compound comprising at least one constitutional unit selected from the group consisting of a constitutional unit represented by the formula (Y) and a constitutional unit represented by the formula (X).

[Polymer compound of second organic layer]

It is preferable that the polymer compound of the second organic layer should be a polymer compound comprising a cross-linking constitutional unit having at least one cross-linking group selected from the above Group A of cross-linking groups, because the external quantum efficiency of the light-emitting device according to the present embodiment is excellent.

The cross-linking group selected from the above Group A of cross-linking groups is preferably cross-linking groups represented by the formula (XL-1) to the formula (XL-4), the formula (XL-7) to the formula (XL-10) or the formula (XL-14) to the formula (XL-17), more preferably a cross-linking group represented by the formula (XL-1), the formula (XL-3), the formula (XL-9), the formula (XL-10), the formula (XL-16) or the formula (XL-17), further preferably a cross-linking group represented by the formula (XL-1), the formula (XL-16) or the formula (XL-17), particularly preferably a

cross-linking group represented by the formula (XL-1) or the formula (XL-17), especially preferably a cross-linking group represented by the formula (XL-17), because the external quantum efficiency of the light-emitting device according to the present embodiment is better.

The constitutional unit having at least one cross-linking group selected from the Group A of cross-linking groups, contained in the polymer compound of the second organic layer can be a constitutional unit represented by the formula (2) mentioned later, a constitutional unit represented by the formula (2') mentioned later, or a constitutional unit represented by the following formula, and a constitutional unit represented by the formula (2) or a constitutional unit represented by the formula (2') is preferable.

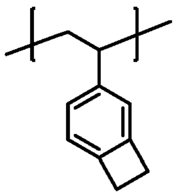

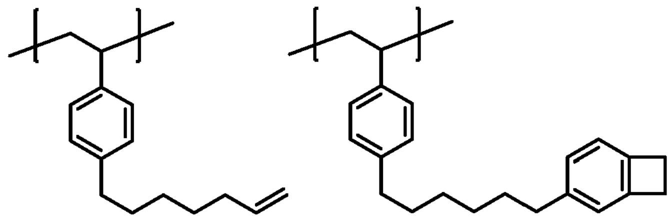

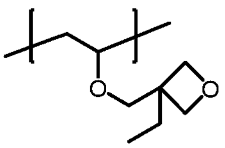

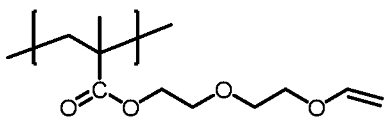

[Constitutional unit represented by formula (2)]

nA represents an integer of 0 to 5 and is preferably an integer of 0 to 3, more preferably an integer of 0 to 2, further preferably 1 or 2, because the external quantum efficiency of the light-emitting device according to the present embodiment is better.

n represents 1 or 2 and is preferably 2 because the external quantum efficiency of the light-emitting device according to the present embodiment is better.

$Ar^3$ represents an aromatic hydrocarbon group or a heterocyclic group and is preferably an aromatic hydrocarbon group optionally having a substituent because the external quantum efficiency of the light-emitting device according to the present embodiment is better.

The number of carbon atoms of the aromatic hydrocarbon group represented by $Ar^3$ is usually 6 to 60, preferably 6 to 30, more preferably 6 to 18, which excludes the number of carbon atoms of a substituent.

The arylene group moiety, excluding n substituent(s), of the aromatic hydrocarbon group represented by $Ar^3$ is preferably groups represented by the formula (A-1) to the formula (A-20), more preferably groups represented by the formula (A-1), the formula (A-2), the formula (A-6) to the formula (A-10), the formula (A-19) or the formula (A-20), further preferably a group represented by the formula (A-1), the formula (A-2), the formula (A-7), the formula (A-9) or the formula (A-19). These groups optionally have a substituent.

The number of carbon atoms of the heterocyclic group represented by $Ar^3$ is usually 2 to 60, preferably 3 to 30, more preferably 4 to 18, which excludes the number of carbon atoms of a substituent.

The divalent heterocyclic group moiety, excluding n substituent(s), of the heterocyclic group represented by $Ar^3$ is preferably groups represented by the formula (AA-1) to the formula (AA-34).

The aromatic hydrocarbon group and the heterocyclic group represented by $Ar^3$ optionally have a substituent and an alkyl group, a cycloalkyl group, an alkoxy group, a cycloalkoxy group, an aryl group, an aryloxy group, a halogen atom, a monovalent heterocyclic group and a cyano group are preferable as the substituent.

$L^A$ represents an alkylene group, a cycloalkylene group, an arylene group, a divalent heterocyclic group, a group represented by -NR'-, an oxygen atom or a sulfur atom, and these groups optionally have a substituent. R' represents a hydrogen atom, an alkyl group, a cycloalkyl group, an aryl group or a monovalent heterocyclic group. The number of carbon atoms of the alkylene group represented by $L^A$ is usually 1 to 20, preferably 1 to 15, more preferably 1 to 10, which excludes the number of carbon atoms of a substituent. The number of carbon atoms of the cycloalkylene group represented by $L^A$ is usually 3 to 20, which excludes the number of carbon atoms of a substituent.

Examples of the alkylene group represented by $L^A$ include a methylene group, an ethylene group, a propylene group, a butylene group, a hexylene group, and an octylene group. The alkylene group represented by $L^A$ optionally has a substituent, and a cycloalkyl group, an alkoxy group, a cycloalkoxy group, a halogen atom and a cyano group are preferable as the substituent. These groups optionally further have a substituent.

Examples of the cycloalkylene group represented by $L^A$ include a cyclopentylene group and a cyclohexylene

group. The cycloalkylene group represented by $L^A$ optionally has a substituent, and an alkyl group, a cycloalkyl group, an alkoxy group, a cycloalkoxy group, a halogen atom and a cyano group are preferable as the substituent. These groups optionally further have a substituent.

The arylene group represented by $L^A$ optionally has a substituent. A phenylene group or a fluorenediyl group is preferable as the arylene group, and a m-phenylene group, a p-phenylene group, a fluorene-2,7-diyl group, or a fluorene-9,9-diyl group is more preferable. An alkyl group, a cycloalkyl group, an alkoxy group, a cycloalkoxy group, an aryl group, an aryloxy group, a monovalent heterocyclic group, a halogen atom, a cyano group or a cross-linking group selected from the above-described Group A of cross-linking group is preferable as the substituent optionally carried by the arylene group. These groups optionally further have a substituent.

The divalent heterocyclic group represented by $L^A$ is preferably groups represented by the formula (AA-1) to the formula (AA-34).

$L^A$ is preferably an arylene group or an alkylene group, more preferably a phenylene group, a fluorenediyl group or an alkylene group because the production of the polymer compound of the second organic layer is easy. These groups optionally have a substituent.

X represents a cross-linking group selected from the above cross-linking group A group. The cross-linking group represented by X is preferably cross-linking groups represented by the formula (XL-1) to the formula (XL-4), the formula (XL-7) to the formula (XL-10) or the formula (XL-14) to the formula (XL-17), more preferably a cross-linking group represented by the formula (XL-1), the formula (XL-3), the formula (XL-9), the formula (XL-10), the formula (XL-16) or the formula (XL-17), further preferably a cross-linking group represented by the formula (XL-1), the formula (XL-16) or the formula (XL-17), particularly preferably a cross-linking group represented by the formula (XL-1) or the formula (XL-17), especially preferably a cross-linking group represented by the formula (XL-17), because the external quantum efficiency of the light-emitting device according to the present embodiment is better.

Only one constitutional unit represented by the formula (2) may be contained in the polymer compound of the second organic layer, or two or more may be contained.

[Constitutional unit represented by formula (2')]

mA represents an integer of 0 to 5 and is preferably an integer of 0 to 3, more preferably an integer of 0 to 2, further preferably 0 or 1, particularly preferably 0, because the external quantum efficiency of the light-emitting device according to the present embodiment is better.

m represents an integer of 1 to 4 and is preferably 1 or 2, more preferably 2, because the external quantum efficiency of the light-emitting device according to the present embodiment is better.

c represents an integer of 0 or 1 and is preferably 0 because the production of the polymer compound of the second organic layer is easy, and the external quantum efficiency of the light-emitting device according to the present embodiment is better.

$Ar^5$ represents an aromatic hydrocarbon group, a heterocyclic group, or a group in which at least one aromatic hydrocarbon ring and at least one heterocyclic ring are directly bonded to each other. $Ar^5$ is preferably an aromatic hydrocarbon group optionally having a substituent because the external quantum efficiency of the light-emitting device according to the present embodiment is better.

A definition and examples of the arylene group moiety, excluding m substituent(s), of the aromatic hydrocarbon group represented by $Ar^5$ are the same as the definition and the examples of the arylene group represented by $Ar^{X2}$ in the formula (X).

A definition and examples of the divalent heterocyclic group moiety, excluding m substituent(s), of the heterocyclic group represented by $Ar^5$ are the same as the definition and the examples of the divalent heterocyclic group moiety represented by $Ar^{X2}$ in the formula (X).

A definition and examples of the divalent group, excluding m substituent(s), of the group in which at least one aromatic hydrocarbon ring and at least one heterocyclic ring are directly bonded to each other, represented by $Ar^5$ are the same as the definition and the examples of the divalent group in which at least one arylene group and at least one divalent heterocyclic group are directly bonded to each other, represented by $Ar^{X2}$ in the formula (X).

$Ar^4$ and $Ar^6$ each independently represent an arylene group or a divalent heterocyclic group and are preferably an arylene group optionally having a substituent because the external quantum efficiency of the light-emitting device according to the present embodiment is better.

A definition and examples of the arylene group represented by $Ar^4$ and $Ar^6$ are the same as the definition and the examples of the arylene group represented by $Ar^{X1}$ and $Ar^{X3}$ in the formula (X).

A definition and examples of the divalent heterocyclic group represented by $Ar^4$ and $Ar^6$ are the same as the definition and the examples of the divalent heterocyclic group represented by $Ar^{X1}$ and $Ar^{X3}$ in the formula (X).

Each of $Ar^4$, $Ar^5$ and $Ar^6$ optionally forms a ring by bonding directly or via an oxygen atom or a sulfur atom to a group, other than the group concerned, bonded to the nitrogen atom to which the group concerned is bonded. The

groups represented by $Ar^4$, $Ar^5$ and $Ar^6$ optionally have a substituent and an alkyl group, a cycloalkyl group, an alkoxy group, a cycloalkoxy group, an aryl group, an aryloxy group, a halogen atom, a monovalent heterocyclic group and a cyano group are preferable as the substituent.

$K^A$ represents an alkylene group, a cycloalkylene group, an arylene group, a divalent heterocyclic group, a group represented by -NR'-, an oxygen atom or a sulfur atom. Definitions and examples of the alkylene group, the cycloalkylene group, the arylene group, and the divalent heterocyclic group represented by $K^A$ are the same as the definitions and the examples of the alkylene group, the cycloalkylene group, the arylene group, and the divalent heterocyclic group represented by $L^A$, respectively.

It is preferable that $K^A$ should be a phenylene group or a methylene group, because the production of the polymer compound of the second organic layer becomes easy.

X' represents a cross-linking group selected from the above Group A of cross-linking group, a hydrogen atom, an alkyl group, a cycloalkyl group, an aryl group or a monovalent heterocyclic group. A definition and examples of the cross-linking group represented by X' are the same as the definition and the examples of the cross-linking group represented by X mentioned above.

Only one constitutional unit represented by the formula (2') may be contained in the polymer compound of the second organic layer, or two or more may be contained.

[Preferable form of constitutional unit represented by formula (2) or (2')]

Examples of the constitutional unit represented by the formula (2) include constitutional units represented by the formula (2-1) to the formula (2-30), and examples of the constitutional unit represented by the formula (2') include constitutional units represented by the formula (2'-1) to the formula (2'-9). Among these, it is preferably constitutional units represented by the formula (2-1) to the formula (2-30), more preferably constitutional units represented by the formula (2-1) to the formula (2-15), the formula (2-19), the formula (2-20), the formula (2-23), the formula (2-25) or the formula (2-30), further preferably constitutional units represented by the formula (2-1) to the formula (2-9), the formula (2-20), the formula (2-22) or the formula (2-30), because the cross-linking properties of the polymer compound of the second organic layer are excellent.

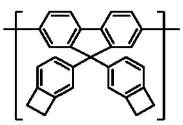
(2-1)
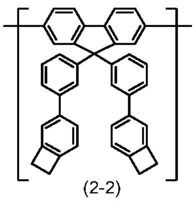
(2-2)
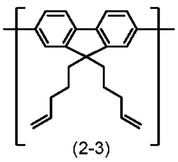
(2-3)
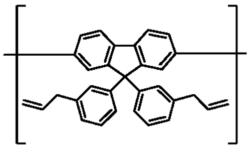
(2-4)
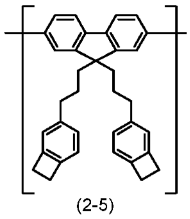
(2-5)

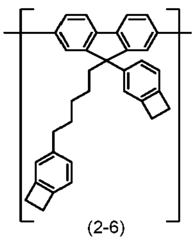
(2-6)
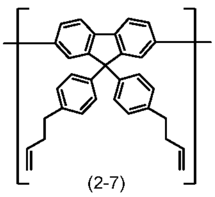
(2-7)
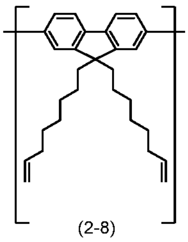
(2-8)
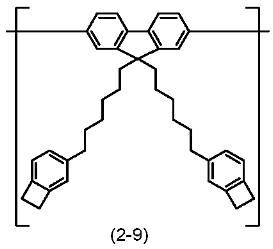
(2-9)
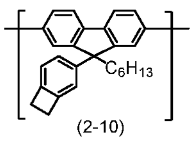
(2-10)

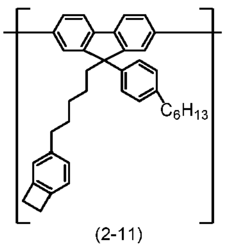
(2-11)
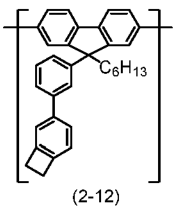
(2-12)
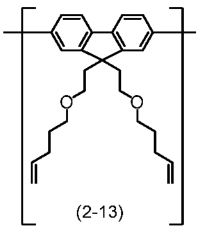
(2-13)
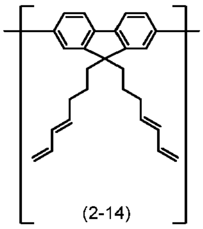
(2-14)
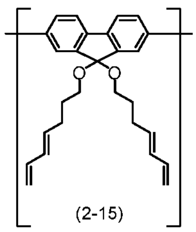
(2-15)

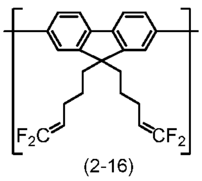
(2-16)

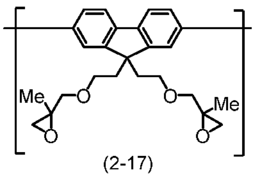
(2-17)

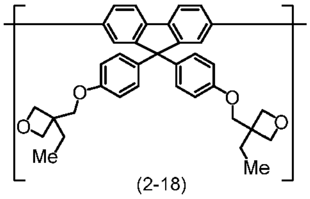
(2-18)

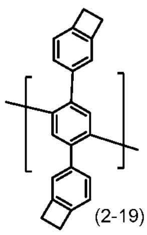
(2-19)

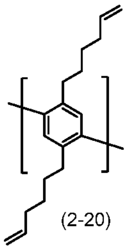
(2-20)

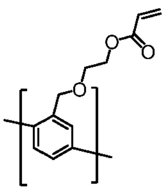
(2-21)

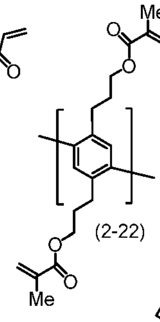
(2-22)

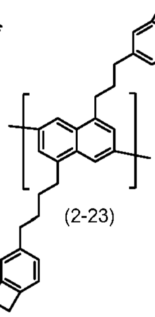
(2-23)

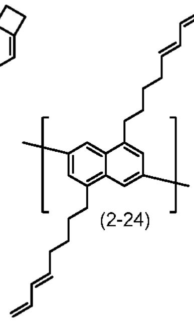
(2-24)

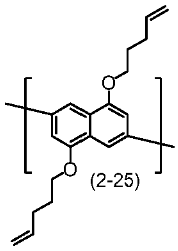
(2-25)

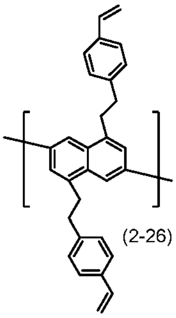
(2-26)

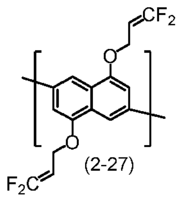
(2-27)

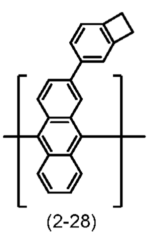
(2-28)

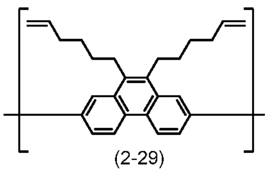
(2-29)

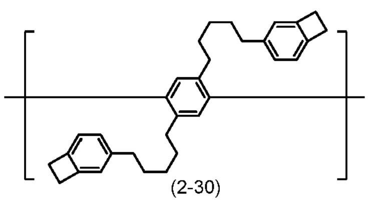
(2-30)

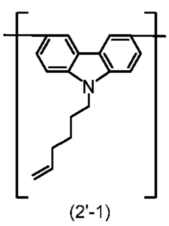
(2'-1)

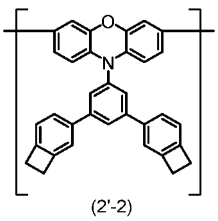
(2'-2)

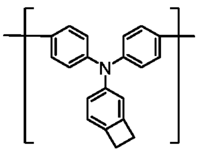
(2'-3)

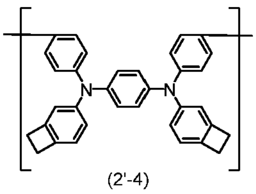
(2'-4)

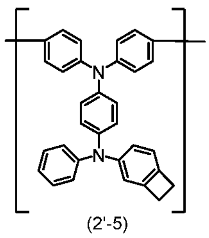
(2'-5)

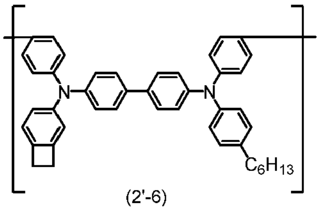
(2'-6)

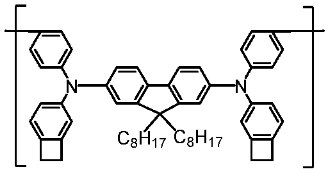
(2'-7)

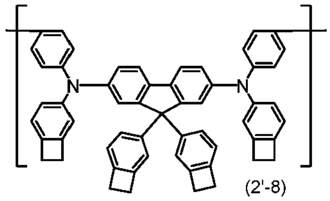
(2'-8)

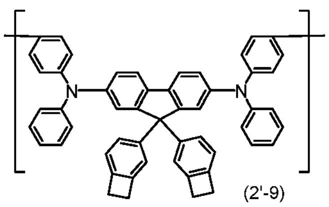
(2'-9)

[Additional constitutional unit]

It is preferable that the polymer compound of the second organic layer should further comprise a constitutional unit represented by the formula (X), because the hole-transporting function is excellent. It is also preferable that the polymer compound of the second organic layer should further comprise a constitutional unit represented by the formula (Y), because the external quantum efficiency of the light-emitting device according to the present embodiment is better.
It is preferable that the polymer compound of the second organic layer should further comprise a constitutional unit represented by the formula (X) and a constitutional unit represented by the formula (Y), because the hole-transporting function is excellent, and the external quantum efficiency of the light-emitting device according to the present embodiment is better.
Definitions, examples and the preferable range of the constitutional unit represented by the formula (X) and the constitutional unit represented by the formula (Y) which may be contained in the polymer compound of the second organic layer are the same as the definitions, the examples and the preferable range of the constitutional unit represented by the formula (X) and the constitutional unit represented by the formula (Y) which may be contained in the polymer host mentioned above, respectively.
In the polymer compound of the second organic layer, each of the constitutional unit represented by the formula (X) and the constitutional unit represented by the formula (Y) may be contained only singly, or two or more may be contained, respectively.
Examples of the polymer compound of the second organic layer include polymer compounds (P-7) to (P-14) shown in Table 2. In this context, "Additional constitutional unit" means a constitutional unit other than the constitutional units represented by the formula (2), the formula (2'), the formula (X) and the formula (Y).

[Table 2]

| Polymer compound | Constitutional unit and molar ratio thereof | | | | |
|---|---|---|---|---|---|
| | Formula (2) | Formula (2') | Formula (X) | Formula (Y) | Additional |
| | p' | q' | r' | s' | t' |
| (P-7) | 0.1-99.9 | 0.1-99.9 | 0 | 0 | 0-30 |
| (P-8) | 0.1-99.9 | 0 | 0.1-99.9 | 0 | 0-30 |
| (P-9) | 0.1-99.9 | 0 | 0 | 0.1-99.9 | 0-30 |
| (P-10) | 0 | 0.1-99.9 | 0.1-99.9 | 0 | 0-30 |
| (P-11) | 0 | 0.1-99.9 | 0 | 0.1-99.9 | 0-30 |
| (P-12) | 0.1-99.8 | 0.1-99.8 | 0.1-99.8 | 0 | 0-30 |
| (P-13) | 0.1-99.8 | 0.1-99.8 | 0 | 0.1-99.8 | 0-30 |
| (P-14) | 0.1-99.7 | 0.1-99.7 | 0.1-99.7 | 0.1-99.7 | 0-30 |

In Table 2, p', q', r', s' and t' represent the molar ratio of each constitutional unit. $p' + q' + r' + s' + t' = 100$, and $70 \leq p' + q' + r' + s' \leq 100$.
In the polymer compounds (P-7) to (P-14), examples and the preferable range of the constitutional units represented by the formula (2), the formula (2'), the formula (X) and the formula (Y) are as mentioned above.
The polymer compound of the second organic layer may be any of a block copolymer, a random copolymer, an alternate copolymer, and a graft copolymer, or may be in other forms, and it is preferable to be a copolymer prepared by copolymerizing a plurality of raw material monomers.
The polystyrene-based number-average molecular weight of the polymer compound of the second organic layer is preferably $5 \times 10^3$ to $1 \times 10^6$, more preferably $1 \times 10^4$ to $5 \times 10^5$, further preferably $1.5 \times 10^4$ to $1 \times 10^5$.
[Method for producing polymer compound of second organic layer]
The polymer compound of the second organic layer can be produced by the same method as the method for producing the polymer host mentioned above.

## [Value of $(Y_1 \times 1000) / X_1$]

The value of $(Y_1 \times 1000) / X_1$ for the polymer compound of the second organic layer can be determined by the

following method.

First, as for each constitutional unit constituting the polymer compound, the value x obtained by multiplying the molar ratio C of the each constitutional unit to total mol of all constitutional units by the molecular weight M of the constitutional unit, and the value y obtained by multiplying the molar ratio C by the number n of the cross-linking group carried by the each constitutional unit are determined. Subsequently, the summation of the value x determined as to the each constitutional unit is defined as $X_1$, and the summation of the value y determined as to the each constitutional unit is defined as $Y_1$.

In this respect, the value of $(Y_1 \times 1000) / X_1$ is a value almost equal to the average number of cross-linking groups per molecular weight 1000 of the polymer compound of the second organic layer, and can be effectively used as an index that indicates the average number of cross-linking groups in the polymer compound of the second organic layer.

A specific method for calculating the average number of cross-linking groups will be described in detail by the value of polymer compound HTL-5 used in Example 1 described below.

The polymer compound HTL-5 has constitutional units derived from a compound M3, a compound M4 and a compound M5. The ratio to the total mol of all constitutional units is 0.45 for the constitutional unit derived from the compound M3, 0.05 for the constitutional unit derived from the compound M4, and 0.50 for the constitutional unit derived from the compound M5. The molecular weight of the constitutional unit derived from the compound M3 is 776.45, the molecular weight of the constitutional unit derived from the compound M4 is 240.20, and the molecular weight of the constitutional unit derived from the compound M5 is 750.51. The number of cross-linking groups carried by the constitutional unit derived from the compound M3 is 2, the number of cross-linking groups carried by the constitutional unit derived from the compound M4 is 2, and the number of cross-linking groups carried by the constitutional unit derived from the compound M5 is 0.

Accordingly, $X_1$ is determined as follows:

$$(0.45 \times 776.45) + (0.05 \times 240.20) + (0.50 \times 750.51) = 736.67$$

$Y_1$ is determined as follows:

$$(0.45 \times 2) + (0.05 \times 2) + (0.50 \times 0) = 1.00$$

Accordingly, the value of $(Y_1 \times 1000) / X_1$ is determined as follows:

$$(1.00 \times 1000) / 736.67 = 1.36$$

In the case of containing two or more polymer compounds, the value of $(Y_1 \times 1000) / X_1$ is determined on the basis of constitutional units constituting the each polymer compound. Also, the value of $(Y_1 \times 1000) / X_1$ is determined as to the each polymer compound, and the value of $(Y_1 \times 1000) / X_1$ is determined from the amount ratios of the each polymer compound.

A specific calculation method will be described about the case of mixing polymer compound HTL-1 and polymer compound HTL-2 of Comparative Example CD3 described below at a ratio of 50:50.

The polymer compound HTL-2 has constitutional units derived from a compound M3, a compound M4, a compound M6 and a compound M5. In the polymer compound HTL-2, the ratio to the total mol of all constitutional units is 0.05 for the constitutional unit derived from the compound M3, 0.05 for the constitutional unit derived from the compound M4, 0.40 for the constitutional unit derived from the compound M6, and 0.05 for the constitutional unit derived from the compound M5. The molecular weight of the constitutional unit derived from the compound M3 is 776.45, the molecular weight of the constitutional unit derived from the compound M4 is 240.20, the molecular weight of the constitutional unit derived from the compound M6 is 244.23, and the molecular weight of the constitutional unit derived from the compound M5 is 750.51. The number of cross-linking groups carried by the constitutional unit derived from the compound M3 is 2, the number of cross-linking groups carried by the constitutional unit derived from the compound M4 is 2, the number of cross-linking groups carried by the monomer derived from the compound M6 is 0, and the number of cross-linking groups carried by the constitutional unit derived from the compound M5 is 0. Accordingly, the value of $(Y_1 \times 1000) / X_1$ calculated by the method mentioned above as to the polymer compound HTL-2 is 0.38.

The polymer compound HTL-1 has constitutional units derived from the compound M6 and the compound M5. In the polymer compound HTL-1, the ratios to the total mol of all constitutional units are 0.50 for the constitutional unit derived from the compound M6 and 0.50 for the constitutional unit derived from the compound M5. The molecular weight

of the constitutional unit derived from the compound M6 is 244.23, and the molecular weight of the constitutional unit derived from the compound M5 is 750.51. The number of cross-linking groups carried by the constitutional unit derived from the compound M6 is 0, and the number of cross-linking groups carried by the constitutional unit derived from the compound M5 is 0. Accordingly, the value of $(Y_1 \times 1000) / X_1$ calculated by the method mentioned above as to the polymer compound HTL-1 is 0.

In Comparative Example CD3, the polymer compound HTL-2 and the polymer compound HTL-1 are mixed at a ratio of 50:50. Accordingly, in Comparative Example CD3, the value of $(Y_1 \times 1000) / X_1$ can be determined as 0.19 according to the following expression:

$$0.38 \times 0.5 + 0 \times 0.5 = 0.19$$

The values of $(Y_1 \times 1000) / X_1$ of the polymer compound (PO-1) described in Patent Literature 1 and the polymer compound (P0-2) described in Patent Literature 2 mentioned above are calculated as 0.57 and 0, respectively.

In the present embodiment, the value of $(Y_1 \times 1000) / X_1$ is preferably 0.69 or more, more preferably 0.85 or more, further preferably 0.95 or more, particularly preferably 1.10 or more, especially preferably 1.20 or more, because the external quantum efficiency of the light-emitting device according to the present embodiment is better. As the value of $(Y_1 \times 1000) / X_1$ increases, the second organic layer becomes a closely packed film and the charge-transporting function of the second organic layer and/or charge injection from the second organic layer to the first organic layer is considered to be improved.

In the present embodiment, the value of $(Y_1 \times 1000) / X_1$ is usually 5.0 or less, preferably 4.0 or less, more preferably 3.0 or less, further preferably 2.0 or less, particularly preferably 1.50 or less. By setting the value of $(Y_1 \times 1000) / X_1$ to this range, the effects that a flat film is obtained easily and the luminance lifetime of the light-emitting device is more improved are exerted.

In the present embodiment, the value of $(Y_1 \times 1000) / X_1$ is preferably 0.85 or more and 4.0 or less, more preferably 0.95 or more and 3.0 or less, further preferably 1.10 or more and 2.0 or less, particularly preferably 1.20 or more and 1.50 or less, because the external quantum efficiency of the light-emitting device according to the present embodiment is better, and the luminance lifetime of the light-emitting device according to the present embodiment is more improved.

[Second composition]

The second organic layer may be a layer containing a composition comprising the cross-linked form of the polymer compound of the second organic layer and at least one material selected from the group consisting of a hole-transporting material, a hole-injecting material, an electron-transporting material, an electron-injecting material, an antioxidant, and a light-emitting material (hereinafter, also referred to as a "second composition").

Examples and the preferable range of the hole-transporting material, the electron-transporting material, the hole-injecting material, the electron-injecting material and the light-emitting material contained in the second composition are the same as the examples and the preferable ranges of the hole-transporting material, the electron-transporting material, the hole-injecting material, the electron-injecting material and the light-emitting material contained in the first composition.

In the second composition, each of the amounts of the hole-transporting material, the electron-transporting material, the hole-injecting material, the electron-injecting material and the light-emitting material is usually 1 to 400 parts by mass, preferably 5 to 150 parts by mass, with respect to 100 parts by mass of the cross-linked form of the polymer compound of the second organic layer.

Examples and the preferable range of the antioxidant contained in the second composition are the same as the examples and the preferable range of the antioxidant contained in the first composition. In the second composition, the amount of the antioxidant is usually 0.001 to 10 parts by mass with respect to 100 parts by mass of the cross-linked form of the polymer compound of the second organic layer.

[Second ink]

The second composition containing the polymer compound of the second organic layer and a solvent can be used as the second ink for forming the second organic layer. The second ink can be suitably used in the wet method described in the section of the first ink. The preferable range of the viscosity of the second ink is the same as the preferable range of the viscosity of the first ink. Examples and the preferable range of the solvent contained in the second ink are the same as the examples and the preferable range of the solvent contained in the first ink.

In the second ink, the amount of the solvent is usually 1000 to 100000 parts by mass, preferably 2000 to 20000

parts by mass, with respect to 100 parts by mass of the polymer compound of the second organic layer.

<Layer configuration of light-emitting device>

The light-emitting device according to the present embodiment has: an anode; a cathode; a first organic layer disposed between the anode and the cathode; and a second organic layer disposed, adjacently to the first organic layer, between the anode and the cathode. The light-emitting device according to the present embodiment may comprise a layer other than the anode, the cathode, the first organic layer and the second organic layer.

In the light-emitting device according to the present embodiment, the first organic layer is usually a light-emitting layer (hereinafter, also referred to as a "first light-emitting layer").

In the light-emitting device according to the present embodiment, the second organic layer is usually a hole-transporting layer, a light-emitting layer (hereinafter, also referred to as a "second light-emitting layer") or an electron-transporting layer, preferably a hole-transporting layer or the second light-emitting layer, more preferably a hole-transporting layer.

In the light-emitting device according to the present embodiment, it is preferable that the second organic layer should be a layer disposed between the anode and the first organic layer, it is more preferable to be a hole-transporting layer or the second light-emitting layer disposed between the anode and the first organic layer, and it is further preferable to be a hole-transporting layer disposed between the anode and the first organic layer, because the external quantum efficiency of the light-emitting device is better.

In the light-emitting device according to the present embodiment, in the case where the second organic layer is a hole-transporting layer disposed between the anode and the first organic layer, it is preferable to further comprise a hole-injecting layer between the anode and the second organic layer, because the external quantum efficiency of the light-emitting device is better. Also, in the case where the second organic layer is a hole-transporting layer disposed between the anode and the first organic layer, it is preferable to further comprise at least one layer selected from the group of an electron-injecting layer and an electron-transporting layer between the cathode and the first organic layer, because the external quantum efficiency of the light-emitting device is better.

In the light-emitting device according to the present embodiment, in the case where the second organic layer is the second light-emitting layer disposed between the anode and the first organic layer, it is preferable to further comprise at least one layer selected from the group of a hole-injecting layer and a hole-transporting layer between the anode and the second organic layer, because the external quantum efficiency of the light-emitting device is better. Also, in the case where the second organic layer is the second light-emitting layer disposed between the anode and the first organic layer, it is preferable to further comprise at least one layer selected from the group of an electron-injecting layer and an electron-transporting layer between the cathode and the first organic layer, because the external quantum efficiency of the light-emitting device is better.

In the light-emitting device according to the present embodiment, in the case where the second organic layer is the second light-emitting layer disposed between the cathode and the first organic layer, it is preferable to further comprise at least one layer selected from the group of a hole-injecting layer and a hole-transporting layer between the anode and the first organic layer, because the external quantum efficiency of the light-emitting device is better. Also, in the case where the second organic layer is the second light-emitting layer disposed between the cathode and the first organic layer, it is preferable to further comprise at least one layer selected from the group of an electron-injecting layer and an electron-transporting layer between the cathode and the second organic layer, because the external quantum efficiency of the light-emitting device is better.

In the light-emitting device according to the present embodiment, in the case where the second organic layer is an electron-transporting layer disposed between the cathode and the first organic layer, it is preferable to further comprise at least one layer selected from the group of a hole-injecting layer and a hole-transporting layer between the anode and the first organic layer, because the external quantum efficiency of the light-emitting device is better. Also, in the case where the second organic layer is an electron-transporting layer disposed between the cathode and the first organic layer, it is preferable to further have an electron-injecting layer between the cathode and the second organic layer, because the external quantum efficiency of the light-emitting device is better.

Specific examples of the layer configuration of the light-emitting device according to the present embodiment include layer configurations represented by (D1) to (D14) described below. The light-emitting device usually comprises a substrate and the anode may be laminated on the substrate or the cathode may be laminated on the substrate.

(D1) Anode/second light-emitting layer (second organic layer)/first light-emitting layer (first organic layer)/cathode
(D2) Anode/hole-transporting layer (second organic layer)/first light-emitting layer (first organic layer)/cathode
(D3) Anode/hole-injecting layer/second light-emitting layer (second organic layer)/first light-emitting layer (first organic layer)/cathode
(D4) Anode/hole-injecting layer/second light-emitting layer (second organic layer)/first light-emitting layer (first organic layer)/electron-transporting layer/cathode
(D5) Anode/hole-injecting layer/second light-emitting layer (second organic layer)/first light-emitting layer (first organic layer)/electron-injecting layer/cathode
(D6) Anode/hole-injecting layer/second light-emitting layer (second organic layer)/first light-emitting layer (first organic layer)/electron-transporting layer/electron-injecting layer/cathode
(D7) Anode/hole-injecting layer/hole-transporting layer (second organic layer)/first light-emitting layer (first organic layer)/cathode
(D8) Anode/hole-injecting layer/hole-transporting layer (second organic layer)/first light-emitting layer (first organic layer)/electron-transporting layer/cathode
(D9) Anode/hole-injecting layer/hole-transporting layer (second organic layer)/first light-emitting layer (first organic layer)/electron-injecting layer/cathode
(D10) Anode/hole-injecting layer/hole-transporting layer (second organic layer)/first light-emitting layer (first organic layer)/electron-transporting layer/electron-injecting layer/cathode
(D11) Anode/hole-injecting layer/hole-transporting layer/second light-emitting layer (second organic layer)/first light-emitting layer (first organic layer)/electron-transporting layer/electron-injecting layer/cathode
(D12) Anode/hole-injecting layer/hole-transporting layer (second organic layer)/first light-emitting layer (first organic layer)/second light-emitting layer/electron-transporting layer/electron-injecting layer/cathode
(D13) Anode/hole-injecting layer/hole-transporting layer/first light-emitting layer (first organic layer)/second light-emitting layer (second organic layer)/electron-transporting layer/electron-injecting layer/cathode
(D14) Anode/hole-injecting layer/hole-transporting layer/first light-emitting layer (first organic layer)/electron-transporting layer (second organic layer)/electron-injecting layer/cathode

In the above (D1) to (D14), "/" means that layers before and after it are adjacently laminated. Specifically, "second light-emitting layer (second organic layer)/first light-emitting layer (first organic layer)" means that the second light-emitting layer (second organic layer) and the first light-emitting layer (first organic layer) are adjacently laminated.
The layer configurations represented by (D3) to (D12) are preferable, and the layer configurations represented by (D7) to (D10) are more preferable, because the external quantum efficiency of the light-emitting device according to the present embodiment is better.
In the light-emitting device according to the present embodiment, two or more of each of the anode, the hole-injecting layer, the hole-transporting layer, the second light-emitting layer, the electron-transporting layer, the electron-injecting layer and the cathode may be provided, if necessary.
In the case where pluralities of anodes, hole-injecting layers, hole-transporting layers, second light-emitting layers, electron-transporting layers, electron-injecting layers and cathodes are present, they are the same or different, respectively.
The thickness of each of the anode, the hole-injecting layer, the hole-transporting layer, the first light-emitting layer, the second light-emitting layer, the electron-transporting layer, the electron-injecting layer and the cathode are usually 1 nm to 1 $\mu$m, preferably 2 nm to 500 nm, further preferably 5 nm to 150 nm.
In the light-emitting device according to the present embodiment, the order, number, and thickness of layers to be laminated can be advantageously adjusted in views of the external quantum efficiency and device lifetime of the light-emitting device.

[Second light-emitting layer]

The second light-emitting layer is usually the second organic layer or a layer containing a light-emitting material. In the case where the second light-emitting layer is a layer containing a light-emitting material, examples of the light-emitting material contained in the second light-emitting layer include the light-emitting material which may be contained in the first composition mentioned above. In the second light-emitting layer, one light-emitting material may be contained singly, or two or more may be contained.
In the case where the light-emitting device according to the present embodiment comprises the second light-emitting layer, and neither a hole-transporting layer mentioned later nor an electron-transporting layer mentioned later is the second organic layer, it is preferable that the second light-emitting layer should be the second organic layer.

[Hole-transporting layer]

The hole-transporting layer is usually the second organic layer or a layer containing a hole-transporting material. In the case where the hole-transporting layer is a layer containing a hole-transporting material, examples of the hole-transporting material include the hole-transporting material which may be contained in the first composition mentioned above. In the hole-transporting layer, one hole-transporting material may be contained singly, or two or more may be

contained.

In the case where the light-emitting device according to the present embodiment comprises a hole-transporting layer, and neither the second light-emitting layer mentioned above nor an electron-transporting layer mentioned later is the second organic layer, it is preferable that the hole-transporting layer should be the second organic layer.

[Electron-transporting layer]

The electron-transporting layer is usually the second organic layer or a layer containing an electron-transporting material, preferably a layer containing an electron-transporting material. In the case where the electron-transporting layer is a layer containing an electron-transporting material, examples of the electron-transporting material contained in the electron-transporting layer include the electron-transporting material which may be contained in the first composition mentioned above. In the electron-transporting layer, one electron-transporting material may be contained singly, or two or more may be contained.

[Hole-injecting layer and electron-injecting layer]

The hole-injecting layer is a layer containing a hole-injecting material. Examples of the hole-injecting material contained in the hole-injecting layer include the hole-injecting material which may be contained in the first composition mentioned above. In the hole-injecting layer, the hole-injecting material may be contained singly, or two or more may be contained.

The electron-injecting layer is a layer containing an electron-injecting material. Examples of the electron-injecting material contained in the electron-injecting layer include the electron-injecting material which may be contained in the first composition mentioned above. In the electron-injecting layer, the electron-injecting material may be contained singly, or two or more may be contained.

[Substrate/electrode]

The substrate in the light-emitting device can form an electrode, and can be a substrate that does not chemically change in forming the organic layers, for example, a substrate made of a material such as glass, plastic, or silicon. In the case of using an opaque substrate, it is preferable that an electrode most distant from the substrate should be transparent or semitransparent.

Examples of the material of the anode include conductive metal oxides and semitransparent metals, preferably indium oxide, zinc oxide, and tin oxide; conductive compounds such as indium tin oxide (ITO) and indium zinc oxide; a composite of silver, palladium, and copper (APC); and NESA, gold, platinum, silver, and copper.

Examples of the material of the cathode include: metals such as lithium, sodium, potassium, rubidium, cesium, beryllium, magnesium, calcium, strontium, barium, aluminum, zinc, and indium; alloys composed of two or more of them; alloys composed of one or more of them and at least one selected from the group of silver, copper, manganese, titanium, cobalt, nickel, tungsten, and tin; and graphite and graphite intercalation compounds. Examples of the alloys include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

In the light-emitting device according to the present embodiment, at least one of the anode and the cathode is usually transparent or semitransparent, and it is preferable that the anode should be transparent or semitransparent.

Examples of methods for forming the anode and the cathode include a vacuum deposition method, a sputtering method, an ion plating method, a plating method and a lamination method.

[Method for producing light-emitting device]

In the light-emitting device according to the present embodiment, examples of a method for forming each layer such as the first light-emitting layer, the second light-emitting layer, the hole-transporting layer, the electron-transporting layer, the hole-injecting layer, or the electron-injecting layer include a vacuum deposition method from a powder and a method by film formation from a solution or a melted state in the case of using a low-molecular compound, and include a method by film formation from a solution or a melted state in the case of using a polymer compound.

The first light-emitting layer, the second light-emitting layer, the hole-transporting layer, the electron-transporting layer, the hole-injecting layer and the electron-injecting layer can be formed by a wet method such as a spin coating method or an inkjet printing method using the first ink, the second ink, and inks respectively containing the light-emitting material, the hole-transporting material, the electron-transporting material, the hole-injecting material and the electron-injecting material mentioned above.

[Purpose of light-emitting device]

In order to obtain planar light emission using the light-emitting device, a planar anode and cathode can be arranged so as to overlap. In order to obtain patterned light emission, there is a method of establishing a mask provided with a patterned window on the surface of a planar light-emitting device, a method of forming a layer desired to be a non-light-emitting part as an exceedingly thick film to render the layer substantially non-light-emitting, or a method of forming an anode or a cathode, or both the electrodes in a patterned form. A segment-type display device that can display numbers, characters, etc. is obtained by forming a pattern by any of these methods and arranging some electrodes so as to switch ON and OFF independently. In order to prepare a dot matrix display device, the anode and the cathode can both be formed in a stripe state and orthogonally arranged. Partial color display or multicolor display are made possible by a method of distinctively applying a plurality of kinds of polymer compounds differing in emitted light color, or a method using a color filter or a fluorescence conversion filter. The dot matrix display device may be passively driven and may be actively driven in combination with TFT or the like. These display devices can be used in display screens of computers, televisions, portable terminals, etc. The planar light-emitting device can be suitably used as a planar light source for a backlight of a liquid-crystal display device, or a planar light source for illumination. It can also be used as a curved light source and display device as long as a flexible substrate is used.

## Examples

Although the present invention will be described below in more detail with reference to Examples, the present invention is not limited by these Examples.

In Examples, the polystyrene-equivalent number average molecular weight (Mn) and the polystyrene-equivalent weight average molecular weight (Mw) of a polymer compound were determined by size exclusion chromatography (SEC) (manufactured by Shimadzu Corp., trade name: LC-10Avp). The measurement conditions of SEC are as follows.

[Measurement conditions]

The polymer compound to be measured was dissolved in tetrahydrofuran (THF) at a concentration of approximately 0.05% by mass, and 10 μL was injected into SEC. THF was used as a mobile phase of SEC and injected at a flow rate of 2.0 mL/min. PLgel MIXED-B (manufactured by Polymer Laboratories Ltd.) was used as a column. A UV-VIS detector (manufactured by Shimadzu Corp., trade name: SPD-10Avp) was used as a detector.

In the present Examples, the maximum peak wavelength of an emission spectrum of a compound was measured at room temperature with a spectrophotometer (manufactured by JASCO Corp., trade name: FP-6500). A toluene solution in which the compound was dissolved at a concentration of approximately $0.8 \times 10^{-4}$% by mass in xylene was used as a sample. UV light with a wavelength of 325 nm was used as excitation light.

<Compounds EM-1 to EM-7, compound EM-A1 and compound EM-A2>

Compound EM-1 was synthesized according to the method described in International Publication No. WO 2008/059713.

Compound EM-2 was synthesized according to the method described in Japanese Unexamined Patent Publication No. 2006-176491.

Compound EM-3 was synthesized according to the method described in International Publication No. WO 2005/033051.

Compound EM-4 and compound EM-5 were purchased from Tokyo Chemical Industry Co., Ltd.

Compound EM-6 was synthesized according to the method described in International Publication No. WO 2010/013006.

Compound EM-7 was purchased from Sigma-Aldrich Co. LLC.

Compound EM-A1 was synthesized according to the method described in Japanese Unexamined Patent Publication No. 2011-105643.

Compound EM-A2 was synthesized according to the method described in International Publication No. WO 2007/058368.

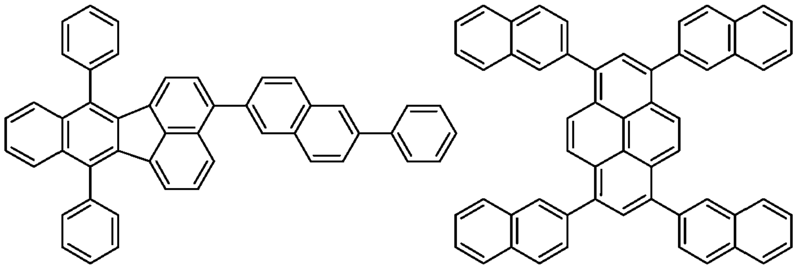

**Compound EM-1** **Compound EM-2**

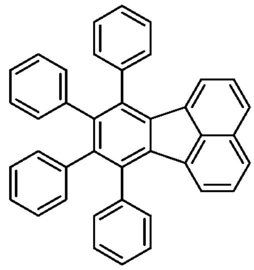

**Compound EM-3**

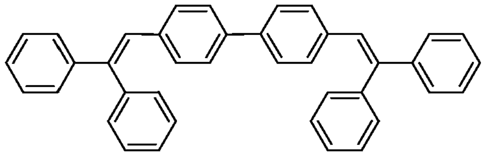

**Compound EM-4**

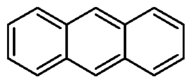

**Compound EM-5**

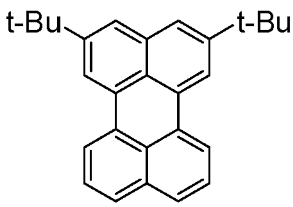

**Compound EM-6**

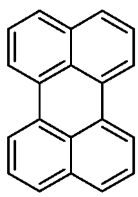

**Compound EM-7**

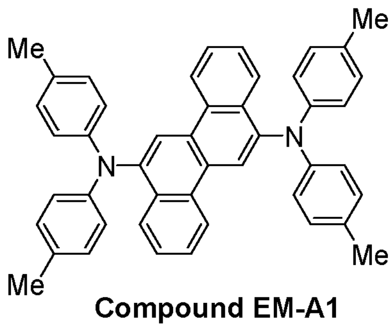

**Compound EM-A1**

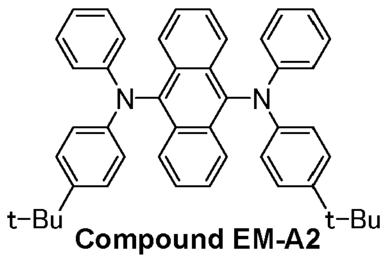

**Compound EM-A2**

The maximum peak wavelength of an emission spectrum of compound EM-1 was 441 nm.

The maximum peak wavelength of an emission spectrum of compound EM-2 was 446 nm.

The maximum peak wavelength of an emission spectrum of compound EM-3 was 453 nm.

The maximum peak wavelength of an emission spectrum of compound EM-4 was 446 nm.

The maximum peak wavelength of an emission spectrum of compound EM-5 was 404 nm.

The maximum peak wavelength of an emission spectrum of compound EM-6 was 453 nm.

The maximum peak wavelength of an emission spectrum of compound EM-7 was 448 nm.

The maximum peak wavelength of an emission spectrum of compound EM-A1 was 454 nm.

The maximum peak wavelength of an emission spectrum of compound EM-A2 was 521 nm.

<Compounds HM-1 and HM-2>

Compound HM-1 was purchased from AK Scientific, Inc.

Compound HM-2 was synthesized according to the method described in Japanese Unexamined Patent Publication No. 2011-100942 and International Publication No. WO 2011/137922.

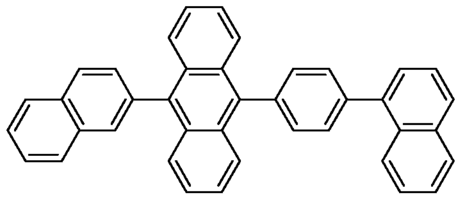

Compound HM-1

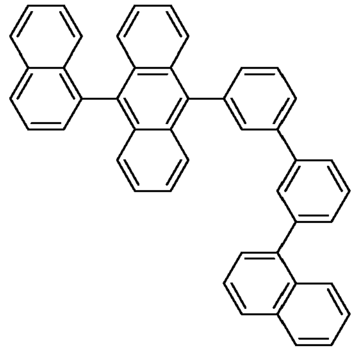

Compound HM-2

The maximum peak wavelength of an emission spectrum of compound HM-1 was 425 nm.

The maximum peak wavelength of an emission spectrum of compound HM-2 was 430 nm.

<Compounds M1 to M6>

Compound M1 was synthesized according to the method described in Japanese Unexamined Patent Publication No. 2012-144721.

Compound M2 employed a commercially available product.

Compound M3 was synthesized according to the method described in International Publication No. WO 2015/145871.

Compound M4 was synthesized according to the method described in International Publication No. WO 2013/146806.

Compound M5 was synthesized according to the method described in International Publication No. WO 2005/049546.

Compound M6 was synthesized according to the method described in Japanese Unexamined Patent Publication No. 2010-189630.

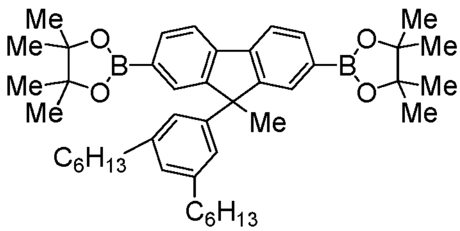

Compound M1

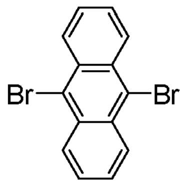

Compound M2

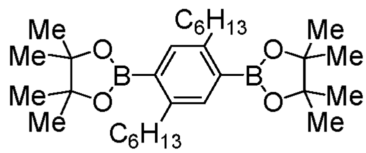

Compound M6

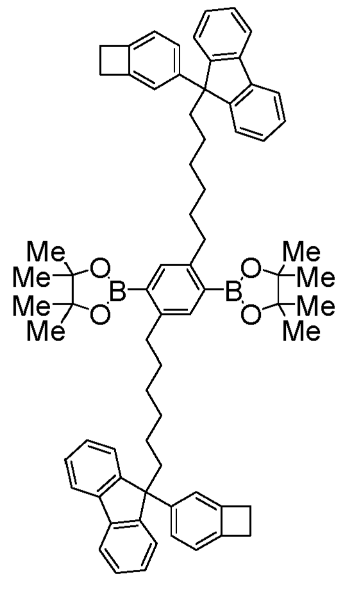

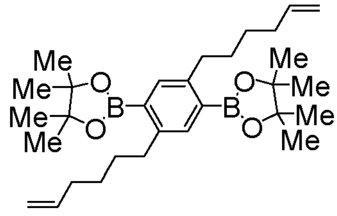

Compound M4

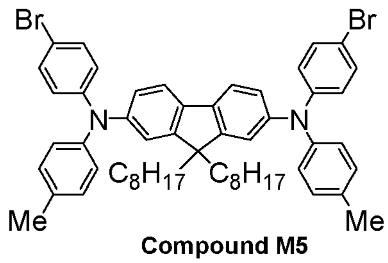

Compound M5

Compound M3

<Synthesis Example HP1> Synthesis of polymer compound HP-1

(Step 1) After an inert gas atmosphere was created within a reaction container, compound M1 (1.73 g), compound M2 (0.843 g), dichlorobis[tris(2-methoxyphenyl)phosphine]palladium (2.2 mg) and toluene (40 ml) were added and heated to 105°C.

(Step 2) An aqueous solution containing 20% by mass of tetraethylammonium hydroxide (8.7 g) was added dropwise to the obtained reaction solution and refluxed for 3 hours.

(Step 3) Then, 9-bromoanthracene (64.1 mg), an aqueous solution containing 20% by mass of tetraethylammonium hydroxide (8.8 g) and dichlorobis[tris(2-methoxyphenyl)phosphine]palladium (2.2 mg) were added thereto and refluxed for 16 hours.

(Step 4) Then, an aqueous sodium diethyldithiacarbamate solution was added thereto and stirred at 80°C for 2 hours. The obtained reaction solution was cooled and then washed twice with water, twice with an aqueous solution containing 3% by mass of acetic acid and twice with water, and as a result of adding the obtained solution dropwise to methanol, precipitates were formed. The precipitates were dissolved in toluene and purified by passing the solution through an alumina column and a silica gel column in order. The obtained solution was added dropwise to methanol, and as a result of stirring, precipitates were formed. The precipitates were collected by filtration and dried to thereby obtain 0.91 g of polymer compound HP-1. Mn of the polymer compound HP-1 was $1.2 \times 10^5$, and Mw was $4.8 \times 10^5$.

The polymer compound HP-1 is a copolymer in which a constitutional unit derived from compound M1 and a constitutional unit derived from compound M2 are constituted at a molar ratio of 50:50, in terms of a theoretical value determined from the amounts of the added raw materials.

<Synthesis Example HTL1> Synthesis of polymer compound HTL-1

Polymer compound HTL-1 was synthesized according to the method described in International Publication No. WO 2015/194448 using compound M5 and compound M6.

Mn of the polymer compound HTL-1 was $4.5 \times 10^4$, and Mw was $1.5 \times 10^5$.

The polymer compound HTL-1 is a copolymer in which a constitutional unit derived from compound M5 and a constitutional unit derived from compound M6 are constituted at a molar ratio of 50:50, in terms of a theoretical value determined from the contents of the added raw materials. As for the polymer compound HTL-1, the value of $(Y_1 \times 1000) / X_1$ was calculated by the method mentioned above and was consequently 0.

<Synthesis Example HTL2> Synthesis of polymer compound HTL-2

(Step 1) After an inert gas atmosphere was created within a reaction container, compound M3 (0.130 g), compound M4 (0.0620 g), compound M6 (0.493 g), compound M5 (1.15 g), dichlorobis(tris-o-methoxyphenylphosphine)palladium (2.2 mg) and toluene (30 mL) were added and heated to 105°C.

(Step 2), An aqueous solution containing 20% by mass of tetraethylammonium hydroxide (8.3 mL) was added dropwise to the reaction solution and refluxed for 6 hours.

(Step 3) Then, phenylboronic acid (61.0 mg) and dichlorobis(tris-o-methoxyphenylphosphine)palladium (1.1 mg) were added thereto and refluxed for 14.5 hours.

(Step 4) Then, an aqueous sodium diethyldithiacarbamate solution was added thereto and stirred at 80°C for 2 hours. After cooling, the obtained reaction solution was washed twice with water, twice with an aqueous solution containing 3% by mass of acetic acid and twice with water, and as a result of adding the obtained solution dropwise to methanol, precipitates were formed. The obtained precipitates were dissolved in toluene and purified by passing the solution through an alumina column and a silica gel column in order. The obtained solution was added dropwise to methanol and stirred, and then, the obtained precipitates were collected by filtration and dried to thereby obtain 1.05 g of polymer compound HTL-2.

Mn of the polymer compound HTL-2 was $2.4 \times 10^4$, and Mw was $1.8 \times 10^5$.

The polymer compound HTL-2 is a copolymer in which a constitutional unit derived from compound M3, a constitutional unit derived from compound M4, a constitutional unit derived from compound M6, and a constitutional unit derived from compound M5 are constituted at a molar ratio of 5:5:40:50, in terms of a theoretical value determined from the contents of the added raw materials. As for the polymer compound HTL-2, the value of $(Y_1 \times 1000) / X_1$ was calculated by the method mentioned above and was consequently 0.38.

<Synthesis Example HTL3> Synthesis of polymer compound HTL-3

0.92 g of polymer compound HTL-3 was obtained by the same method as in the above synthesis of the polymer compound HTL-2 except that: (Step 1) in the synthesis of the polymer compound HTL-2 was changed to (Step 1-1) described below; (Step 2) was changed to (Step 2-1) described below; and (Step 3) was changed to (Step 3-1) described below.

(Step 1-1) After an inert gas atmosphere was created within a reaction container, compound M3 (0.311 g), compound M4 (0.0496 g), compound M6 (0.295 g), compound M5 (0.917 g), dichlorobis(tris-o-methoxyphenylphosphine)palladium (1.76 mg) and toluene (30 mL) were added and heated to 105°C.

(Step 2-1) An aqueous solution containing 20% by mass of tetraethylammonium hydroxide (6.7 mL) was added dropwise to the reaction solution and refluxed for 6 hours.

(Step 3-1) Then, phenylboronic acid (48.8 mg) and dichlorobis(tris-o-methoxyphenylphosphine)palladium (0.88 mg) were added thereto and refluxed for 14.5 hours.

Mn of the polymer compound HTL-3 was $2.5 \times 10^4$, and Mw was $1.3 \times 10^5$.

The polymer compound HTL-3 is a copolymer in which a constitutional unit derived from compound M3, a constitutional unit derived from compound M4, a constitutional unit derived from compound M6, and a constitutional unit derived from compound M5 are constituted at a molar ratio of 15:5:30:50, in terms of a theoretical value determined from the contents of the added raw materials. As for the polymer compound HTL-3, the value of $(Y_1 \times 1000) / X_1$ was calculated by the method mentioned above and was consequently 0.69.

<Synthesis Example HTL4> Synthesis of polymer compound HTL-4

0.92 g of polymer compound HTL-4 was obtained by the same method as in the above synthesis of the polymer compound HTL-3 except that (Step 1-1) in the synthesis of the polymer compound HTL-3 was changed to (Step 1-2) described below.

(Step 1-2) After an inert gas atmosphere was created within a reaction container, compound M3 (0.518 g), compound M4 (0.0496 g), compound M6 (0.195 g), compound M5 (0.917 g), dichlorobis(tris-o-methoxyphenylphosphine)palladium (1.76 mg) and toluene (30 mL) were added and heated to 105°C.

Mn of the polymer compound HTL-4 was $2.5 \times 10^4$, and Mw was $3.0 \times 10^5$.

The polymer compound HTL-4 is a copolymer in which a constitutional unit derived from compound M3, a constitutional unit derived from compound M4, a constitutional unit derived from compound M6, and a constitutional unit derived from compound M5 are constituted at a molar ratio of 25:5:20:50, in terms of a theoretical value determined from the contents of the added raw materials. As for the polymer compound HTL-4, the value of $(Y_1 \times 1000) / X_1$ was calculated by the method mentioned above and was consequently 0.95.

<Synthesis Example HTL5> Synthesis of polymer compound HTL-5

Polymer compound HTL-5 was synthesized according to the method described in International Publication No. WO 2015/145871 using compound M3, compound M4 and compound M5.

Mn of the polymer compound HTL-5 was $2.3 \times 10^4$, and Mw was $1.2 \times 10^5$.

The polymer compound HTL-5 is a copolymer in which a constitutional unit derived from compound M3, a constitutional unit derived from compound M4, and a constitutional unit derived from compound M5 are constituted at a molar ratio of 45:5:50, in terms of a theoretical value determined from the contents of the added raw materials. As for the polymer compound HTL-5, the value of $(Y_1 \times 1000) / X_1$ was calculated by the method mentioned above and was consequently 1.36.

<Example D1> Preparation and evaluation of light-emitting device D1

(Formation of anode and hole-injecting layer)

An ITO film was attached at a thickness of 45 nm to a glass substrate by the sputtering method to thereby form an anode. A film of a hole-injecting material ND-3202 (manufactured by Nissan Chemical Industries, Ltd.) was formed at a thickness of 35 nm on the anode by the spin coating method. In an air atmosphere, a hole-injecting layer was formed by heating at 50°C for 3 minutes and further heating at 230°C for 15 minutes.

(Formation of second organic layer)

Polymer compound HTL-5 was dissolved at a concentration of 0.6% by mass in xylene. A film was formed at a thickness of 20 nm on the hole-injecting layer by the spin coating method using the obtained xylene solution, and in a nitrogen gas atmosphere, a second organic layer was formed by heating at 180°C for 60 minutes on a hot plate. The polymer compound HTL-5 became a cross-linked form by this heating.

(Formation of first organic layer)

Compound HM-1 and compound EM-A1 (compound HM-1/compound EM-A1 = 91.5% by mass/8.5% by mass) were dissolved at a concentration of 2% by mass in toluene. A film was formed at a thickness of 60 nm on the second organic layer by the spin coating method using the obtained toluene solution, and in a nitrogen gas atmosphere, a first organic layer was formed by heating at 150°C for 10 minutes on a hot plate.

(Formation of cathode)

The substrate with the first organic layer formed was placed in a vapor deposition machine, and after pressure reduction to $1 \times 10^{-4}$ Pa or lower, sodium fluoride as a cathode was deposited at approximately 4 nm on the first organic layer, and subsequently, aluminum was deposited at approximately 80 nm on the sodium fluoride layer. After the deposition, the resultant was sealed using a glass substrate to thereby prepare light-emitting device D1.

(Evaluation of light-emitting device)

EL emission was observed by applying voltage to the light-emitting device D1. The external quantum efficiency at 200 cd/$m^2$ was 2.99%, and the CIE chromaticity coordinate (x,y) was (0.14,0.18).

<Example D2> Preparation and evaluation of light-emitting device D2

Light-emitting device D2 was prepared in the same way as in Example D1 except that polymer compound HTL-4 was used instead of the polymer compound HTL-5 in Example D1.

(Evaluation of light-emitting device)

EL emission was observed by applying voltage to the light-emitting device D2. The external quantum efficiency at 200 cd/$m^2$ was 2.87%, and the CIE chromaticity coordinate (x,y) was (0.14,0.18).

<Example D3> Preparation and evaluation of light-emitting device D3

Light-emitting device D3 was prepared in the same way as in Example D1 except that polymer compound HTL-3 was used instead of the polymer compound HTL-5 in Example D1.

(Evaluation of light-emitting device)

EL emission was observed by applying voltage to the light-emitting device D3. The external quantum efficiency at 200 cd/$m^2$ was 2.32%, and the CIE chromaticity coordinate (x,y) was (0.14,0.17).

<Comparative Example CD1> Preparation and evaluation of light-emitting device CD1

Light-emitting device CD1 was prepared in the same way as in Example D1 except that polymer compound HTL-2 and polymer compound HTL-3 (polymer compound HTL-2/polymer compound HTL-3 = 45% by mass/55% by mass) were used instead of the polymer compound HTL-5 in Example D1. As for one in which the above polymer compound HTL-2 and polymer compound HTL-3 were mixed at a ratio of 45:55, the value of $(Y_1 \times 1000) / X_1$ was calculated by the method mentioned above and was consequently 0.55.

(Evaluation of light-emitting device)

EL emission was observed by applying voltage to the light-emitting device CD1. The external quantum efficiency at 200 cd/$m^2$ was 1.77%, and the CIE chromaticity coordinate (x,y) was (0.14,0.17).

<Comparative Example CD2> Preparation and evaluation of light-emitting device CD2

Light-emitting device CD2 was prepared in the same way as in Example D1 except that polymer compound HTL-2 was used instead of the polymer compound HTL-5 in Example D1.

(Evaluation of light-emitting device)

EL emission was observed by applying voltage to the light-emitting device CD2. The external quantum efficiency at 200 cd/$m^2$ was 1.38%, and the CIE chromaticity coordinate (x,y) was (0.14,0.16).

<Comparative Example CD3> Preparation and evaluation of light-emitting device CD3

Light-emitting device CD3 was prepared in the same way as in Example D1 except that polymer compound HTL-1 and polymer compound HTL-2 (polymer compound HTL-1/polymer compound HTL-2 = 50% by mass/50% by mass) were used instead of the polymer compound HTL-5 in Example D1. As for one in which the above polymer compound HTL-1 and polymer compound HTL-2 were mixed at a ratio of 50:50, the value of $(Y_1 \times 1000) / X_1$ was calculated by the method mentioned above and was consequently 0.19.

(Evaluation of light-emitting device)

EL emission was observed by applying voltage to the light-emitting device CD3. The external quantum efficiency at 200 cd/$m^2$ was 0.89%, and the CIE chromaticity coordinate (x,y) was (0.14,0.17).

<Comparative Example CD4> Preparation and evaluation of light-emitting device CD4

Light-emitting device CD4 was prepared in the same way as in Example D1 except that polymer compound HTL-1 was used instead of the polymer compound HTL-5 in Example D1.

(Evaluation of light-emitting device)

EL emission was observed by applying voltage to the light-emitting device CD4. The external quantum efficiency at 200 cd/$m^2$ was 0.75%, and the CIE chromaticity coordinate (x,y) was (0.14,0.17).

The results of Examples and Comparative Examples are shown in Table 3.

[Table 3]

| | Light - emitting device | Second organic layer | | | First organic layer | | External quantum efficiency (%) (200 $cd/m^2$) |
|---|---|---|---|---|---|---|---|
| | | Material | Compositional ratio (% by mass) | $(Y_1 \times 1000)/X_1$ | Material | Compositional ratio (% by mass) | |
| Example D1 | D1 | HTL-5 | 100 | 1.36 | HM-1/EM-A1 | 91.5/8.5 | 2.99 |
| Example D2 | D2 | HTL-4 | 100 | 0.95 | HM-1/EM-A1 | 91.5/8.5 | 2.87 |
| Example D3 | D3 | HTL-3 | 100 | 0.69 | HM-1/EM-A1 | 91.5/8.5 | 2.32 |
| Comparative Example CD1 | CD1 | HTL-2/HTL-3 | 45/55 | 0.55 | HM-1/EM-A1 | 91.5/8.5 | 1.77 |
| Comparative Example CD2 | CD2 | HTL-2 | 100 | 0.38 | HM-1/EM-A1 | 91.5/8.5 | 1.38 |
| Comparative Example CD3 | CD3 | HTL-1/HTL-2 | 50/50 | 0.19 | HM-1/EM-A1 | 91.5/8.5 | 0.89 |
| Comparative Example CD4 | CD4 | HTL-1 | 100 | 0 | HM-1/EM-A1 | 91.5/8.5 | 0.75 |

<Example D4> Preparation and evaluation of light-emitting device D4

(Formation of anode and hole-injecting layer)

An ITO film was attached at a thickness of 45 nm to a glass substrate by the sputtering method to thereby form an anode. A film of a hole-injecting material ND-3202 (manufactured by Nissan Chemical Industries, Ltd.) was formed at a thickness of 35 nm on the anode by the spin coating method. In an air atmosphere, a hole-injecting layer was formed by heating at 50°C for 3 minutes and further heating at 230°C for 15 minutes.

(Formation of second organic layer)

Polymer compound HTL-5 was dissolved at a concentration of 0.6% by mass in xylene. A film was formed at a thickness of 20 nm on the hole-injecting layer by the spin coating method using the obtained xylene solution, and in a nitrogen gas atmosphere, a second organic layer was formed by heating at 180°C for 60 minutes on a hot plate. The polymer compound HTL-5 became a cross-linked form by this heating.

(Formation of first organic layer)

Compound HM-1 and compound EM-1 (compound HM-1/compound EM-1 = 91.5% by mass/8.5% by mass) were dissolved at a concentration of 2% by mass in toluene. A film was formed at a thickness of 60 nm on the second organic layer by the spin coating method using the obtained toluene solution, and in a nitrogen gas atmosphere, a first organic layer was formed by heating at 150°C for 10 minutes on a hot plate.

(Formation of cathode)

The substrate with the first organic layer formed was placed in a vapor deposition machine, and after pressure reduction to 1.0 × $10^{-4}$ Pa or lower, sodium fluoride as a cathode was deposited at approximately 4 nm on the first organic layer, and subsequently, aluminum was deposited at approximately 80 nm on the sodium fluoride layer. After the deposition, the resultant was sealed using a glass substrate to thereby prepare light-emitting device D4.

(Evaluation of light-emitting device)

EL emission was observed by applying voltage to the light-emitting device D4. The external quantum efficiency at 50 cd/$m^2$ was 2.33%, and the CIE chromaticity coordinate (x,y) was (0.16,0.22).

<Example D5> Preparation and evaluation of light-emitting device D5

Light-emitting device D5 was prepared in the same way as in Example D4 except that polymer compound HTL-4 was used instead of the polymer compound HTL-5 in Example D4.

(Evaluation of light-emitting device)

EL emission was observed by applying voltage to the light-emitting device D5. The external quantum efficiency at 50 cd/$m^2$ was 2.28%, and the CIE chromaticity coordinate (x,y) was (0.16,0.23).

<Example D6> Preparation and evaluation of light-emitting device D6

Light-emitting device D6 was prepared in the same way as in Example D4 except that polymer compound HTL-3 was used instead of the polymer compound HTL-5 in Example D4.

(Evaluation of light-emitting device)

EL emission was observed by applying voltage to the light-emitting device D6. The external quantum efficiency at 50 cd/$m^2$ was 2.06%, and the CIE chromaticity coordinate (x,y) was (0.16,0.21).

<Example D7> Preparation and evaluation of light-emitting device D7

Light-emitting device D7 was prepared in the same way as in Example D4 except that compound EM-2 was used instead of the compound EM-1 in Example D4.

(Evaluation of light-emitting device)

EL emission was observed by applying voltage to the light-emitting device D7. The external quantum efficiency at 50 cd/$m^2$ was 2.03%, and the CIE chromaticity coordinate (x,y) was (0.16,0.22).

<Example D8> Preparation and evaluation of light-emitting device D8

Light-emitting device D8 was prepared in the same way as in Example D4 except that compound EM-3 was used instead of the compound EM-1 in Example D4.

(Evaluation of light-emitting device)

EL emission was observed by applying voltage to the light-emitting device D8. The external quantum efficiency at 50 cd/$m^2$ was 1.63%, and the CIE chromaticity coordinate (x,y) was (0.18,0.28).

<Example D9> Preparation and evaluation of light-emitting device D9

Light-emitting device D9 was prepared in the same way as in Example D4 except that compound EM-4 was used instead of the compound EM-1 in Example D4.

(Evaluation of light-emitting device)

EL emission was observed by applying voltage to the light-emitting device D9. The external quantum efficiency at 50 cd/$m^2$ was 1.53%, and the CIE chromaticity coordinate (x,y) was (0.17,0.24).

<Example D10> Preparation and evaluation of light-emitting device D10

Light-emitting device D10 was prepared in the same way as in Example D4 except that polymer compound HP-1 was used instead of the compound HM-1 in Example D4.

(Evaluation of light-emitting device)

EL emission was observed by applying voltage to the light-emitting device D10. The external quantum efficiency at 50 cd/$m^2$ was 3.74%, and the CIE chromaticity coordinate (x,y) was (0.15,0.16).

<Example D11> Preparation and evaluation of light-emitting device D11

Light-emitting device D11 was prepared in the same way as in Example D4 except that compound HM-2 was used instead of the compound HM-1 in Example D4.

(Evaluation of light-emitting device)

EL emission was observed by applying voltage to the light-emitting device D11. The external quantum efficiency at 50 cd/$m^2$ was 2.69%, and the CIE chromaticity coordinate (x,y) was (0.16,0.22).

<Comparative Example CD5> Preparation and evaluation of light-emitting device CD5

Light-emitting device CD5 was prepared in the same way as in Example D4 except that polymer compound HTL-1 was used instead of the polymer compound HTL-5 in Example D4.

(Evaluation of light-emitting device)

EL emission was observed by applying voltage to the light-emitting device CD5. The external quantum efficiency at 50 cd/$m^2$ was 0.33%, and the CIE chromaticity coordinate (x,y) was (0.16,0.19).
The results of Examples and Comparative Example are shown in Table 4.

[Table 4]

| | Light-emitting device | Second organic layer | | | First organic layer | | External quantum efficiency (%) (50 cd/$m^2$) |
|---|---|---|---|---|---|---|---|
| | | Material | Compositional ratio (% by mass) | $(Y_1 \times 1000)/X_1$ | Material | Compositional ratio (% by mass) | |
| Example D4 | D4 | HTL-5 | 100 | 1.36 | HM-1/FM-1 | 91.5/8.5 | 2.33 |
| Example D5 | D5 | HTL-4 | 100 | 0.95 | HM-1/FM-1 | 91.5/8.5 | 2.28 |
| Example D6 | D6 | HTL-3 | 100 | 0.69 | HM-1/FM-1 | 91.5/8.5 | 2.06 |
| Example D7 | D7 | HTL-5 | 100 | 1.36 | HM-1/EM-2 | 91.5/8.5 | 2.03 |
| Example D8 | D8 | HTL-5 | 100 | 1.36 | HM-1/EM-3 | 91.5/8.5 | 1.63 |
| Example D9 | D9 | HTL-5 | 100 | 1.36 | HM-1/EM-4 | 91.5/8.5 | 1.53 |

(continued)

| | Light-emitting device | Second organic layer | | | First organic layer | | External quantum efficiency (%) (50 cd/$m^2$) |
|---|---|---|---|---|---|---|---|
| | | Material | Compositional ratio (% by mass) | $(Y_1 \times 1000)/X_1$ | Material | Compositional ratio (% by mass) | |
| Example D10 | D10 | HTL-5 | 100 | 1.36 | HP-1/EM-1 | 91.5/8.5 | 3.74 |
| Example D11 | D11 | HTL-5 | 100 | 1.36 | HM-2/EM-1 | 91.5/8.5 | 2.69 |
| Comparative Example CD5 | CD5 | HTL-1 | 100 | 0 | HM-1/FM-1 | 91.5/8.5 | 0.33 |

<Example D12> Preparation and evaluation of light-emitting device D12

Light-emitting device D12 was prepared in the same way as in Example D1 except that compound EM-A2 was used instead of the compound EM-A1 in Example D1.

(Evaluation of light-emitting device)

EL emission was observed by applying voltage to the light-emitting device D12. The external quantum efficiency at 400 cd/$m^2$ was 2.00%, and the CIE chromaticity coordinate (x,y) was (0.27,0.64).

<Example D13> Preparation and evaluation of light-emitting device D13

Light-emitting device D13 was prepared in the same way as in Example D12 except that polymer compound HTL-4 was used instead of the polymer compound HTL-5 in Example D12.

(Evaluation of light-emitting device)

EL emission was observed by applying voltage to the light-emitting device D13. The external quantum efficiency at 400 cd/$m^2$ was 1.69%, and the CIE chromaticity coordinate (x,y) was (0.27,0.64).

<Comparative Example CD6> Preparation and evaluation of light-emitting device CD6

Light-emitting device CD6 was prepared in the same way as in Example D12 except that polymer compound HTL-2 and polymer compound HTL-3 (polymer compound HTL-2/polymer compound HTL-3 = 45% by mass/55% by mass) were used instead of the polymer compound HTL-5 in Example D12.

(Evaluation of light-emitting device)

EL emission was observed by applying voltage to the light-emitting device CD6. The external quantum efficiency at 400 cd/$m^2$ was 0.45%, and the CIE chromaticity coordinate (x,y) was (0.27,0.64).

<Comparative Example CD7> Preparation and evaluation of light-emitting device CD7

Light-emitting device CD7 was prepared in the same way as in Example D12 except that polymer compound HTL-2 was used instead of the polymer compound HTL-5 in Example D12.

(Evaluation of light-emitting device)

EL emission was observed by applying voltage to the light-emitting device CD7. The external quantum efficiency at 400 cd/$m^2$ was 0.59%, and the CIE chromaticity coordinate (x,y) was (0.27,0.64).

<Comparative Example CD8> Preparation and evaluation of light-emitting device CD8

Light-emitting device CD8 was prepared in the same way as in Example D12 except that polymer compound HTL-1 was used instead of the polymer compound HTL-5 in Example D12.

(Evaluation of light-emitting device)

EL emission was observed by applying voltage to the light-emitting device CD8. The external quantum efficiency at 400 cd/$m^2$ was 0.62%, and the CIE chromaticity coordinate (x,y) was (0.27,0.64).

<Example D14> Preparation and evaluation of light-emitting device D14

Light-emitting device D14 was prepared in the same way as in Example D1 except that compound EM-5 was used instead of the compound EM-A1 in Example D1.

(Evaluation of light-emitting device)

EL emission was observed by applying voltage to the light-emitting device D14. The external quantum efficiency at 400 cd/$m^2$ was 1.24%, and the CIE chromaticity coordinate (x,y) was (0.16,0.22).

<Example D15> Preparation and evaluation of light-emitting device D15

Light-emitting device D15 was prepared in the same way as in Example D14 except that polymer compound HTL-3 was used instead of the polymer compound HTL-5 in Example D14.

(Evaluation of light-emitting device)

EL emission was observed by applying voltage to the light-emitting device D15. The external quantum efficiency at 400 cd/$m^2$ was 1.07%, and the CIE chromaticity coordinate (x,y) was (0.16,0.23).

<Comparative Example CD9> Preparation and evaluation of light-emitting device CD9

Light-emitting device CD9 was prepared in the same way as in Example D14 except that polymer compound HTL-1 was used instead of the polymer compound HTL-5 in Example D14.

(Evaluation of light-emitting device)

EL emission was observed by applying voltage to the light-emitting device CD9. The external quantum efficiency at 400 cd/$m^2$ was 0.60%, and the CIE chromaticity coordinate (x,y) was (0.16,0.24).

The results of Examples and Comparative Examples are shown in Table 5.

[Table 5]

| | Light-emitting device | Second organic layer | | | First organic layer | | External quantum efficiency (%) (400 cd/$m^2$) |
|---|---|---|---|---|---|---|---|
| | | Material | Compositional ratio (% by mass) | (Y1×1000)/X1 | Material | Compositional ratio (% by mass) | |
| Example D12 | D12 | HTL-5 | 100 | 1.36 | HM-1/EM-A2 | 91.5/8.5 | 2.00 |
| Example D13 | D13 | HTL-4 | 100 | 0.95 | HM-1/EM-A2 | 91.5/8.5 | 1.69 |
| Comparative Example CD6 | CD6 | HTL-2+HTL-3 | 45/55 | 0.55 | HM-1/EM-A2 | 91.5/8.5 | 0.45 |

(continued)

| | Light-emitting device | Second organic layer | | | First organic layer | | External quantum efficiency (%) (400 cd/m$^2$) |
|---|---|---|---|---|---|---|---|
| | | Material | Compositional ratio (% by mass) | (Y1×1000)/X1 | Material | Compositional ratio (% by mass) | |
| Comparative Example CD7 | CD7 | HTL-2 | 100 | 0.38 | HM-1/EM-A2 | 91.5/8.5 | 0.59 |
| Comparative Example CD8 | CD8 | HTL-1 | 100 | 0 | HM-1/EM-A2 | 91.5/8.5 | 0.62 |
| Example D14 | D14 | HTL-5 | 100 | 1.36 | HM-1/EM-5 | 91.5/8.5 | 1.24 |
| Example D15 | D15 | HTL-3 | 100 | 0.69 | HM-1/EM-5 | 91.5/8.5 | 1.07 |
| Comparative Example CD9 | CD9 | HTL-1 | 100 | 0 | HM-1/EM-5 | 91.5/8.5 | 0.60 |

<Example D16> Preparation and evaluation of light-emitting device D16

Light-emitting device D16 was prepared in the same way as in Example D4.

(Evaluation of light-emitting device)

EL emission was observed by applying voltage to the light-emitting device D16. The external quantum efficiency at 1000 cd/m$^2$ was 2.30%, and the CIE chromaticity coordinate (x,y) was (0.16,0.22).

<Example D17> Preparation and evaluation of light-emitting device D17

Light-emitting device D17 was prepared in the same way as in Example D4 except that compound EM-6 was used instead of the compound EM-1 in Example D4.

(Evaluation of light-emitting device)

EL emission was observed by applying voltage to the light-emitting device D17. The external quantum efficiency at 1000 cd/m$^2$ was 1.78%, and the CIE chromaticity coordinate (x,y) was (0.14,0.18).

<Example D18> Preparation and evaluation of light-emitting device D18

Light-emitting device D18 was prepared in the same way as in Example D4 except that compound EM-7 was used instead of the compound EM-1 in Example D4.

(Evaluation of light-emitting device)

EL emission was observed by applying voltage to the light-emitting device D18. The external quantum efficiency at 1000 cd/m$^2$ was 1.37%, and the CIE chromaticity coordinate (x,y) was (0.16,0.19).

**Industrial Applicability**

According to the present invention, a light-emitting device excellent in external quantum efficiency can be provided.

## Claims

1. A light-emitting device comprising:

an anode;
a cathode;
a first organic layer disposed between the anode and the cathode; and
a second organic layer disposed, adjacently to the first organic layer, between the anode and the cathode, wherein:

the first organic layer is a layer containing a fluorescent low-molecular compound that does not have a molecular weight distribution and has a molecular weight of $1 \times 10^4$ or smaller;
a maximum peak wavelength of an emission spectrum of the fluorescent low-molecular compound is 380 nm or larger and 750 nm or smaller;
the second organic layer is a layer containing a cross-linked form of a polymer compound comprising a cross-linking constitutional unit having a cross-linking group;
as for each constitutional unit constituting the polymer compound, when a value x obtained by multiplying a molar ratio C of the constitutional unit to a total mol of all constitutional units by a molecular weight M of the constitutional unit, and a value y obtained by multiplying the molar ratio C by a number n of the cross-linking group carried by the constitutional unit are determined, a value of $(Y_1 \times 1000) / X_1$ calculated from a summation $X_1$ of the values x and a summation $Y_1$ of the values y is 0.60 or more;
the fluorescent low-molecular compound is a compound represented by the formula (B):

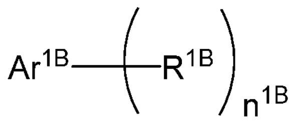 (B)

wherein

$n^{1B}$ represents an integer of 1 to 8;
$Ar^{1B}$ represents an aromatic hydrocarbon group or an aromatic heterocyclic group, and these groups optionally have a substituent; in the case where a plurality of the substituent are present, they are the same or different and are optionally bonded to each other to form a ring together with the atoms to which they are attached;
$R^{1B}$ represents an alkyl group, a cycloalkyl group, an alkoxy group, a cycloalkoxy group, an aryl group, a monovalent heterocyclic group, a substituted amino group, an alkenyl group, a cycloalkenyl group, an alkynyl group or a cycloalkynyl group, and these groups optionally have a substituent; and in the case where a plurality of $R^{1B}$ are present, they are the same or different and are optionally bonded to each other to form a ring together with the carbon atoms to which they are attached; and
the maximum peak wavelength of an emission spectrum of the fluorescent low-molecular compound is evaluated by measuring a photoluminescence spectrum.

2. The light-emitting device according to claim 1, wherein $n^{1B}$ is an integer of 1 to 4.

3. The light-emitting device according to claim 1 or 2, wherein the $Ar^{1B}$ is an aromatic hydrocarbon group optionally having a substituent.

4. The light-emitting device according to claim 3, wherein the $Ar^{1B}$ is a group formed by removing one or more hydrogen atoms directly bonded to an annular carbon atom from a benzene ring, a biphenyl ring, a naphthalene ring, an anthracene ring, a phenanthrene ring, a dihydrophenanthrene ring, a triphenylene ring, a naphthacene ring, a fluorene ring, a spirobifluorene ring, a pyrene ring, a perylene ring, a chrysene ring, an indene ring, a fluoranthene ring, a benzofluoranthene ring or an acenaphthofluoranthene ring, optionally wherein the group has a substituent.

5. The light-emitting device according to claim 4, wherein the $Ar^{1B}$ is a group formed by removing one or more hydrogen atoms directly bonded to an annular carbon atom from a biphenyl ring, a pyrene ring, a chrysene ring, a fluoranthene ring or a benzofluoranthene, optionally wherein the group has a substituent.

6. The light-emitting device according to claim 5, wherein the $Ar^{1B}$ is a group formed by removing one or more hydrogen atoms

atoms directly bonded to an annular carbon atom from a fluoranthene ring or a benzofluoranthene ring, optionally wherein the group has a substituent.

**7.** The light-emitting device according to any one of claims 1 to 6, wherein the $R^{1B}$ is an alkyl group, a cycloalkyl group, an aryl group, a monovalent heterocyclic group, a substituted amino group, an alkenyl group or a cycloalkenyl group, optionally wherein these groups have a substituent.

**8.** The light-emitting device according to claim 7, wherein the $R^{1B}$ is an aryl group, a substituted amino group or an alkenyl group optionally wherein these groups have a substituent.

**9.** The light-emitting device according to any one of claims 1 to 8, wherein the maximum peak wavelength of an emission spectrum of the fluorescent low-molecular compound is 380 nm or larger and 570 nm or smaller.

**10.** The light-emitting device according to any one of claims 1 to 9, wherein the polymer compound is a polymer compound comprising a cross-linking constitutional unit having at least one cross-linking group selected from the Group A of cross-linking group:

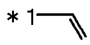
(XL-1)

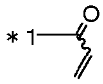
(XL-2)

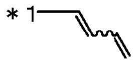
(XL-3)

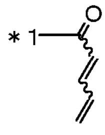
(XL-4)

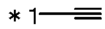
(XL-5)

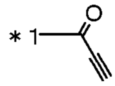
(XL-6)

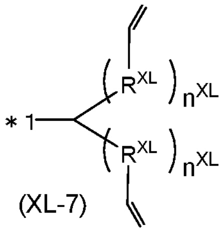
(XL-7)

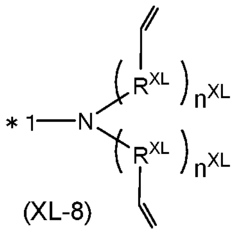
(XL-8)

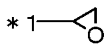
(XL-9)

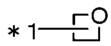
(XL-10)

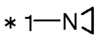
(XL-11)

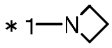
(XL-12)

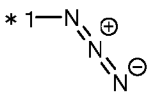
(XL-13)

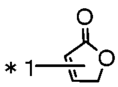
(XL-14)

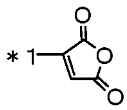
(XL-15)

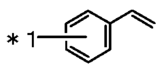
(XL-16)

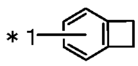
(XL-17)

wherein $R^{XL}$ represents a methylene group, an oxygen atom or a sulfur atom; $n^{XL}$ represents an integer of 0 to 5; in the case where a plurality of $R^{XL}$ are present, they are the same or different; in the case where a plurality of $n^{XL}$ are present, they are the same or different; *1 represents a position of a bond; and these cross-linking groups optionally have a substituent.

**11.** The light-emitting device according to claim 10, wherein the cross-linking constitutional unit is a constitutional unit represented by the formula (2) or a constitutional unit represented by the formula (2'):

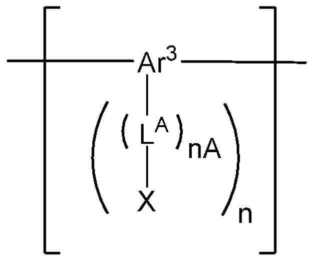

(2)

wherein

nA represents an integer of 0 to 5; n represents 1 or 2; in the case where a plurality of nA are present, they are the same or different;
$Ar^3$ represents an aromatic hydrocarbon group or a heterocyclic group, and these groups optionally have a substituent;
$L^A$ represents an alkylene group, a cycloalkylene group, an arylene group, a divalent heterocyclic group, a group represented by -NR'-, an oxygen atom or a sulfur atom, and these groups optionally have a substituent; R' represents a hydrogen atom, an alkyl group, a cycloalkyl group, an aryl group or a monovalent heterocyclic group, and these groups optionally have a substituent; in the case where a plurality of $L^A$ are present, they are the same or different;
X represents a cross-linking group selected from the cross-linking group A group; and in the case where a plurality of X are present, they are the same or different, and

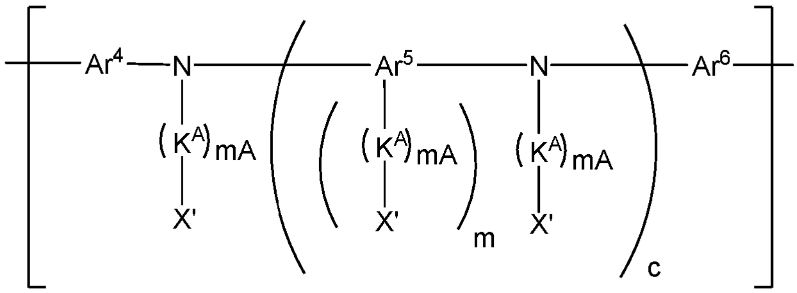

(2')

wherein

mA represents an integer of 0 to 5; m represents an integer of 1 to 4; c represents an integer of 0 or 1; in the case where a plurality of mA are present, they are the same or different;
$Ar^5$ represents an aromatic hydrocarbon group, a heterocyclic group, or a group in which at least one aromatic hydrocarbon ring and at least one heterocyclic ring are directly bonded, and these groups optionally have a substituent;
$Ar^4$ and $Ar^6$ each independently represent an arylene group or a divalent heterocyclic group, and these groups optionally have a substituent;
each of $Ar^4$, $Ar^5$ and $Ar^6$ optionally forms a ring by bonding directly or via an oxygen atom or a sulfur atom to a group, other than the group concerned, bonded to the nitrogen atom to which the group concerned is bonded;
$K^A$ represents an alkylene group, a cycloalkylene group, an arylene group, a divalent heterocyclic group, a group represented by -NR'-, an oxygen atom or a sulfur atom, and these groups optionally have a substituent; R' represents a hydrogen atom, an alkyl group, a cycloalkyl group, an aryl group or a monovalent heterocyclic group, and these groups optionally have a substituent; in the case where a plurality of $K^A$ are present, they are the same or different;
X' represents a cross-linking group selected from the cross-linking group A group, a hydrogen atom, an alkyl group, a cycloalkyl group, an aryl group or a monovalent heterocyclic group, and these groups optionally have a substituent; and in the case where a plurality of X' are present, they are the same or different, provided that at least one X' is a cross-linking group selected from the Group A of cross-linking group.

**12.** The light-emitting device according to any one of claims 1 to 11, wherein the value of $(Y_1 \times 1000) / X_1$ is 0.85 or more and 4.0 or less.

**13.** The light-emitting device according to any one of claims 1 to 12, wherein:

the first organic layer is a layer containing the fluorescent low-molecular compound and a host material;
the host material is a compound represented by the formula (FH-1) or a polymer compound comprising a constitutional unit represented by the formula (Y); and
the amount of the fluorescent low-molecular compound is 0.1 to 50 parts by mass with respect to 100 parts by mass in total of the fluorescent low-molecular compound and the host material:

$$Ar^{H1}-\left[L^{H1}\right]_{n^{H1}}-Ar^{H2} \qquad \textbf{(FH-1)}$$

wherein

$Ar^{H1}$ and $Ar^{H2}$ each independently represent an aryl group, a monovalent heterocyclic group or a substituted amino group, and these groups optionally have a substituent;
$n^{H1}$ represents an integer of 0 to 15;
$L^{H1}$ represents an arylene group, a divalent heterocyclic group, or a group represented by $-[C(RH^{11})_2]n^{H11}-$, and these groups optionally have a substituent; in the case where a plurality of $L^{H1}$ are present, they are the same or different; $n^{H11}$ represents an integer of 1 to 10; $R^{H11}$ represents a hydrogen atom, an alkyl group, a cycloalkyl group, an alkoxy group, a cycloalkoxy group, an aryl group or a monovalent heterocyclic group, and these groups optionally have a substituent; and a plurality of $R^{H11}$ present are the same or different and are optionally bonded to each other to form a ring together with the carbon atoms to which they are attached and

$$-\left[-Ar^{Y1}\right]- \qquad (Y)$$

wherein $Ar^{Y1}$ represents an arylene group, a divalent heterocyclic group, or a divalent group in which at least one arylene group and at least one divalent heterocyclic group are directly bonded, and these groups optionally have a substituent.

**14.** The light-emitting device according to any one of claims 1 to 13, wherein the first organic layer further contains at least one material selected from the group consisting of a hole-transporting material, a hole-injecting material, an electron-transporting material, an electron-injecting material, an antioxidant, and a light-emitting material different from the fluorescent low-molecular compound.

**15.** The light-emitting device according to any one of claims 1 to 14, wherein the second organic layer is a layer disposed between the anode and the first organic layer.

## Patentansprüche

**1.** Lichtemittierende Vorrichtung, umfassend
eine Anode;
eine Kathode;
eine erste organische Schicht, die zwischen der Anode und der Kathode angeordnet ist; und
eine zweite organische Schicht, die neben der ersten organischen Schicht zwischen der Anode und der Kathode angeordnet ist, wobei:

die erste organische Schicht eine Schicht ist, die eine fluoreszierende niedermolekulare Verbindung enthält, die keine Molekulargewichtsverteilung hat und ein Molekulargewicht von 1 x $10^4$ oder weniger hat;
eine maximale Peak-Wellenlänge eines Emissionsspektrums der fluoreszierenden niedermolekularen Verbindung 380 nm oder größer und 750 nm oder kleiner ist;
die zweite organische Schicht eine Schicht ist, die eine vernetzte Form einer Polymerverbindung enthält, die eine konstitutionelle Vernetzungseinheit mit einer Vernetzungsgruppe umfasst;
für jede konstitutionelle Einheit, die die Polymerverbindung bildet, gilt: wenn ein Wert x, der durch Multiplizieren

eines molaren Verhältnisses C der konstitutionellen Einheit zu einem Gesamtmol aller konstitutionellen Einheiten mit einem Molekulargewicht M der konstitutionellen Einheit erhalten wird, und ein Wert y, der durch Multiplizieren des molaren Verhältnisses C mit einer Anzahl n der von der konstitutionellen Einheit getragenen Vernetzungsgruppe erhalten wird, bestimmt werden, ein Wert von ($Y_1$ x 1000) / $X_1$, berechnet aus einer Summierung $X_1$ der Werte x und einer Summierung $Y_1$ der Werte y, 0,60 oder mehr beträgt;
die fluoreszierende niedermolekulare Verbindung eine Verbindung ist, die durch die Formel (B) dargestellt wird:

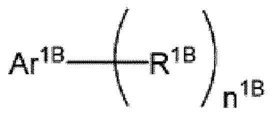 (B)

wobei

$n^{1B}$ eine ganze Zahl von 1 bis 8 darstellt;
$Ar^{1B}$ eine aromatische Kohlenwasserstoffgruppe oder eine aromatische heterocyclische Gruppe darstellt, und diese Gruppen optional einen Substituenten aufweisen; in dem Fall, in dem eine Vielzahl der Substituenten vorhanden ist, diese jeweils gleich oder verschieden sind und optional aneinander gebunden sind, um zusammen mit den Atomen, an die sie gebunden sind, einen Ring zu bilden;
$R^{1B}$ eine Alkylgruppe, eine Cycloalkylgruppe, eine Alkoxygruppe, eine Cycloalkoxygruppe, eine Arylgruppe, eine monovalente heterocyclische Gruppe, eine substituierte Aminogruppe, eine Alkenylgruppe, eine Cycloalkenylgruppe, eine Alkynylgruppe oder eine Cycloalkynylgruppe darstellt und diese Gruppen optional einen Substituenten aufweisen; und in dem Fall, in dem eine Vielzahl von $R^{1B}$ vorhanden ist, diese jeweils gleich oder verschieden sind und optional aneinander gebunden sind, um zusammen mit den Kohlenstoffatomen, an die sie gebunden sind, einen Ring zu bilden; und
die maximale Peak-Wellenlänge eines Emissionsspektrums der fluoreszierenden niedermolekularen Verbindung durch Messung eines Photolumineszenzspektrums ausgewertet wird.

2. Lichtemittierende Vorrichtung nach Anspruch 1, wobei $n^{1B}$ eine ganze Zahl von 1 bis 4 ist.

3. Lichtemittierende Vorrichtung nach Anspruch 1 oder 2, wobei $Ar^{1B}$ eine aromatische Kohlenwasserstoffgruppe ist, die optional einen Substituenten aufweist.

4. Lichtemittierende Vorrichtung nach Anspruch 3, wobei $Ar^{1B}$ eine Gruppe ist, die gebildet wird durch Entfernen eines oder mehrerer direkt an ein ringförmiges Kohlenstoffatom gebundener Wasserstoffatome von einem Benzolring, einem Biphenylring, einem Naphthalinring, einem Anthracenring, einem Phenanthrenring, einem Dihydrophenanthrenring, einem Triphenylenring, einem Naphthacenring, einem Fluorenring, einem Spirobifluorenring, einem Pyrenring, einem Perylenring, einem Chrysenring, einem Indenring, einem Fluoranthenring, einem Benzofluoranthenring oder einem Acenaphthofluoranthenring, wobei die Gruppe optional einen Substituenten aufweist.

5. Lichtemittierende Vorrichtung nach Anspruch 4, wobei $Ar^{1B}$ eine Gruppe ist, die gebildet wird durch Entfernen eines oder mehrerer direkt an ein ringförmiges Kohlenstoffatom gebundener Wasserstoffatome von einem Biphenylring, einem Pyrenring, einem Chrysenring, einem Fluoranthenring oder einem Benzofluoranthen, wobei die Gruppe optional einen Substituenten aufweist.

6. Lichtemittierende Vorrichtung nach Anspruch 5, wobei $Ar^{1B}$ eine Gruppe ist, die gebildet wird durch Entfernen eines oder mehrerer direkt an ein ringförmiges Kohlenstoffatom gebundener Wasserstoffatome von einem Fluoranthenring oder einem Benzofluoranthenring, wobei die Gruppe optional einen Substituenten aufweist.

7. Lichtemittierende Vorrichtung nach einem der Ansprüche 1 bis 6, wobei $R^{1B}$ eine Alkylgruppe, eine Cycloalkylgruppe, eine Arylgruppe, eine einwertige heterocyclische Gruppe, eine substituierte Aminogruppe, eine Alkenylgruppe oder eine Cycloalkenylgruppe ist, wobei diese Gruppen optional einen Substituenten aufweisen.

8. Lichtemittierende Vorrichtung nach Anspruch 7, wobei $R^{1B}$ eine Arylgruppe, eine substituierte Aminogruppe oder eine Alkenylgruppe ist, wobei diese Gruppen optional einen Substituenten aufweisen.

9. Lichtemittierende Vorrichtung nach einem der Ansprüche 1 bis 8, wobei die maximale Peak-Wellenlänge eines

Emissionsspektrums der fluoreszierenden niedermolekularen Verbindung 380 nm oder größer und 570 nm oder kleiner ist.

**10.** Lichtemittierende Vorrichtung nach einem der Ansprüche 1 bis 9, wobei die Polymerverbindung eine Polymerverbindung ist, die eine konstitutionelle Vernetzungseinheit mit mindestens einer Vernetzungsgruppe, ausgewählt aus der Gruppe A der Vernetzungsgruppe, umfasst:

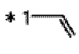
(XL-1)

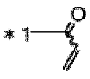
(XL-2)

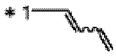
(XL-3)

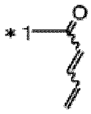
(XL-4)

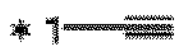
(XL-5)

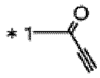
(XL-6)

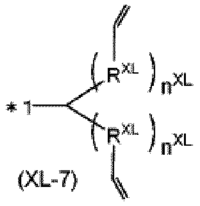
(XL-7)

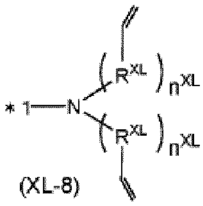
(XL-8)

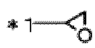
(XL-9)

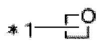
(XL-10)

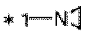
(XL-11)

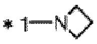
(XL-12)

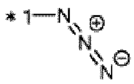
(XL-13)

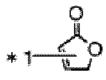
(XL-14)

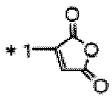
(XL-15)

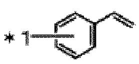
(XL-16)

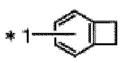
(XL-17)

wobei $R^{XL}$ eine Methylengruppe, ein Sauerstoffatom oder ein Schwefelatom darstellt; $n^{XL}$ eine ganze Zahl von 0 bis 5 darstellt; in dem Fall, in dem eine Vielzahl von $R^{XL}$ vorhanden ist, diese jeweils gleich oder verschieden sind; in dem Fall, in dem eine Vielzahl von $n^{XL}$ vorhanden ist, diese jeweils gleich oder verschieden sind; *1 eine Position einer Bindung darstellt; und diese Vernetzungsgruppen optional einen Substituenten aufweisen.

**11.** Lichtemittierende Vorrichtung nach Anspruch 10, wobei die konstitutionelle Vernetzungseinheit eine konstitutionelle Einheit ist, die durch die Formel (2) dargestellt wird, oder eine konstitutionelle Einheit ist, die durch die Formel (2') dargestellt wird:

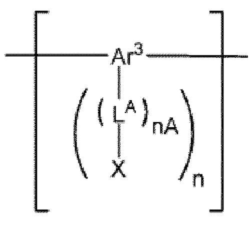
(2)

wobei

nA eine ganze Zahl von 0 bis 5 darstellt; n 1 oder 2 darstellt; in dem Fall, in dem eine Vielzahl von nA vorhanden ist, diese jeweils gleich oder verschieden sind;

$Ar^3$ eine aromatische Kohlenwasserstoffgruppe oder eine heterocyclische Gruppe darstellt und diese Gruppen optional einen Substituenten aufweisen;

$L^A$ eine Alkylengruppe, eine Cycloalkylengruppe, eine Arylengruppe, eine zweiwertige heterocyclische Gruppe, eine Gruppe, dargestellt durch -NR'-, ein Sauerstoffatom oder ein Schwefelatom darstellt und diese Gruppen

optional einen Substituenten aufweisen; R' ein Wasserstoffatom, eine Alkylgruppe, eine Cycloalkylgruppe, eine Arylgruppe oder eine einwertige heterocyclische Gruppe darstellt und diese Gruppen optional einen Substituenten aufweisen; in dem Fall, in dem eine Vielzahl von $L^A$ vorhanden ist, diese jeweils gleich oder verschieden sind;
X eine Vernetzungsgruppe darstellt, ausgewählt aus der Vernetzungsgruppe A; und in dem Fall, in dem eine Vielzahl von X vorhanden ist, diese jeweils gleich oder verschieden sind, und

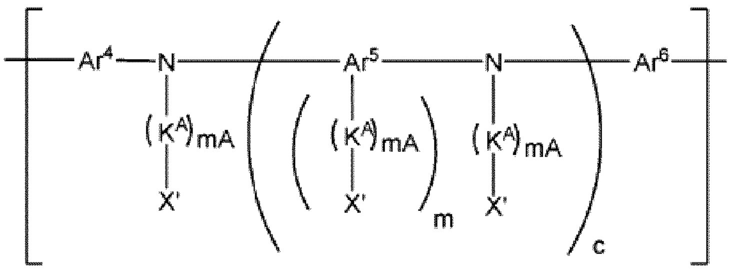

(2')

wobei

mA eine ganze Zahl von 0 bis 5 darstellt; m eine ganze Zahl von 1 bis 4 darstellt; c eine ganze Zahl von 0 oder 1 darstellt; in dem Fall, in dem eine Vielzahl von mA vorhanden ist, diese jeweils gleich oder verschieden sind;
$Ar^5$ eine aromatische Kohlenwasserstoffgruppe, eine heterocyclische Gruppe oder eine Gruppe, in der mindestens ein aromatischer Kohlenwasserstoffring und mindestens ein heterocyclischer Ring direkt gebunden sind, darstellt und diese Gruppen optional einen Substituenten aufweisen;
$Ar^4$ und $Ar^6$ jeweils unabhängig voneinander eine Arylengruppe oder eine zweiwertige heterocyclische Gruppe darstellen und diese Gruppen optional einen Substituenten aufweisen;
jedes von $Ar^4$, $Ar^5$ und $Ar^6$ optional einen Ring bildet, und zwar durch die direkte Bindung oder die Bindung über ein Sauerstoffatom oder ein Schwefelatom an eine Gruppe (die eine andere Gruppe als die betreffende Gruppe ist), die an das Stickstoffatom gebunden ist, an das die betreffende Gruppe gebunden ist;
$K^A$ eine Alkylengruppe, eine Cycloalkylengruppe, eine Arylengruppe, eine zweiwertige heterocyclische Gruppe, eine Gruppe, dargestellt durch -NR'-, ein Sauerstoffatom oder ein Schwefelatom darstellt und diese Gruppen optional einen Substituenten aufweisen; R' ein Wasserstoffatom, eine Alkylgruppe, eine Cycloalkylgruppe, eine Arylgruppe oder eine einwertige heterocyclische Gruppe darstellt und diese Gruppen optional einen Substituenten aufweisen; in dem Fall, in dem eine Vielzahl von $K^A$ vorhanden ist, diese jeweils gleich oder verschieden sind;
X' eine Vernetzungsgruppe, ausgewählt aus der Vernetzungsgruppe A-Gruppe, ein Wasserstoffatom, eine Alkylgruppe, eine Cycloalkylgruppe, eine Arylgruppe oder eine einwertige heterocyclische Gruppe darstellt und diese Gruppen optional einen Substituenten aufweisen; und in dem Fall, in dem eine Vielzahl von X' vorhanden ist, diese jeweils gleich oder verschieden sind, vorausgesetzt, dass mindestens ein X' eine Vernetzungsgruppe ist, die ausgewählt ist aus der Gruppe A der Vernetzungsgruppe.

**12.** Lichtemittierende Vorrichtung nach einem der Ansprüche 1 bis 11, wobei der Wert von ($Y_1$ x 1000) / $X_1$ 0,85 oder mehr und 4,0 oder weniger beträgt.

**13.** Lichtemittierende Vorrichtung nach einem der Ansprüche 1 bis 12, wobei:

die erste organische Schicht eine Schicht ist, die die fluoreszierende niedermolekulare Verbindung und ein Grundmaterial enthält;
das Grundmaterial eine Verbindung ist, die durch die Formel (FH-1) dargestellt wird, oder eine Polymerverbindung ist, die eine durch die Formel (Y) dargestellte konstitutionelle Einheit umfasst; und
die Menge der fluoreszierenden niedermolekularen Verbindung 0,1 bis 50 Masseteile in Bezug auf insgesamt 100 Massenteile der fluoreszierenden niedermolekularen Verbindung und des Grundmaterials beträgt:

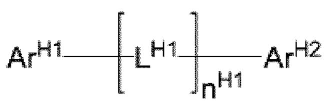

**(FH-1)**

wobei

$Ar^{H1}$ und $Ar^{H2}$ jeweils unabhängig voneinander eine Arylgruppe, eine einwertige heterocyclische Gruppe oder eine substituierte Aminogruppe darstellen und diese Gruppen optional einen Substituenten aufweisen;
$n^{H1}$ eine ganze Zahl von 0 bis 15 darstellt;
$L^{H1}$ eine Arylengruppe, eine zweiwertige heterocyclische Gruppe oder eine Gruppe, dargestellt durch $-[C(R^{H11})_2]n^{H11}$, darstellt und diese Gruppen optional einen Substituenten aufweisen; in dem Fall, in dem eine Vielzahl von $L^{H1}$ vorhanden ist, diese jeweils gleich oder verschieden sind; $n^{H11}$ eine ganze Zahl von 1 bis 10 darstellt; $R^{H11}$ ein Wasserstoffatom, eine Alkylgruppe, eine Cycloalkylgruppe, eine Alkoxygruppe, eine Cycloalkoxygruppe, eine Arylgruppe oder eine einwertige heterocyclische Gruppe darstellt und diese Gruppen optional einen Substituenten aufweisen; und eine vorhandene Vielzahl von $R^{H11}$ jeweils gleich oder verschieden sind und optional aneinander gebunden sind, um zusammen mit den Kohlenstoffatomen, an die sie gebunden sind, einen Ring zu bilden und

$-[-Ar^{Y1}-]-$ (Y)

wobei $Ar^{Y1}$ eine Arylengruppe, eine zweiwertige heterocyclische Gruppe oder eine zweiwertige Gruppe, in der mindestens eine Arylengruppe und mindestens eine zweiwertige heterocyclische Gruppe direkt gebunden sind, darstellt und diese Gruppen optional einen Substituenten aufweisen.

**14.** Lichtemittierende Vorrichtung nach einem der Ansprüche 1 bis 13, wobei die erste organische Schicht ferner mindestens ein Material enthält, das ausgewählt ist aus der Gruppe bestehend aus einem lochtransportierenden Material, einem lochinjizierenden Material, einem elektronentransportierenden Material, einem elektroneninjizierenden Material, einem Antioxidationsmittel und einem lichtemittierenden Material, das sich von der fluoreszierenden niedermolekularen Verbindung unterscheidet.

**15.** Lichtemittierende Vorrichtung nach einem der Ansprüche 1 bis 14, wobei die zweite organische Schicht eine Schicht ist, die zwischen der Anode und der ersten organischen Schicht angeordnet ist.

**Revendications**

**1.** Dispositif luminescent, comprenant :

une anode ;
une cathode ;
une première couche organique disposée entre l'anode et la cathode ; et
une seconde couche organique disposée, de façon adjacente à la première couche organique, entre l'anode et la cathode, dans lequel :

la première couche organique est une couche contenant un composé fluorescent à faible poids moléculaire qui n'a pas une distribution de poids moléculaire et a un poids moléculaire de $1 \times 10^4$ ou moins ;
une longueur d'onde de crête maximum d'un spectre d'émission du composé fluorescent à faible poids moléculaire est de 380 nm ou plus et 750 nm ou moins ;
la seconde couche organique est une couche contenant une forme réticulée d'un composé polymère comprenant une unité constitutive réticulante ayant un groupe réticulant ;
comme pour chaque unité constitutive constituant le composé polymère, lorsqu'une valeur x obtenue en multipliant un rapport molaire C de l'unité constitutive par rapport à une mole totale de toutes les unités constitutives par un poids moléculaire M de l'unité constitutive, et une valeur y obtenue en multipliant le rapport molaire C par un nombre n du groupe réticulant supporté par l'unité constitutive sont déterminées, une valeur de $(Y_1 \times 1000) / X_1$ calculée à partir d'une sommation $X_1$ des valeurs x et une sommation $Y_1$ des valeurs y est 0,60 ou plus ;
le composé fluorescent à faible poids moléculaire est un composé représenté par la formule (B) :

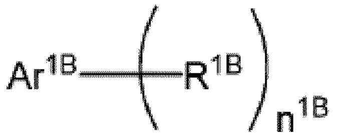 (B)

dans lequel

$n^{1B}$ représente un nombre entier relatif de 1 à 8 ;
$Ar^{1B}$ représente un groupe hydrocarbure aromatique ou un groupe hétérocyclique aromatique, et ces groupes ont optionnellement un substituant ; au cas où une pluralité du substituant sont présents, ils sont les mêmes ou différents et sont optionnellement liés les uns aux autres pour former un anneau conjointement avec les atomes auxquels ils sont attachés ;
$R^{1B}$ représente un groupe alkyle, un groupe cycloalkyle, un groupe alkoxy, un groupe cycloalkoxy, un groupe aryle, un groupe hétérocyclique monovalent, un groupe amino substitué, un groupe alcényle, un groupe cycloalcényle, un groupe alkynyle ou un groupe cycloalkynyle, et ces groupes ont optionnellement un substituant ; et au cas où une pluralité de $R^{1B}$ sont présents, ils sont les mêmes ou différents et sont optionnellement liés les uns aux autres pour former un anneau conjointement avec les atomes de carbone auxquels ils sont attachés ; et
la longueur d'onde de crête maximum d'un spectre d'émission du composé fluorescent à faible poids moléculaire est évaluée en mesurant un spectre de photoluminescence.

**2.** Dispositif luminescent selon la revendication 1, dans lequel $n^{1B}$ est un nombre entier relatif de 1 à 4.

**3.** Dispositif luminescent selon la revendication 1 ou 2, dans lequel $Ar^{1B}$ est un groupe hydrocarbure aromatique optionnellement ayant un substituant.

**4.** Dispositif luminescent selon la revendication 3, dans lequel $Ar^{1B}$ est un groupe formé en enlevant un ou plusieurs atomes d'hydrogène directement liés à un atome de carbone annulaire à partir d'un anneau benzène, d'un anneau biphényle, d'un anneau naphtalène, d'un anneau anthracène, d'un anneau phénanthrène, d'un anneau dihydrophénanthrène, d'un anneau triphénylène, d'un anneau naphtacène, d'un anneau fluorène, d'un anneau spirobifluorène, d'un anneau pyrène, d'un anneau pérylène, d'un anneau chrysène, d'un anneau indène, d'un anneau fluoranthène, d'un anneau benzofluoranthène ou d'un anneau acénaphtofluoranthène, optionnellement dans lequel le groupe a un substituant.

**5.** Dispositif luminescent selon la revendication 4, dans lequel $Ar^{1B}$ est un groupe formé en enlevant un ou plusieurs atomes d'hydrogène directement liés à un atome de carbone annulaire à partir d'un anneau biphényle, d'un anneau pyrène, d'un anneau chrysène, d'un anneau fluoranthène ou d'un benzofluoranthène, optionnellement dans lequel le groupe a un substituant.

**6.** Dispositif luminescent selon la revendication 5, dans lequel $Ar^{1B}$ est un groupe formé en enlevant un ou plusieurs atomes d'hydrogène directement liés à un atome de carbone annulaire à partir d'un anneau fluoranthène ou d'un anneau benzofluoranthène, optionnellement dans lequel le groupe a un substituant.

**7.** Dispositif luminescent selon l'une quelconque des revendications 1 à 6, dans lequel $R^{1B}$ est un groupe alkyle, un groupe cycloalkyle, un groupe aryle, un groupe hétérocyclique monovalent, un groupe amino substitué, un groupe alcényle ou un groupe cycloalcényle, optionnellement dans lequel ces groupes ont un substituant.

**8.** Dispositif luminescent selon la revendication 7, dans lequel $R^{1B}$ est un groupe aryle, un groupe amino substitué ou un groupe alcényle optionnellement dans lequel ces groupes ont un substituant.

**9.** Dispositif luminescent selon l'une quelconque des revendications 1 à 8, dans lequel la longueur d'onde de crête maximum d'un spectre d'émission du composé fluorescent à faible poids moléculaire est de 380 nm ou plus et de 570 nm ou moins.

**10.** Dispositif luminescent selon l'une quelconque des revendications 1 à 9, dans lequel le composé polymère est un composé polymère comprenant une unité constitutive réticulante ayant au moins un groupe réticulant sélectionné à partir du groupe A de groupe réticulant :

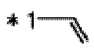
(XL-1)
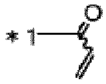
(XL-2)
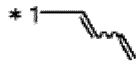
(XL-3)
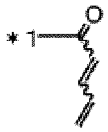
(XL-4)
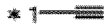
(XL-5)
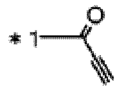
(XL-6)

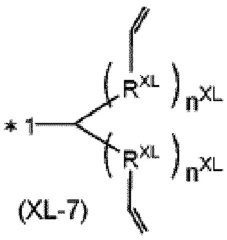
(XL-7)
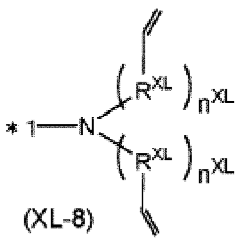
(XL-8)
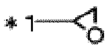
(XL-9)
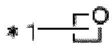
(XL-10)

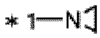
(XL-11)
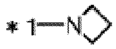
(XL-12)
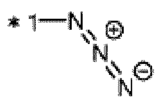
(XL-13)
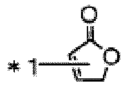
(XL-14)
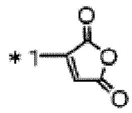
(XL-15)

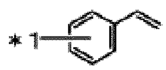
(XL-16)
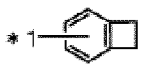
(XL-17)

dans lequel $R^{XL}$ représente un groupe méthylène, un atome d'oxygène ou un atome de soufre ; $n^{XL}$ représente un nombre entier relatif de 0 à 5 ; au cas où une pluralité de $R^{XL}$ sont présents, ils sont les mêmes ou différents ; au cas où une pluralité de $n^{XL}$ sont présents, ils sont les mêmes ou différents ; *1 représente une position d'une liaison ; et ces groupe réticulants ont optionnellement un substituant.

**11.** Dispositif luminescent selon la revendication 10, dans lequel l'unité constitutive réticulante est une unité constitutive représentée par la formule (2) ou une unité constitutive représentée par la formule (2') :

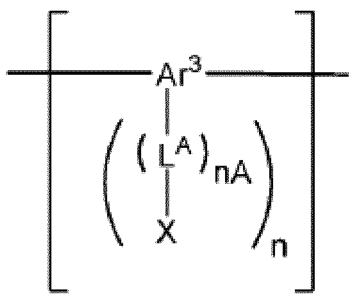
(2)

dans lequel

nA représente an nombre entier relatif de 0 à 5 ; n représente 1 ou 2 ; au cas où une pluralité de nA sont présents, ils sont les mêmes ou différents ;
$Ar^3$ représente un groupe hydrocarbure aromatique ou un groupe hétérocyclique, et ces groupes ont optionnellement un substituant ;
$L^A$ représente un groupe alkylène, un groupe cycloalkylène, un groupe arylène, un groupe hétérocyclique divalent, un groupe représenté par -NR'-, un atome d'oxygène ou un atome de soufre, et ces groupes ont optionnellement un substituant ; R' représente un atome d'hydrogène, un groupe alkyle, un groupe cycloalkyle, un groupe aryle ou un groupe hétérocyclique monovalent, et ces groupes ont optionnellement un substituant ;

au cas où une pluralité de $L^A$ sont présents, ils sont les mêmes ou différents ; X représente un groupe réticulant sélectionné à partir du groupe réticulant groupe A ; et, au cas où une pluralité de X sont présents, ils sont les mêmes ou différents, et

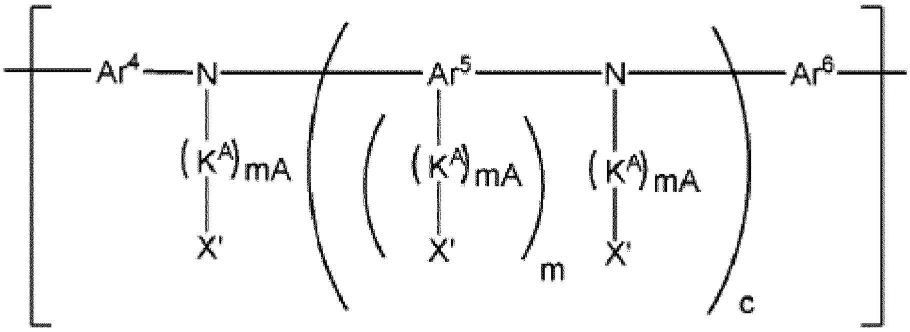

(2')

dans lequel

mA représente an nombre entier relatif de 0 à 5 ; m représente un nombre entier relatif de 1 à 4 ; c représente an nombre entier relatif de 0 ou 1 ; au cas où une pluralité de mA sont présent, ils sont les mêmes ou différents ; $Ar^5$ représente un groupe hydrocarbure aromatique, un groupe hétérocyclique, ou un groupe dans lequel au moins un groupe hydrocarbure aromatique et au moins un anneau hétérocyclique sont directement liés, et ces groupes ont optionnellement un substituant ;
$Ar^4$ et $Ar^6$ représentent chacun indépendamment un groupe arylène ou un groupe hétérocyclique divalent, et ces groupes ont optionnellement un substituant ;
chacun de $Ar^4$, de $Ar^5$ et de $Ar^6$ forme optionnellement un anneau en se liant directement ou par l'intermédiaire d'un atome d'oxygène ou d'un atome de soufre à un groupe, autre que le groupe concerné, lié à l'atome d'azote auquel le groupe concerné est lié ;
$K^A$ représente un groupe alkylène, un groupe cycloalkylène, un groupe arylène, un groupe hétérocyclique divalent, un groupe représenté par -NR'-, un atome d'oxygène ou un atome de soufre, et ces groupes ont optionnellement un substituant ; R' représente un atome d'hydrogène, un groupe alkyle, un groupe cycloalkyle, un groupe aryle ou un groupe hétérocyclique monovalent, et ces groupes ont optionnellement un substituant ; au cas où une pluralité de $K^A$ sont présents, ils sont les mêmes ou différents ;
X' représente un groupe réticulant sélectionné à partir du groupe réticulant groupe A, un atome d'hydrogène, un groupe alkyle, un groupe cycloalkyle, un groupe aryle ou un groupe hétérocyclique monovalent, et ces groupes ont optionnellement un substituant ; et au cas où une pluralité de X' sont présents, ils sont les mêmes ou différents, à condition qu'au moins un X' soit un groupe réticulant sélectionné à partir du groupe A de groupe réticulant.

**12.** Dispositif luminescent selon l'une quelconque des revendications 1 à 11, dans lequel la valeur de $(Y_1 \times 1000) / X_1$ est de 0,85 ou plus et de 4,0 ou moins.

**13.** Dispositif luminescent selon l'une quelconque des revendications 1 à 12, dans lequel :

la première couche organique est une couche contenant le composé fluorescent à faible poids moléculaire et un matériau hôte ;
le matériau hôte est un composé représenté par la formule (FH-1) ou un composé polymère comprenant une unité constitutive représenté par la formule (Y) ; et
la quantité du composé fluorescent à faible poids moléculaire est de 0,1 à 50 parties en masse par rapport à 100 parties en masse au total du composé fluorescent à faible poids moléculaire et du matériau hôte :

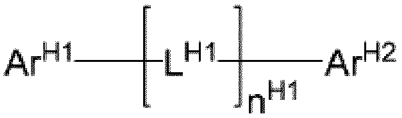

**(FH-1)**

dans lequel

$Ar^{H1}$ et $Ar^{H2}$ représentent chacun indépendamment un groupe aryle, un groupe hétérocyclique monovalent ou un groupe amino substitué, et ces groupes ont optionnellement un substituant ;
$n^{H1}$ représente an nombre entier relatif de 0 à 15 ;
$L^{H1}$ représente un groupe arylène, un groupe hétérocyclique divalent, ou un groupe représenté par $-[C(R^{H11})]n^{H11}-$, et ces groupes ont optionnellement un substituant ; au cas où une pluralité de $L^{H1}$ sont présents, ils sont les mêmes ou différents ; $n^{H11}$ représente un nombre entier relatif de 1 à 10 : ; $R^{H11}$ représente un atome d'hydrogène, un groupe alkyle, un groupe cycloalkyle, un groupe alkoxy, un groupe cycloalkoxy, un groupe aryle ou un groupe hétérocyclique monovalent, et ces groupes ont optionnellement un substituant ; et une pluralité de $R^{H11}$ présents sont les mêmes ou différents et sont optionnellement liés les uns aux autres pour former un anneau conjointement avec les atomes de carbone auxquels ils sont attachés et

$$-[-Ar^{Y1}-]- \qquad (Y)$$

dans lequel $Ar^{Y1}$ représente un groupe arylène, un groupe hétérocyclique divalent, ou un groupe divalent dans lequel au moins un groupe arylène et au moins un groupe hétérocyclique divalent sont directement liés, et ces groupes ont optionnellement un substituant.

**14.** Dispositif luminescent selon l'une quelconque des revendications 1 à 13, dans lequel la première couche organique contient en outre au moins un matériau sélectionné à partir du groupe constitué d'un matériau de transport de trous, d'un matériau d'injection de trous, d'un matériau de transport d'électrons, d'un matériau d'injection d'électrons, d'un antioxydant, et d'un matériau luminescent différent du composé fluorescent à faible poids moléculaire.

**15.** Dispositif luminescent selon l'une quelconque des revendications 1 à 14, dans lequel la seconde couche organique est une couche disposée entre l'anode et la première couche organique.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2009102027 A
- WO 2007100010 A
- US 2011042661 A
- WO 2015145871 A
- WO 2008059713 A
- WO 2011012212 A
- WO 2012096263 A
- WO 2006025273 A
- WO 2006030527 A
- JP 2006176491 A
- WO 2005033051 A
- WO 2010013006 A
- JP 2011105643 A
- WO 2007058368 A
- JP 2011100942 A
- WO 2011137922 A
- JP 2012144721 A
- WO 2013146806 A
- WO 2005049546 A
- JP 2010189630 A
- WO 2015194448 A


### Non-patent literature cited in the description


- *Chem. Rev.,* 2009, vol. 109, 897-1091